# EUROPEAN PATENT APPLICATION

(11) **EP 4 769 223 A1**
(43) Date of publication of application: **01.07.2026**
(21) Application number: 23958355.2
(22) Date of filing: 30.11.2023
(51) Int. Cl.: G06N 3/0475

(54) **CONTROL SYSTEM, CONTROL METHOD, AND CONTROL PROGRAM**

(30) Priority: 09.11.2023 JP 2023191481
(71) Applicant: Mitsubishi Electric Corporation, Tokyo 100-8310 (JP)
(72) Inventor: SUGAMA, Yasushi, Tokyo 100-8310 (JP); OTOMURA, Kotaro, Tokyo 100-8310 (JP); MIWA, Shotaro, Tokyo 100-8310 (JP); MAEKAWA, Kiyoshi, Tokyo 100-8310 (JP); NAMMOTO, Takashi, Tokyo 100-8310 (JP)
(74) Representative: Pfenning, Meinig & Partner mbB
(86) International application number: PCT/JP2023/042837
(87) International publication number: WO 2025/099956

(57) **Abstract**

A voice recognition unit (513v) accepts input information (D51v) input from a user (1) who is an originator, and inputs the input information (D51v) to a learning model unit (500) as input information (D51). A control decision unit (520) specifies a precondition for the learning model unit (500) for generating response information (D52) according to the input information (D51v) previously input from the user 1 who is the originator. A voice synthesis unit (514v) accepts the response information (D52) generated by the learning model unit (500) in response to the input information (51) input by the voice recognition unit (513v) in accordance with the precondition specified by the control decision unit (512), and outputs the response information (D52) as response information (D52v) to the user (1) who is the originator.

## Description

### Technical Field

The present disclosure relates to a control system, a control method, and a control program.

### Background Art

In recent years, the utilization of artificial intelligence (AI) has been progressing. In particular, AI called generative artificial intelligence (generative AI) that can generate various kinds of content is beginning to become widespread, and the applications of AI are expected to expand. The potential applications of AI are not limited to work in homes, but also include work in various locations and situations including inside various facilities such buildings, factories, stations, schools, hospitals, and commercial facilities, as well as outdoors such as roads, outdoor facilities, the sky, and the sea.

For example, Patent Literature 1 describes a processing program generation device that generates a program for controlling a machine using a large-scale language model.

### Citation List Patent Literature

Patent Literature 1: JP 2021-060806 A

### Summary of Invention

### Technical Problem

Cases will be considered where in order to assist work performed by a person or an object, a learning model takes on part or all of tasks involved in the work, not limited to generating control programs for equipment. The "work performed by a person or an object" includes not only work in real space performed by a person or a machine, but also work in data space, such as information processing, performed by a processor such as a central processing unit (CPU).

Examples of work performed by an object include, for example, the following:
- Work performed by various types of equipment such as a robot, a machine, a device, and a sensor
- Work performed by various types of mobility such as a car, a train, a bus, a flying object, and a ship.

The work may include, for example, work referred to as control, processing, machining, instruction, calculation, input, output, display, communication, testing, production, conversion, generation, measurement, irradiation, emission, suction, heat dissipation, heating, cooling, recording, reading, shaping, driving, moving, transporting, flying, investigation, monitoring, measurement, extraction, and so on.

Examples of work performed by a person include, for example, the following:
- Work performed by a person on another person or other living creatures
- Work performed by a person on various types of equipment

The work may include, for example, work referred to as conversation, viewing, checking, operation, monitoring, instruction, arbitration, interpretation, and so on.

The examples described above are merely examples, and types of work to be assisted by the present disclosure are not limited to these.

When some kind of learning model is used to cause an information processing device perform part or all of tasks involved in work performed by a person or an object, the validity of an output from the model may become a problem. The validity of an input to the model that affects an output from the model may also become a problem.

Depending on the target equipment, appropriate control may not be possible without first understanding the current situation. In such cases, how to achieve situation awareness can be a problem. In such cases, it may be necessary to recognize a continuous situation including not only the current situation but also past situations. For example, in cases such as where the next action is determined based on the content of control performed in the past, the accuracy of situation awareness can be a problem in order to secure the continuity of control.

In cases such as where immediate control of equipment is required, the response time between issuing an instruction to the learning model and obtaining a result can be a problem.

The maintainability of the model can be a problem, such as the need to retrain the model each time equipment is changed or added.

Thus, various problems still remain in the use of learning models. Depending on the scale of a problem, attempting to improve the efficiency or performance of work by using a learning model may actually result in reducing the efficiency or performance of work.

These problems in using a learning model will become more pronounced, particularly as work to be assisted becomes more complex or work to be assisted becomes more advanced.

Therefore, an object of the present disclosure is to use a learning model to further improve the efficiency or performance of work performed by a person or an object.

### Solution to Problem

A control system according to the present disclosure includes:
an input interface to accept input information input from an originator, and input the input information to a learning model unit;
a control decision unit to specify a precondition for the learning model unit for generating response information according to the input information previously input from the originator; and
an output interface to accept response information generated by the learning model unit in response to the input information input by the input interface in accordance with the precondition specified by the control decision unit, and output the response information to the originator.

### Advantageous Effects of Invention

According to the present disclosure, a learning model can be used to further improve the efficiency or performance of work performed by a person or an object. In particular, it is possible to improve the efficiency or performance of response work of returning a response to information transmitted from an originator.

### Brief Description of Drawings

Fig. 1 is a configuration diagram illustrating an example of a control system according to Embodiment 1.
Fig. 2 is an explanatory diagram illustrating an example of the configuration of a learning model unit.
Fig. 3 is an explanatory diagram illustrating another example of the configuration of the learning model unit.
Fig. 4 is an explanatory diagram illustrating another example of the configuration of the learning model unit.
Fig. 5 is a configuration diagram illustrating an example of an information processing device that is an operating environment of a control unit including the learning model unit.
Fig. 6 is an explanatory diagram illustrating an example of model learning in a model generation unit.
Fig. 7 is a flowchart illustrating an example of the operation of the control system according to Embodiment 1.
Fig. 8 is a configuration diagram illustrating another example of the control system according to Embodiment 1.
Fig. 9 is a configuration diagram illustrating another example of the control system according to Embodiment 1.
Fig. 10 is a configuration diagram illustrating another example of the control system according to Embodiment 1.
Fig. 11 is a configuration diagram illustrating an example of the control system according to Embodiment 2.
Fig. 12 is a configuration diagram illustrating another example of the control system according to Embodiment 2.
Fig. 13 is a flowchart illustrating an example of the operation of the control system according to Embodiment 2.
Fig. 14 is a configuration diagram illustrating an example of the control system according to Embodiment 3.
Fig. 15 is a flowchart illustrating an example of the operation of the control system according to Embodiment 3.
Fig. 16 is a configuration diagram illustrating another example of the control system according to Embodiment 3.
Fig. 17 is a flowchart illustrating an example of the operation of a variation according to Embodiment 3.
Fig. 18 is a configuration diagram illustrating another example of the control system according to Embodiment 3.
Fig. 19 is a configuration diagram illustrating another example of the control system according to Embodiment 3.
Fig. 20 is a configuration diagram illustrating another example of the control system according to Embodiment 3.
Fig. 21 is a configuration diagram illustrating another example of the control system according to Embodiment 3.
Fig. 22 is a flowchart illustrating an example of the operation of a variation according to Embodiment 3.
Fig. 23 is a configuration diagram illustrating an example of the control system according to Embodiment 4.
Fig. 24 is a flowchart illustrating an example of the operation of the control system according to Embodiment 4.
Fig. 25 is a configuration diagram illustrating another example of the control system according to Embodiment 4.
Fig. 26 is a flowchart illustrating an example of the operation of a variation according to Embodiment 4.
Fig. 27 is a configuration diagram illustrating an example of the control system according to Embodiment 5.
Fig. 28 is a flowchart illustrating an example of the operation of the control system according to Embodiment 5.
Fig. 29 is a configuration diagram illustrating another example of the control system according to Embodiment 5.
Fig. 30 is an explanatory diagram of an example of a determination method of a correctness determination unit 515.
Fig. 31 is a configuration diagram illustrating another example of the control system according to Embodiment 5.
Fig. 32 is a configuration diagram illustrating another example of the control system according to Embodiment 5.
Fig. 33 is a configuration diagram illustrating another example of the control system according to Embodiment 5.
Fig. 34 is a configuration diagram illustrating another example of the control system according to Embodiment 5.
Fig. 35 is a configuration diagram illustrating another example of the control system according to Embodiment 5.
Fig. 36 is a configuration diagram illustrating another example of the control system according to Embodiment 5.

### Description of Embodiments

In order to describe the present disclosure in more detail, embodiments of the present disclosure will be described below with reference to the accompanying drawings. In the following, the same elements are denoted by the same reference signs, and description will be omitted.

### Embodiment 1.

In this embodiment, an example will be described in which a learning model is used to assist work involved in generating code for a target equipment.

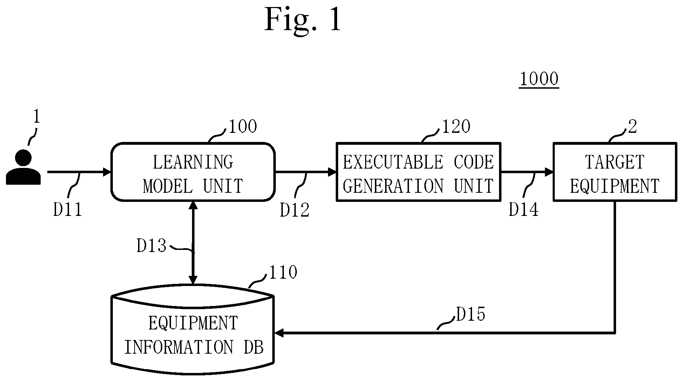

Fig. 1 is a configuration diagram illustrating an example of a control system 1000 according to Embodiment 1. The control system 1000 illustrated in Fig. 1 is a control system for controlling equipment using a learning model, and includes a learning model unit 100, an equipment information storage unit 110 (indicated as an equipment information DB in the diagram), and an executable code generation unit 120.

In Fig. 1, a user 1 and target equipment 2 are depicted, and the control system 1000 may include these. In this case, the "user 1" may be interpreted as a "user terminal 1". The same also applies to other embodiments.

When input information D11 is input, the learning model unit 100 outputs a control description D12. When the input information D11 is input, the learning model unit 100 outputs the control description D12 based on model information D102 to be described later.

In this embodiment, the learning model unit 100 is a model and its operating environment configured to output the control description D12 corresponding to the input information D11 when the input information D11 is input. The learning model unit 100 may be a model and its operating environment configured to generate and output the control description D12 when the input information D11 is input, based on the input information D11, equipment information D13, and/or other information that can be referred to in the learning model unit 100 (such as model reference information D104 to be described later).

In this embodiment, the input information D11 includes information indicating control content required for the target equipment 2. The input information D11 may be, for example, text, an image, voice, a combination of these, or the like indicating control content for the target equipment 2. The input information D11 may be, for example, text, an image, voice, a combination of these, or the like indicating a plurality of pieces of control content for the target equipment 2. The input information D11 may include information indicating control content to be performed continuously over time, and in that case, may be time-series data in a predetermined data structure that includes text, an image, voice, a combination of these, or the like indicating such control content. It is assumed that control content is indicated in a way that conforms with the input format of a model used by the learning model unit 100. However, this does not apply in cases such as those where error handling, correction processing, or conversion processing is included in a stage preceding the learning model unit 100.

An example of how to indicate control content in the input information D11 is a method in which control to be performed on the target equipment 2 is identified, and then parameter values for performing the control and a state after the control are specified. In this case, the input information D11 may include, for example, information that identifies the control and information that indicates the parameter values for performing the control or the state after the control. The parameter values for performing the control may include, for example, values related to a type of control (such as ON/OFF), a direction, an amount, and time. Examples of the control content include "turn on function X" for a programmable logic controller (PLC), "move the tip to point A" for a robot arm, and "lower the set temperature by one degree" for an air conditioner. Examples of how to indicate the control content in the input information D11 include methods of using various types of information, such as document strings (docstrings) that describe the specifications of functions or the like, a specification or a specification applied to other equipment such as other models, a design document, an operation command, control code, and source code.

The control content in the input information D11 may be indicated not only by methods of explicit indication as described above, but also by a method in which, for example, when there is control to be performed by a certain operation, corresponding control content is indicated by indicating the content of that operation. For example, there are also methods of implicit indication using the behavior of the user 1 associated with specific control, an operation result of the target equipment 2, a similar control instruction to other models or the like, and so on. In other words, the input information D11 may include not only information that directly indicates the control content for the target equipment 2, but also information that indirectly indicates the control content using operation content, behavior of the user 1, an image of the target equipment 2, or the like corresponding to the control content. As an example, control content related to temperature control of an air conditioner can be indicated using words of the user 1 such as "it is hot" or actions of the user 1 indicating heat, such as wiping sweat, rolling up sleeves, or fanning oneself with a hand. In this case, as the input information D11, information such as text, voice, or an image indicating what the user 1 has said, or information such as an image (video) showing the behavior of the user 1 can be used. As another example, control content related to arm control of robotic equipment can be indicated using information specifying a posture of the robotic equipment after the control or specifying a destination point to which a specific part is to be moved, or information indicating actions imitating actions of the robot or actions to instruct the robot (action instructions using gestures such as pointing) that are performed by a person or other objects (including a simulator and objects on a screen that mimic movements of the robot).

The format of the input information D11 is not particularly limited. For example, the information may be text, an image, voice, data written in a predetermined design language, a control description (including source code and information written in a predetermined programming platform language), information written in other platform languages, a control instruction (including a control command, a control signal, control code, and a controller command), or executable code. These types of information may be combined as appropriate. In the present disclosure, when the term "text" is used without any particular distinction, it may include not only natural language expressed in text, but also data written in a predetermined design language that cannot be recognized by humans, a control description (including source code and information written in a predetermined programming platform language), information written in other platform languages, a control instruction (including a control command, a control signal, control code, and a controller command), and data that is recognized by machines, such as executable code, expressed in text.

The control description D12 includes information related to control written in a predetermined format that can be recognized by the executable code generation unit 120 at the subsequent stage. The control description D12 is, for example, source code written in a predetermined programming language. The control description D12 may be, for example, commands written in a format (platform language) that is handled by a predetermined programming platform. The predetermined programming platform may include a no-code programming platform and a low-code programming platform.

The equipment information storage unit 110 stores the equipment information D13, which is information related to the target equipment 2. The equipment information D13 may include, for example, information indicating functions, performance, a structure, dimensions, operation, and/or a control method of the target equipment 2. The equipment information D13 may include, for example, information related to a program used to control the target equipment 2. The equipment information D13 may be, for example, a digitized version of a manual or instruction manual for the target equipment 2. Digitization here includes text conversion, image data conversion, speech-to-text data conversion, and a combination of these. The equipment information D13 is used, for example, as additional information when the learning model unit 100 outputs the control description D12.

The equipment information D13 may include information indicating a state of the target equipment 2. The information indicating the state of the target equipment 2 may include not only the current state of the target equipment 2 but also information indicating past states. For example, the equipment information D13 may include time-series data in a predetermined data structure that indicates the state of the target equipment 2. The information indicating the state of the target equipment 2 may be, for example, information output from the target equipment 2, or may be information input by the user 1 or other equipment. The information indicating the state of the target equipment 2 may include various kinds of information (e.g., error information, log information, notification information, etc.) output from the target equipment 2. In the following, in this embodiment, information indicating in particular the state of the target equipment 2 may be referred to as state information D15.

When the control description D12 is input, the executable code generation unit 120 generates and outputs executable code D14, which is code executable by the target equipment 2, based on the control description D12. The executable code D14 may be, for example, a group of code written in machine language. The executable code D14 includes, for example, information used when the target equipment 2 actually performs control. The executable code D14 may be, for example, information related to control written in a format that can be recognized by the target equipment 2. The executable code generation unit 120 may be, for example, a compiler that converts the control description D12 into the executable code D14.

The executable code D14 output from the executable code generation unit 120 is input to the target equipment 2. This causes the target equipment 2 to operate according to the executable code D14 output from the executable code generation unit 120. The executable code D14 may be input to the target equipment 2 directly from the executable code generation unit 120, or may be input indirectly through a communication network or other equipment (a server, various types of converters, etc.), manually, and so on.

The target equipment 2 is not particularly limited. It is assumed that the target equipment 2 is equipment that can receive and actually execute the executable code D14. However, this does not apply if an interface, such as a writing device, that loads executable code into the target equipment 2 is provided for the target equipment 2.

The target equipment 2 is, for example, a PLC, a processing machine, a robot, a radar, a sensor, a camera, a projector, or a communication device. The target equipment 2 may be, for example, an air conditioner, a refrigerator, a television, a light, or a washing machine. The target equipment 2 may be, for example, an elevator, a mobility device, a conveyance device, other machines, or a control device that controls such a machine. The target equipment 2 may be equipment operating in a power generation, transformation, and storage plant, a water treatment plant, or the like, or may be a control device that controls other equipment. If the control description D12 is in interpreter language and the target equipment 2 is equipment that can receive and then directly execute the control description D12, the executable code generation unit 120 is omitted.

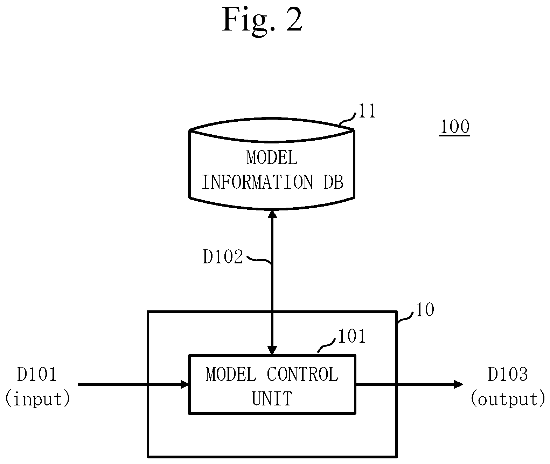

Fig. 2 is an explanatory diagram illustrating an example of the configuration of the learning model unit 100. As illustrated in Fig. 2, the learning model unit 100 may include a model control unit 101 that operates on the information processing device 10 and a model information storage unit 11 (indicated as a model information DB in the diagram) to store the model information D102. The model information storage unit 11 may be composed of a plurality of databases connected via a network.

The model information D102 includes information on the model. The model information D102 may include, as the information on the model, information indicating a correlation between model input data D101 and model output data D103, for example. The model information D102 may include, as the information on the model, information indicating candidates for the model output data D103, for example. The model information D102 may further include, as the information on the model, information indicating candidates for the model output data D103 and information indicating relationships between these candidates. The model information D102 may include, for example, model parameters, which are information that defines the behavior of the learning model, such as constraints, weighting variables, and evaluation functions.

The model may be, for example, a model trained through machine learning by supervised learning, reinforcement learning, or unsupervised learning. The model may be, for example, a model obtained by performing learning according to deep learning, genetic programming, functional logic programming, or other known algorithms or methods. The model may be, for example, a model called a neural network (NN) model, a convolutional neural network (CNN) model, a recurrent neural network (RNN), a variational autoencoder (VAE), generative adversarial networks (GAN), a diffusion model, a transformer model, a large language model (LLM), a visual language model (VLM), Bidirectional Encoder Representations from Transformers (BERT), a generative pre-trained transformer (GPT), or Contrastive Language Image Pre-training (CLIP). The model may be a rule-based model that obtains output results by referring to predetermined tables or making determinations based on predetermined conditions. The models mentioned above are not mutually exclusive, and the LLM, VLM, BERT, and GPT are included in the transformer model, for example. The transformer model is included in the NN model, for example. A learning algorithm and model may be a combination of multiple types. The model includes one called a multimodal model that is trained by combining multiple different types of data.

Upon accepting the model input data D101, the model control unit 101 outputs the model output data D103 corresponding to the model input data D101 based on the model input data D101 and the model information D102. Upon accepting the model input data D101, the model control unit 101 outputs the model output data D103 corresponding to the model input data D101 using a model indicated by the model information D102, for example.

The model control unit 101 is realized, for example, by a CPU or the like that operates according to programs provided in the information processing device 10. In the following, the learning model unit 100 may be referred to as an artificial intelligence unit. The artificial intelligence unit here refers to AI equipped with intelligent functions such as inference and judgment and its operating environment. Therefore, the model control unit 101 may include AI equipped with intelligent functions such as inference and judgment and its operating environment. The model control unit 101 may be, for example, AI equipped with a learning model as described above and its operating environment. The model control unit 101 may be an element (module) of a control unit 104 included in the information processing device 10.

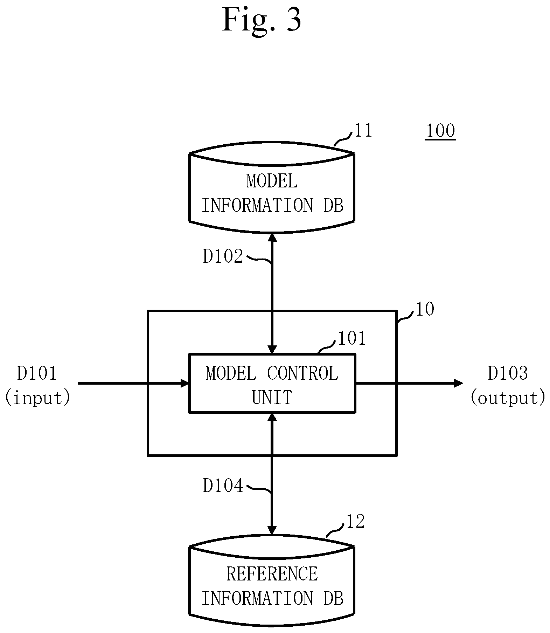

The learning model unit 100 may further include, as illustrated in Fig. 3, a reference information storage unit 12 (indicated as a reference information DB 12 in the diagram) to store the model reference information D104. The reference information storage unit 12 may be composed of a plurality of databases that are connected via a network. The same also applies to other storage units to be described later (e.g., an equipment information storage unit, etc.).

The model reference information D104 is information that the model control unit 101 refers to in order to output model output data. The model reference information D104 may include a history of model input data that has been input in the past and/or a history of model output data that has been output in the past. The model reference information D104 may include information that associates features included in past inputs with features included in outputs made in response to those inputs. The model reference information D104 may include information on evaluations of results output in response to past inputs.

The model reference information D104 may include information related to expressions or concepts included in the model input data D101. The model reference information D104 may include, for example, information that associates a specific expression or concept that may be included in the model input data D101 with other expressions or concepts related to the specific expression or concept. Other expressions or concepts related to a specific expression or concept include expressions or concepts that more specifically embody the specific expression or concept, and other expressions or concepts that are evoked based on the specific expression or concept. The model reference information D104 may include, for example, information that associates a specific expression or concept that may be included in the model input data D101 with an expression or a concept related to that expression or concept. As an example, the model reference information D104 may include, for example, information that associates a specific expression or concept that may be included in the model input data D101 with information related to that expression or concept. The model reference information D104 may include, for example, information that associates a search key extracted from an expression or concept that may be included in the model input data D101 with a value. The model reference information D104 may include information for so-called grounding. The model reference information D104 may include a so-called knowledge graph that describes real-world entities and relationships between them. In a knowledge graph, various pieces of information are systematically connected and expressed in a graph structure.

The model reference information D104 may include information for so-called attention. For example, the model reference information D104 may include information indicating a correlation between an expression or concept that may be included in the model input data D101 and another expression or concept. The model reference information D104 may include a feature map in which features are key information extracted from expressions or concepts that may be included in the model output data D103 and are associated with expressions or concepts that may be included in the model input data D101. The model reference information D104 may include information that associates a query extracted from an expression or concept that may be included in the model input data D101 with search key information corresponding to that query.

In the example illustrated in Fig. 3, upon accepting the model input data D101, the model control unit 101 outputs the model output data D103 based on the model input data D101, the model information D102, and the model reference information D104.

The learning model unit 100 may include, instead of the reference information storage unit 12, a search engine that searches for the model reference information D104 or an interface with the search engine. In such a case, the search range of the search engine may be an external network or a specific network. As one of an external network and a specific network, a database (e.g., the equipment information DB) included in the control system of the present disclosure can be used.

The term "learning model" may refer to a computer algorithm that makes some kind of output based on learned information in response to input information, or may refer to the learned information itself. However, the term "learning model" in an operating environment often refers to an actual program that runs such a computer algorithm and its operating environment. In the present disclosure, the latter is adopted, and a model that actually operates based on information stored in the model information D102 and so on is called a "learning model" in order to distinguish it from one that simply indicates an algorithm or pieces of learned information. The control system according to the present disclosure includes the learning model unit (in particular, the model control unit 101) as an element equivalent to such a learning model. Therefore, in the following, the term "learning model" used in the description of the control system refers to the learning model unit or, in particular, the model control unit 101 in the learning model unit.

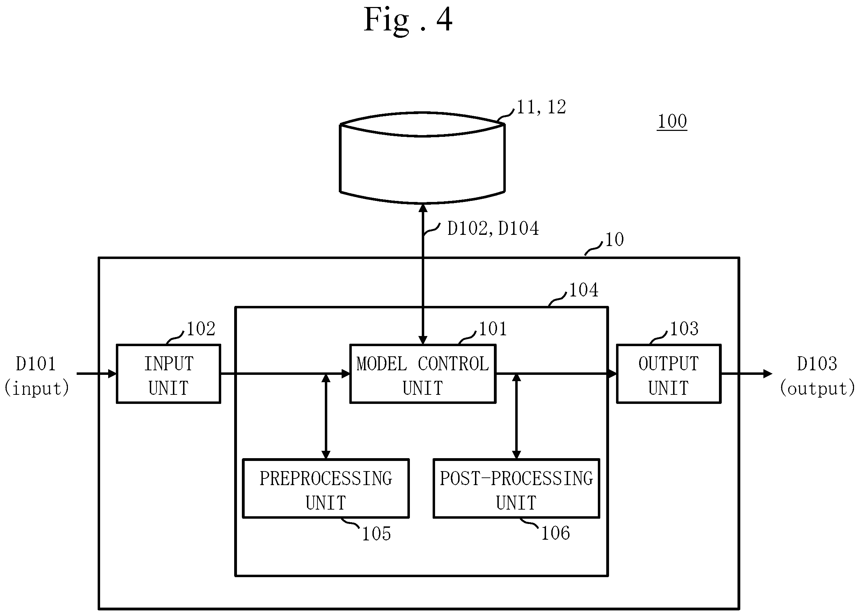

Fig. 4 is an explanatory diagram illustrating another example of the configuration of the learning model unit 100. As illustrated in Fig. 4, the learning model unit 100 may include an input unit 102, an output unit 103, and the control unit 104.

The input unit 102 accepts the model input data D101. The input unit 102 may accept the model input data D101 that is input by the user 1 or the like. The input unit 102 may accept the model input data D101 that is time-series data. In this case, the input unit 102 may sequentially accept the model input data D101 that is time-series data, or may accept the model input data D101 that has been buffered to some extent. The input unit 102 may accept the model input data D101 input from a plurality of input sources. In this case, the input unit 102 may accept the model input data D101 to which information about an input source (e.g., a user identifier, user attribute information, etc.) has been added, or the input unit 102 may determine an input source and add information about the input source to the model input data D101, and then accept it, or may accept the model input data D101 without doing anything in particular. The input unit 102 is realized, for example, by various input devices (e.g., a pointing device, a keyboard, a voice input device, an image input device, a data reading device, a data input device compatible with various communication interfaces, etc.) included in the information processing device 10. The input unit 102 may be realized by an external device of the information processing device 10. In this case, the information processing device 10 only needs to include an interface with the input unit 102.

The output unit 103 outputs an object generated by the control unit 104. The object includes the model output data D103 or data generated from the model output data D103. When the object generated by the control unit 104 includes information for a plurality of output destinations, the output unit 103 may output the object to the plurality of output destinations. In this case, the output unit 103 may output the same data to the plurality of output destinations, or may output different data to each output destination. The output unit 103 is realized, for example, by various output devices (e.g., a display device, a voice output device, an image output device, a data writing device, a data output device compatible with various communication interfaces, etc.) included in the information processing device 10. The output unit 103 may be realized by an external device of the information processing device 10. In this case, the information processing device 10 only needs to include an interface with the output unit 103.

The control unit 104 operates on the information processing device 10, and includes a preprocessing unit 105 and a post-processing unit 106 in addition to the model control unit 101 described above.

The preprocessing unit 105 performs processing for enhancing the accuracy of an object generated by the control unit 104. For example, the preprocessing unit 105 may add, change, or delete elements or convert (including processing) data in the model input data D101.

When the input unit 102 accepts the model input data D101, the preprocessing unit 105 may change (including addition and deletion) elements or transform (including processing) data in the model input data D101, for example. Changing elements or converting (including processing) data includes not only changing a data format but also changing a representation or concept that the data represents. The data changed by the preprocessing unit 105 is input as the model input data D101 to the model control unit 101 at the subsequent stage. The processing performed by the preprocessing unit 105 includes so-called prompt shaping for the model control unit 101.

The preprocessing unit 105 may perform, for example, a process of breaking down the model input data D101 into data in predetermined units. The preprocessing unit 105 may perform, for example, a process of integrating a plurality of pieces of the model input data D101. Furthermore, the preprocessing unit 105 may break down the model input data D101 into data in predetermined units and then change elements or convert the data, or may integrate a plurality of pieces of the model input data D101 and then change elements or convert the data.

For example, if there is a problem in an object generated by the control unit 104 (particularly the model control unit 101), the post-processing unit 106 corrects the object. The post-processing unit 106 may use, for example, the knowledge graph described above to determine whether there is a problem in the object. For example, a relationship indicated by the knowledge graph may be compared with a relationship between an expression or concept included in model input data and an expression or concept included in model output data and/or a relationship between expressions or concepts included in model output data, so as to find out whether they are similar. If there is a difference of a predetermined distance or more from the relationship indicated by the knowledge graph, it may be determined that there is a problem in the object.

The components described above except for the model control unit 101 are not essential, and whether or not to implement them can be selected as appropriate.

The model information D102 and other information used by the learning model may be prepared in advance, or may be acquired via a communication network as necessary.

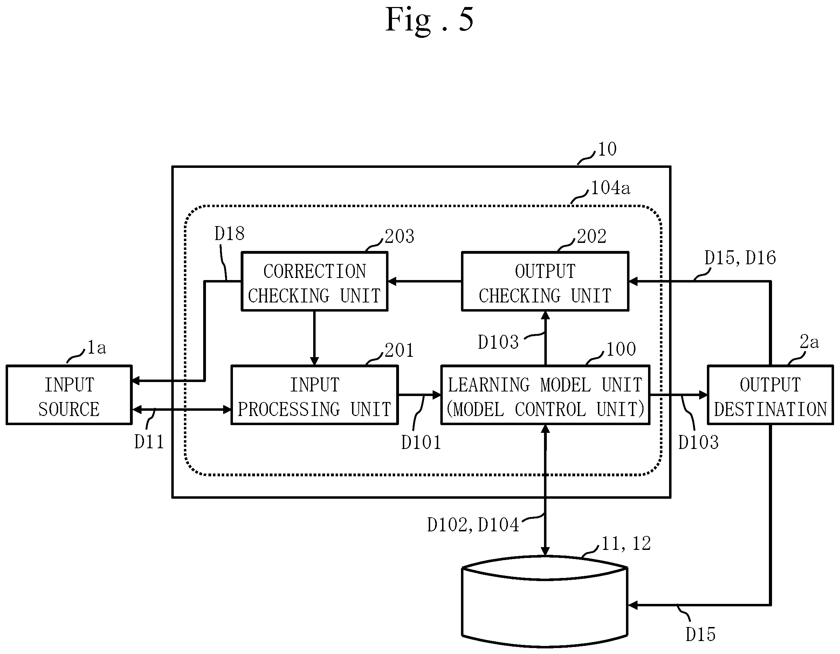

Fig. 5 is a configuration diagram illustrating another example of the information processing device 10 as an operating environment of the control unit 104 including the learning model unit 100 and so on. The information processing device 10 illustrated in Fig. 5 may include a control unit 104a that includes the learning model unit 100 (particularly the model control unit 101), an input processing unit 201, an output checking unit 202, and a correction checking unit 203.

The input processing unit 201 accepts the input information D11 from an input source 1a such as the user 1. The input processing unit 201 outputs the accepted input information D11 to the learning model unit 100 as the model input data D101.

At this time, the input processing unit 201 may, for example, output the input information D11 in which an element has been changed or data has been converted as the model input data D101. The input processing unit 201 may, for example, remove noise from the input information D11. If the input information D11 includes qualitative information, for example, the input processing unit 201 may convert this information into quantitative information. If the input information D11 includes quantitative information, for example, the input processing unit 201 may correct the amount depending on the equipment to which a requirement in the input information D11 is targeted or its operating environment. The input processing unit 201 may, for example, perform so-called a grounding process, that is, may change an expression or concept indicated by the input information D11 into a more specific expression or concept.

If the input information D11 includes unclear or uncertain information, the input processing unit 201 may return an inquiry to the input source. As the inquiry, the input processing unit 201 may output, for example, a message to confirm the input content, a message to propose a correction to the input information D11, or a message to request re-entry of the input information D11 in a different state or expressed differently. The proposed correction to the input information D11 may be generated by the correction checking unit 203 to be described later. In the following, information indicating a correction, an addition, or a deletion for input data or output data of the learning model after being input or output may be called supplementary information D18. The proposed correction is an example of the supplementary information D18.

The output checking unit 202 performs a simulation that simulates the control and state of the target equipment 2 based on the model output data D103 output from the learning model unit 100. The output checking unit 202 may convert the model output data D103 into control information that conforms to a predetermined simulator (not illustrated) that can simulate the control and state of the target equipment 2, and then perform a simulation. The output checking unit 202 may have a simulator function. When performing a simulation, the output checking unit 202 may use information acquired from an output destination 2a of the model output data D103. The output destination 2a includes an output destination of information generated from the model output data D103. The information acquired from the output destination 2a may include, for example, the state information D15 and/or feedback information D16 that are to be described later.

The output checking unit 202 may check, for example, the state of the target equipment 2, the state of a system including the target equipment 2, and/or the state of work that the target equipment 2 has. Before performing an operation check, the output checking unit 202 may generate and display an intermediate product that humans can understand for the model output data D103 or information generated based on the model output data D103. Examples of the intermediate product include source code for a control program and an operation image of a controller of the target equipment 2 for an operation instruction to the target equipment 2. The output checking unit 202 may display a simulation result together with a reliability index of the learning model.

The following are examples of the reliability index for the learning model. For example, an evaluation network may be provided in which, during pre-training or the like, each time there is an input to the learning model, results of human evaluations on those results are accumulated and the inputs and the evaluation results are learned. When the learning model is used, an input to the learning model may also be input to the above evaluation network and its output result may be used as the reliability index.

For example, a learning device that clusters outputs of the learning model during pre-training or the like may be provided. When the learning model is used, an output of the learning model may also be input to the above learning device, and its clustering result may be used as the reliability index.

For example, an evaluation network may be provided in which, during pre-training or the like, each time there is an input to the learning model, results of human evaluations on those results are accumulated and features of inputs with high evaluation results are learned. When the learning model is used, an input to the learning model may also be input to the above evaluation network, and the similarity between a feature that is an output result of the evaluation network and a feature of a learning result may be used as the reliability index.

For example, a learning device may be provided in which, during pre-training or the like, each time there is an input to the learning model, results of human evaluations on those results are accumulated, and inputs to the learning model with high evaluation results are clustered. When the learning model is used, an input to the learning model may also be input to the above learning device, and its clustering result may be used as the reliability index.

The correction checking unit 203 uses the result of a simulation performed by the output checking unit 202 to determine the validity of the model output data D103 and/or the model input data D101. For example, the correction checking unit 203 may determine the validity of the model output data D103 and/or the model input data D101 by comparing the state of the target equipment 2 indicated by the simulation result with the state of the target equipment 2 identified by the input information D11, the model output data D103, and/or the model input data D101 and determining whether correct control has been performed. The correction checking unit 203 may determine that correct control has been performed if the state of the target equipment 2 indicated by the simulation result matches the state of the target equipment 2 identified by the model output data D103 and/or the model input data D101. The state of the target equipment 2 to be compared is not limited to one.

For example, the correction checking unit 203 may determine the validity of the model output data D103 and/or the model input data D101 by checking whether the state or control trajectory of the target equipment 2 indicated by the simulation result matches the control indicated by the input information D11 or does not include any content that has been prohibited in advance, and so on.

The correction checking unit 203 may determine the validity of the model output data D103 and/or the model input data D101 by presenting the simulation result to the input source 1a of the input information D11 and requesting a response as to whether desired control has been performed.

If it is determined that the model output data D103 and/or the model input data D101 is incorrect, the correction checking unit 203 may correct the model input data D101. Instead of correcting the model input data D101, the correction checking unit 203 may generate the supplementary information D18 for the input information D11 and output the supplementary information D18 to the input source 1a.

The control system 1000 may have, for example, the configuration illustrated in one of Figs. 1 to 5 as the operating environment of the learning model unit 100. Also in this case, part or all of the components may be internal components of the control system 1000 or may be external components, as in the case of the learning model unit 100.

The learning model unit 100 and its surrounding components described above are merely examples, and not all the components are essential, and whether or not to implement these components may be selected depending on desired functions.

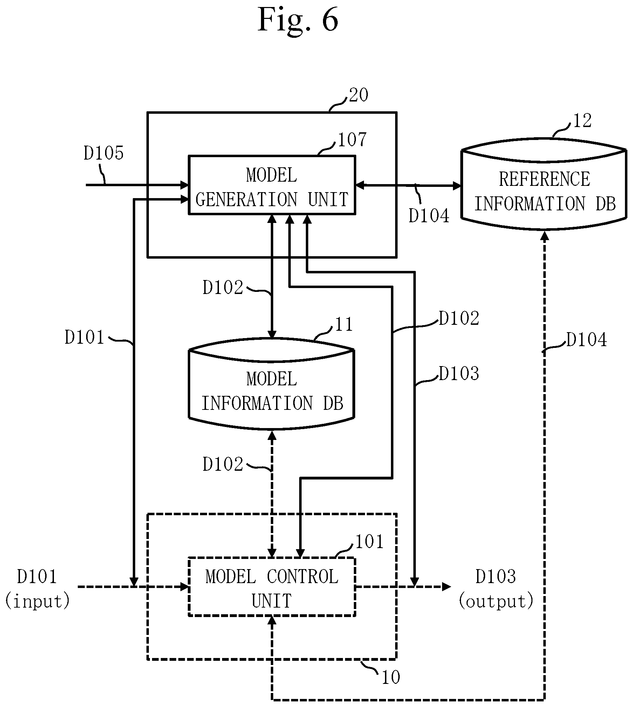

Fig. 6 is an explanatory diagram illustrating an example of model learning. As illustrated in Fig. 6, the model information D102 may be generated by a model generation unit 107 through machine learning using model learning data D105.

The model generation unit 107 is a processing unit that generates or updates the model information D102 according to a predetermined algorithm, based on the model learning data D105 that has been input. The model generation unit 107 is realized, for example, by a CPU that operates according to a program provided in an information processing device 20. The algorithm according to which the model generation unit 107 operates may be a machine learning algorithm corresponding to the learning model, for example, supervised learning, reinforcement learning, or unsupervised learning, or may be deep learning, a genetic program, a functional logic program, or other known algorithms.

For the model learning data D105 that has been input, the model generation unit 107 may generate or update the model information D102 based also on the model reference information D104. For the model learning data D105 that has been input, the model generation unit 107 may generate or update the model information D102 based also on the model output data D103 from the model control unit 101.

The model learning data D105 is not particularly limited. For example, when supervised learning is used as a learning algorithm, the model learning data D105 may include candidates for the model input data D101 that may be input and corresponding candidates for the model output data D103. The model learning data D105 may include the model input data D101 that has been actually input and/or the model output data D103 that has been actually output. By appropriately using the actual model input data D101 and/or model output data D103, feedback control can be performed. The model learning data D105 may include information acquired from equipment or a processing unit included in the system in which the learning model actually operates.

The model information D102 generated or updated by the model generation unit 107 is provided to the model control unit 101 by being stored in the model information storage unit 11. Alternatively, the model generation unit 107 can directly output the model information D102 to the model control unit 101.

For example, before the model control unit 101 uses the model information D102, the model generation unit 107 may generate the model information D102 by pre-training using the model learning data D105 that has been input, and store the model information D102 in the model information storage unit 11.

Updating of the model information D102 by the model generation unit 107 may be a process called fine-tuning.

The model generation unit 107 may be included in the control system 1000, or may be included in a system separate from the control system 1000.

In Fig. 1, the learning model unit 100 is illustrated separately from the equipment information storage unit 110 and the equipment information D13, but the equipment information storage unit 110 and the equipment information D13 may be part of the learning model unit 100. In other words, the learning model unit 100 may include the equipment information storage unit 110 and the equipment information D13. For example, the learning model unit 100 may include the equipment information storage unit 110 as one type of the reference information storage unit 12 to be described later. By using the equipment information D13 in a model-training phase in which a model to be used by the learning model unit 100 is trained, the equipment information D13 may be incorporated in the model in advance. In this case, the equipment information storage unit 110 may be omitted.

Part or the entirety of the learning model unit 100 may be an internal component of the control system 1000 or may be an external component of the control system 1000. In the case of an external component of the control system 1000, the control system 1000 only needs to include, in place of the part or the entirety of the learning model unit 100, an interface that can exchange information with an external system that includes the part or the entirety of the learning model unit 100. For example, the control system 1000 may have the model information storage unit 11 that is called the core of the learning model as an external component. For example, the control system 1000 may have the model information storage unit 11 that is called the core of the learning model and the model control unit 101 that is responsible for the algorithm of the model as external components.

In the following, in the control system 1000, in order to distinguish between the model control unit 101 that is responsible for the algorithm of the learning model and a part that performs a process of sending a request to the model control unit 101 like that and obtaining a response, the part that performs the latter process may be called a "model processing unit." More specifically, the model processing unit corresponds to parts of the information processing device 10 as well as the control unit 104 or the control unit 104a described above excluding the model control unit 101. For example, when the model control unit 101 exists in the internal environment, the model processing unit may be realized by an operating system (OS) and a prompt application (and a control unit that is its operating environment) that operate on the information processing device 10 and call a learning model application. For example, when the model control unit 101 exists in the external environment, the model processing unit may be realized by a browser and a client application (and a control unit that is its operating environment) that operate on the information processing device 10.

The configurations of the learning model and the information processing device as its operating environment and the relationship between the learning model and the control system including the learning model that have been described above also apply to other embodiments.

In this embodiment, the input information D11 corresponds to the model input data D101. The control description D12 corresponds to the model output data D103. The learning model unit 100 (particularly, the model control unit 101) may be configured, for example, to accept the input information D11 and then output the control description D12 corresponding to the input information D11 based on the model information D102 and, if necessary, the model reference information D104.

In such a case, the model generation unit 107 provided corresponding to the learning model unit 100 may, for example, perform machine learning using the model learning data D105 including candidates for the input information D11 that may be input to the model control unit 101, so as to generate or update the model information D102. The model generation unit 107 may, for example, perform machine learning using the model learning data D105 including candidates for the input information D11 that may be input to the model control unit 101 and corresponding candidates for the control description D12, so as to generate or update the model information D102.

In this embodiment, the learning model unit 100 may be, for example, a language learning model such as an LLM to which natural language is input to obtain an output result and its operating environment. The learning model unit 100 may be, for example, an image learning model such as a VLM to which an image is input to obtain an output result and its operating environment. The learning model unit 100 may be, for example, a multimodal model to which natural language and an image are input to obtain an output result and its operating environment. In that case, the input information D11 may be input as text data, image data, a combination of text data and image data, or in a data format that can be converted into any of these (voice data, video that is a combination of voice data and image data, etc.). The learning model used in this embodiment is not limited to the models mentioned above.

In this embodiment, the input information D11 accepted by the control system 1000 can be considered to be information about requirements in a work environment, that is, an environment in which the target equipment 2 operates (control content required for the target equipment 2). Therefore, the input information D11 accepted by the control system 1000 can be considered to be an example of first information indicating requirements in the work environment. The control description D12 and the executable code D14 can be considered to be information used for the work (work involved in controlling the target equipment 2) in response to such input information D11. In the following, the control description D12 that is output to a predetermined output destination from the operating environment of the learning model to which model input data based on the input information D11 is input may be referred to as second information.

In the relationship between the input information D11 and the model input data, the model input data based on the input information D11 may include the input information D11 itself, the input information D11 converted into a format that matches the input format of the learning model, and the input information D11 that has been supplemented. In the relationship between the model output data and the second information, the second information based on the model output data may include the model output data itself, the model output data converted into a format that matches the input format of an output destination, and the model output data that has been supplemented. The same also applies to the relationship between input/output information and model input/output data in other embodiments.

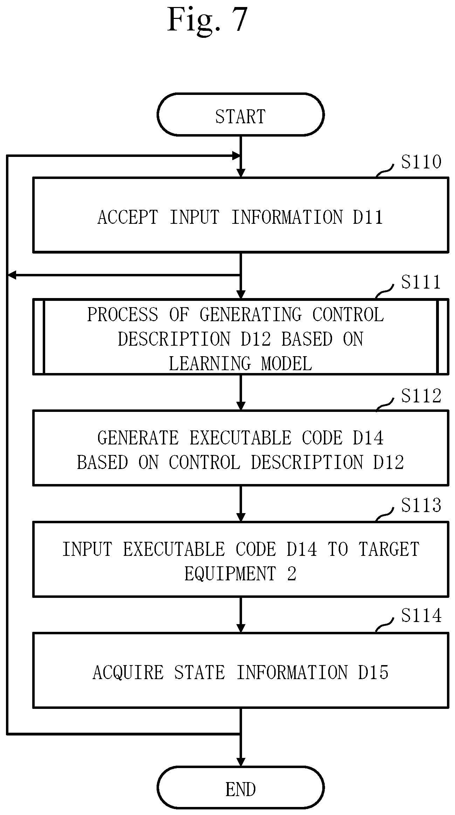

The operation of the control system 1000 of this embodiment will now be described. Fig. 7 is a flowchart illustrating an example of the operation of the control system 1000.

In the example illustrated in Fig. 7, the control system 1000 first accepts the input information D11 (step S110). For example, the input unit 102 or the input processing unit 201 described above may accept the input information D11. The accepted input information D11 is input to the learning model unit 100 as the model input data D101.

In step S110, the control system 1000 may accept a plurality of pieces of the input information D11. The control system 1000 may interact with the user 1, that is, repeat input and output of information related to the input information D11 with the user 1, so as to accept the input information D11 that better matches the requirements of the user 1.

Next, the control system 1000 performs a process of generating the control description D12 using the learning model unit 100 (step S111). In step S111, the learning model unit 100 generates and outputs the control description D12 corresponding to the input information D11 that has been input. For example, the learning model unit 100 (more specifically, the model control unit 101) outputs the control description D12 corresponding to the input information D11 based on the model information D102, the input information D11 that has been input, and, if necessary, the model reference information D104 including the equipment information D13. The learning model unit 100 may, for example, use a learning model that can generate text data to generate the control description D12 of text data from the input information D11 that has been input.

In step S111, in order to enhance the accuracy of the control description D12, the learning model unit 100 (more specifically, the preprocessing unit 105 or the input processing unit 201) may further add, change, or delete an element or convert (including processing) data in the input information D11 that has been input before processing by the model control unit 101. In step S111, the learning model unit 100 (more specifically, the post-processing unit 106) may further determine whether there is a problem in the control description D12 after processing by the model control unit 101, and perform processing to correct the control description D12 if it is determined that there is a problem.

The control description D12 output from the learning model unit 100 is input to the executable code generation unit 120. When the control description D12 is input, the executable code generation unit 120 generates the executable code D14 based on the input control description D12 (step S112).

Then, the executable code D14 generated by the executable code generation unit 120 is input to the target equipment 2 (step S113). As already described, the executable code D14 may be input to the target equipment 2 directly from the control system 1000 (more specifically, the executable code generation unit 120), or may be input indirectly via a communication network or other equipment (a server, various conversion devices, etc.) or manually.

As a result, the target equipment 2 operates according to the executable code D14 that has been input.

If the state of the target equipment 2 changes due to control performed on the target equipment 2 as a result of outputting the executable code D14, the control system 1000 may acquire the state information D15 (step S114). The acquired state information D15 is stored, for example, in the equipment information storage unit 110 as part of the equipment information D13. The control system 1000 may, for example, update the equipment information D13 stored in the equipment information storage unit 110 using the acquired state information D15. The control system 1000 may, for example, output the acquired state information D15 as information indicating a control result to the user 1, the learning model unit 100, or another device that is not illustrated. If the control system 1000 does not use the state information D15, the processing in step S114 can be omitted.

The control system 1000 may repeat the processing in step S110 to step S114 multiple times (for example, until the desired control of the target equipment 2 is completed).

The control system 1000 may output the control description D12 to an operation terminal or the like of the user 1 so that the user 1 checks the content and then subsequent processing (such as code generation in the executable code generation unit 120) is executed through an operation of the user 1.

The state information D15 input to the learning model unit 100 is used, for example, for additional learning by the learning model unit 100. The learning model unit 100 may, for example, update the model information D102 and/or the model reference information D104 based on the input state information D15.

As described above, according to this embodiment, the executable code D14 can be generated from the input information D11 input by the user 1 without the user 1 having to create the control description D12, so that the efficiency of work of controlling the target equipment 2 can be improved.

In this embodiment, the input information D11 may be text, an image, voice, or a combination of these that explicitly or implicitly indicates the control content for the target equipment 2. Therefore, it is possible to further reduce the effort required to input the input information D11 and also improve the efficiency of work of controlling the target equipment 2.

According to this embodiment, the control description D12 can be generated from the input information D11 using the learning model. Therefore, even if the user 1 does not know information or the like for controlling the target equipment 2 such as the detailed specifications of the target equipment 2, the specifications of the control description D12, and so on, the control description D12 corresponding to the input information D11 can be generated. Thus, it is possible to improve the performance of work of controlling the target equipment 2. The improvement of the performance of work of controlling the target equipment 2 includes improved accuracy of control of the target equipment 2.

In this embodiment, the state information D15 acquired after the target equipment 2 is controlled based on the input information D11 can be used for generating a next control description D12 and so on. Therefore, the performance of work of controlling the target equipment 2 can be further improved.

In the examples described above, only one piece of the target equipment 2 is indicated, but the control system 1000 may control a plurality pieces of the target equipment 2. In such a case, for example, information that can identify the target equipment 2 may be included in the input information D11, or the component to perform input to the learning model unit 100 (the input unit 102, the preprocessing unit 105, the input processing unit 201) may perform a process of identifying the target equipment 2 based on the input information D11, or the learning model unit 100 may output control content in which the target equipment 2 has been identified as a result of learning.

### Variation 1-1.

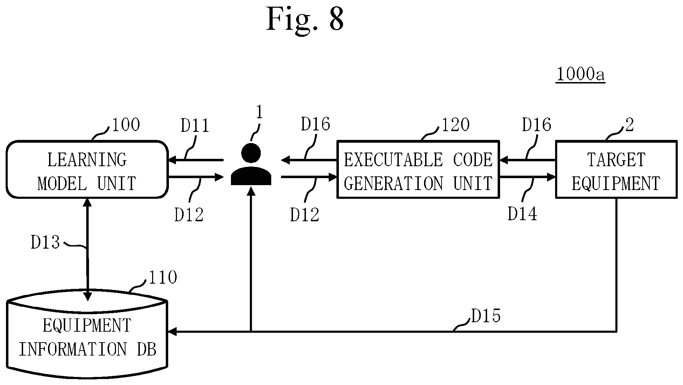

A variation of the control system 1000 will now be described. Fig. 8 is a configuration diagram illustrating an example of a control system 1000a, which is a variation of the control system 1000 according to this embodiment. The same elements as those of the control system 1000 are denoted by the same reference signs, and description will be omitted.

In the control system 1000a illustrated in Fig. 8, an output from the learning model unit 100 is checked by the user 1 and then input to the executable code generation unit 120 at the subsequent stage.

In this embodiment, the user 1 can check the control description D12 output from the learning model unit 100 and input the input information D11 based on the result of checking. The user 1 may check the control description D12 output from the learning model unit 100 and also the feedback information D16 from the executable code generation unit 120 and/or the target equipment 2, and input the input information D11 based on the results of checking. In this case, the user 1 may input the input information D11 with new content, or may input the input information D11 indicating a correction, addition, or deletion made to the content that has already been input. In this case, instructions for the learning model unit 100 can be included in the input information D11. For example, together with the feedback information D16, the user 1 may input, as the input information D11, an instruction to remove a problem included in the input information D11 or an instruction to remove a problem included in the control description D12 that has been output. Instructions for removing problems include inputs for finding causes of problems or solutions for problems.

When a request for control is made to a processing unit at a stage subsequent to the learning model unit 100, the feedback information D16 may include a response to the request returned from the processing unit. The feedback information D16 may include information obtained from the processing unit at the stage subsequent to the learning model unit 100 after a request for control is made to the processing unit. For example, when the control description D12 is input and a request is made to the executable code generation unit 120 to generate the control description D12, the feedback information D16 may include a response to the request returned from the executable code generation unit 120. When the executable code D14 is input to the target equipment 2 to request execution of the code, the feedback information D16 may include a response to the request returned from the target equipment 2. The feedback information D16 may include the state information D15. The feedback information D16 may be output directly to the user 1, or may be output to the user 1 via the executable code generation unit 120 or an output device (not illustrated) included in the control system 1000.

The feedback information D16 may include information for determining whether the control requested of the processing unit at the stage subsequent to the learning model unit 100 is properly executed in the processing unit. This information is not limited to information obtained directly from that processing unit, and may be information obtained from another individual, equipment, a network, or AI (all not illustrated), for example. The feedback information D16 can include analysis information for determining whether the executable code D14 can properly execute the intended control, such as execution time or control trajectory information, for example. The user 1 can, for example, instruct the learning model unit 100 to perform flow timing control, lead time adjustment, or the like in the control description D12 based on such information included in the feedback information D16.

The user 1 may, for example, interact multiple times with the learning model unit 100 using the feedback information D16, and each time determine the validity (presence or absence of a problem) of the control description D12 that has been output. It may be arranged that the user 1 outputs the control description D12 to the executable code generation unit 120 if it is determined that there is no problem in the control description D12.

The feedback information D16 can be acquired, for example, in step S114 described above.

Fig. 8 illustrates an example in which the user 1 inputs the control description D12 to the executable code generation unit 120. However, the control description D12 can be input to the executable code generation unit 120 by the learning model unit 100 upon receiving an instruction from the user 1.

In this example, the control description D12 may include, for example, a description corresponding to low code or no code.

In this example, information can be exchanged between the user 1 and the learning model unit 100 via a terminal provided by the user 1 or via a user interface (such as the input unit 102) included in the information processing device 10 on which the learning model unit 100 operates.

The input information D11 in this example may be updated not by the user 1 but by the control system 1000 (e.g., the correction checking unit 203, etc.).

The feedback information D16 may be input to the learning model unit 100. The feedback information D16 input to the learning model unit 100 may be used for additional learning of the learning model unit 100, for example. The learning model unit 100 may update the model information D102 and/or the model reference information D104 based on the feedback information 16 that has been input.

Other aspects may be substantially the same as those of other control systems according to this embodiment.

As described above, in this variation, the user 1 can check the control description D12 output from the learning model unit 100 and correct the input information D11 while exchanging additional instructions, bug consultations, and so on with the learning model unit 100. Therefore, the accuracy of the control description D12 that is output can be improved. As a result, the efficiency and performance of work of controlling the target equipment 2 can be improved.

### Variation 1-2.

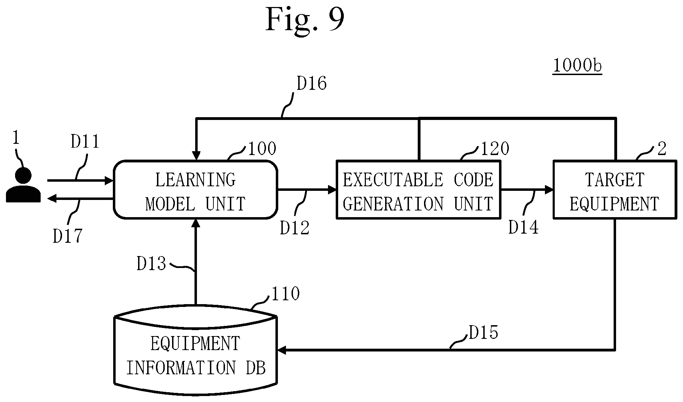

A second variation of the control system 1000 will now be described. Fig. 9 is a configuration diagram illustrating an example of a control system 1000b, which is a variation of the control system 1000. The same elements as those of the control system 1000 and the control system 1000a are denoted by the same reference signs, and description will be omitted.

The control system 1000b illustrated in Fig. 9 differs in that the learning model unit 100 returns an inquiry D17 to the user 1. Examples of the inquiry D17 include, for example, an inquiry that asks again about the input information D11 that is unclear or uncertain, an inquiry for a solution, or a request for re-input with a changed state or expression. As a re-inquiry about the input information D11 that is unclear or uncertain, the learning model unit 100 may output, to the user 1, the inquiry D17 requesting input of more specific information and also presenting a reference point. As an inquiry for a solution, the learning model unit 100 may output, to the user 1, the inquiry D17 providing solution candidates as options and also presenting a reference point. As an inquiry for a solution, the learning model unit 100 may output, to the user 1, information on a solution considered to be the most likely solution together with the inquiry D17 asking whether this solution is correct or not and also present a reference point. The learning model unit 100 may first generate an intermediate control description, which is an intermediate control description that is easy for humans to understand, and output the generated intermediate control description together with the inquiry D17 asking whether it is correct or not to the user 1.

The inquiry D17 may be output, for example, after step S110 described above.

Upon accepting a response from the user 1 to the inquiry D17, the learning model unit 100 may update the input information D11 or confirm the interpretation (meaning) of the input information D11.

The processing by the learning model unit 100 in this example described above can also be implemented, for example, as part of the functions of the input unit 102 or the preprocessing unit 105 of the learning model unit 100, or as part of the functions of the input processing unit 201 (not illustrated) included in the information processing device 10.

As described above, in this variation, the inquiry D17 is output to the user 1 in response to the input information D11 that has been input, and the input information D11 is updated or its interpretation is confirmed based on the response. Therefore, uncertainty in the input information D11 can be cleared. As a result, the accuracy of the control description D12 that is output can be improved, and in turn the efficiency and performance of work of controlling the target equipment 2 can be improved.

### Variation 1-3.

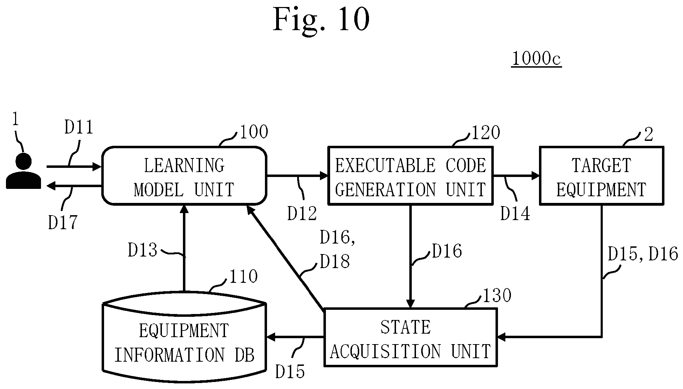

A third variation of the control system 1000 will now be described. Fig. 10 is a configuration diagram illustrating an example of a control system 1000c, which is a variation of the control system 1000. The same elements as those of the control systems 1000, 1000a, and 1000b are denoted by the same reference signs, and description will be omitted.

The control system 1000c illustrated in Fig. 10 further includes a state acquisition unit 130. The state acquisition unit 130 acquires the feedback information D16 indicating a processing result or the state information D15 indicating a state of the equipment after processing from a processing target of the control description D12 output from the learning model unit 100 and the executable code D14 generated from the control description D12. The feedback information D16 or the state information D15 can include information for determining whether the executable code D14 has correctly executed the intended control, such as execution time or control trajectory information.

The state acquisition unit 130 may, for example, input the acquired information to the learning model unit 100. The state acquisition unit 130 may, for example, update the equipment information D13 based on the acquired information. The state acquisition unit 130 may, for example, generate information that supplements (including additions, corrections, and deletions) the input information D11 based on the acquired information, and input this information to the learning model unit 100 as the supplementary information D18. The state acquisition unit 130 may, for example, generate information that supplements (including additions, corrections, and deletions) the control description D12 based on the acquired information, and input this information to the learning model unit 100 as the supplementary information D18.

The state acquisition unit 130 may generate, as the supplementary information D18, a control instruction with new content or an instruction indicating an addition, correction, or deletion to be made in the content indicated by the input information D11 that has already been input, and input it to the learning model unit 100, for example. As the supplementary information D18, the state acquisition unit 130 may input, to the learning model unit 100, the acquired information and also an instruction to remove a problem included in the input information D11 or a problem included in the control description D12 that has been output, for example.

The state acquisition unit 130 may, for example, determine whether the acquired information is information indicating normal processing or a normal state in the processing target, and if not, input to the learning model unit 100 the supplementary information D18 indicating a correction, addition, or deletion to be made to the content indicated by the input information D11 that has already been input.

The learning model unit 100 may, for example, update the model information D102 and/or the model reference information D104 based on information that has been input (the state information D15, the feedback information D16, the supplementary information D18, etc.).

The supplementary information D18 may be generated, for example, in step S115 described above. Output destinations of the supplementary information D18 may include destinations other than the learning model unit 100. The control system 1000 may, for example, output the supplementary information D18 generated by the state acquisition unit 130 to the user 1 or another device that is not illustrated.

The state acquisition unit 130 may be configured to acquire an operation result of a simulator (not illustrated) of the target equipment 2 or an operation result of the target equipment 2 in a debug mode without actually operating the target equipment 2. The debug mode of the target equipment 2 is a mode in which executable code is executed on a control board of the target equipment 2, but actual equipment control is not performed and only the internal state is updated, and is also called an idle operation mode. By using the debug mode, the executable code D14 can be safely tested on the target equipment 2 in a state close to actual control.

Not limited to this variation, as a method for determining the validity of the control description D12 output from the learning model unit 100 and the executable code D14 generated from the control description D12 without actually operating the target equipment 2, the executable code generation unit 120 may be connected so that the output destination of the executable code D14 can be switched between the target equipment 2 and a simulator. The simulator includes one that operates icons of the target equipment 2 in an augmented reality space. When outputting the executable code D14 to the target equipment 2, the executable code generation unit 120 may add information indicating execution in the normal mode or execution in the debug mode.

The processing by the state acquisition unit 130 in this example can also be implemented, for example, as part of the functions of the input unit 102, the preprocessing unit 105, and the post-processing unit 106 of the learning model unit 100, or the input processing unit 201, the output checking unit 202, and the correction checking unit 203 (all not illustrated) included in the information processing device 10.

Other aspects may be substantially the same as those of other control systems according to this embodiment.

As described above, in this variation, the state acquisition unit 130 acquires, for the input information D11 that has been input, the feedback information D16 indicating a processing result or the state information D15 indicating a state of the equipment after processing from the target equipment 2 or the executable code generation unit 120 that is the output destination of the model output data D103 and/or information generated based on the model output data D103, and issues the supplementary information D18 to the learning model unit 100 as appropriate based on the acquired information. As a result, the accuracy of the control description D12 can be improved, and in turn the efficiency and performance of work of controlling the target equipment 2 can be improved.

In this variation, for example, a person and a machine (the state acquisition unit 130) can cooperate to improve the accuracy of inputs to the learning model unit 100, making it possible to also contribute to reducing the work load of the user 1.

### Embodiment 2.

Embodiment 2 will now be described. In this embodiment, an example will be described in which a learning model is used to assist work involved in controlling a target equipment.

In the following, cases will be considered where various types of control equipment such control devices for a PLC, a processing machine, a robot, a sensor, a conveyance device, and other machines are controlled in a factory, for example. While a skilled worker may be familiar with control methods for a wide variety of control equipment and complex control equipment, there may be cases where an unskilled worker is required perform control on control equipment due to reassignment or other reasons. When new control equipment (including a version upgrade) is introduced, it is necessary to inform all workers of a control method that corresponds to the new control equipment, and insufficient dissemination of this information could lead to mistakes.

In such cases, it is preferable to be able to reliably perform desired control without knowing, for example, a specific control method such as, for example, control instructions, control signals, and control code to be provided to the control equipment, or commands to a controller corresponding to the control equipment, as this will lead to improved work efficiency and performance.

Situations in which equipment is controlled are not limited to within a factory, and applications of this embodiment are also not limited to within a factory.

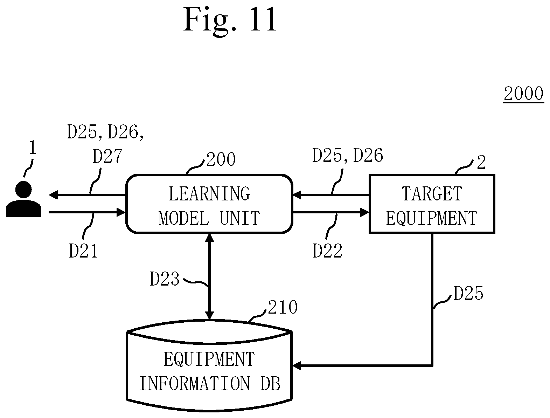

Fig. 11 is a configuration diagram illustrating an example of a control system 2000 according to Embodiment 2. The control system 2000 illustrated in Fig. 11 is a control system for controlling equipment using a learning model, and includes a learning model unit 200 and an equipment information storage unit 210 (indicated as an equipment information DB in the diagram).

When input information D21 is input, the learning model unit 200 outputs a control instruction D22. For example, when the input information D21 is input, the learning model unit 200 outputs the control instruction D22 based on the model information D102. The configuration of the learning model unit 200 may be basically the same as that of the learning model unit 100 in Embodiment 1.

In this embodiment, the learning model unit 200 is a model and its operating environment configured to output the control instruction D22 corresponding to the input information D21 when the input information D21 is input. The learning model unit 200 may be a model and its operating environment configured to generate and output the control instruction D22 when the input information D21 is input, based on the input information D21, equipment information D23, and other information that can be referred to in the learning model unit 200.

In this embodiment, the input information D21 includes information indicating control content required for the target equipment 2. The input information D21 may be, for example, text, an image, voice, or a combination of these indicating control content for the target equipment 2. The input information D21 may be, for example, text, an image, voice, or a combination of these indicating a plurality of pieces of control content for the target equipment 2. The input information D21 may include information indicating control content to be performed continuously over time, and in that case, may be time-series data in a predetermined data structure that includes text, an image, voice, or a combination of these indicating such control content. It is assumed that control content is indicated in a way that conforms with the input format of a model used by the learning model unit 200. However, this does not apply in cases such as those where error handling, correction processing, or conversion processing is included in the stage preceding the learning model unit 200.

The ways in which control content is indicated in the input information D21 may be, for example, substantially the same as those in Embodiment 1. For example, control to be performed on the target equipment 2 may be identified, and then parameter values for performing the control and a state after the control may be specified. In this case, the input information D21 may include, for example, information that identifies the control and information that indicates the parameter values for performing the control or the state after the control. The input information D21 may include not only information that directly indicates the control content for the target equipment 2, but also information that indirectly indicates the control content using operation content, behavior of the user 1, an image of the target equipment 2, or the like corresponding to the control content, or using similar control instructions or the like in other models or the like.

The control instruction D22 includes information about control of the target equipment 2 expressed in a predetermined format that can be recognized by the target equipment 2 or an interface that requests the target equipment 2 to perform control. The control instruction D22 may include information indicating a control requirement for the target equipment 2. The control instruction D22 is, for example, a control command, a control signal, or control code for the target equipment 2. The control instruction D22 may be, for example, a command written in a format that can be handled by a predetermined controller corresponding to the target equipment 2.

The equipment information storage unit 210 stores equipment information D23, which is information related to the target equipment 2. The equipment information storage unit 210 and the equipment information D23 are handled basically in the same way as the equipment information storage unit 110 and the equipment information D13 in Embodiment 1. The equipment information D23 in this embodiment may include, for example, information used for controlling the target equipment 2. The equipment information D23 is used, for example, as additional information when the learning model unit 200 outputs the control instruction D22. In the following, in this embodiment, information indicating particularly the state of the target equipment 2 may be referred to as state information D25.

In this embodiment, the learning model unit 200 may be, for example, a language learning model such as an LLM to which natural language is input to obtain an output result and its operating environment. The learning model unit 200 may be, for example, an image learning model such as a VLM to which an image is input to obtain an output result and its operating environment. The learning model unit 200 may be, for example, a multimodal model to which natural language and an image are input to obtain an output result and its operating environment. In that case, the input information D21 may be input as text data, image data, or a combination of text data and image data, or in a data format that can be converted into these (voice data, video that is a combination of voice data and image data, etc.). The learning model used in this embodiment is not limited to the models mentioned above.

In this embodiment, for the sake of simplicity of description, there may be cases where the components provided corresponding to the learning model unit 200 are described using the same reference signs as those of the components provided corresponding to the learning model unit 100. It should be noted that these components are provided specifically corresponding to the learning model unit 200. The same also applies to other embodiments.

In this embodiment, the input information D21 corresponds to the model input data D101. The control instruction D22 corresponds to the model output data D103. The learning model unit 200 (particularly, the model control unit 101) may be configured to, for example, accept the input information D21, and then based on the model information D102 and, if necessary, the model reference information D104, output the control instruction D22 corresponding to the input information D21.

In such a case, the model generation unit 107 provided corresponding to the learning model unit 200 may perform machine learning using, for example, the model learning data D105 including candidates for the input information D21 that may be input to the model control unit 101, so as to generate or update the model information D102. The model generation unit 107 may perform machine learning using, for example, the model learning data D105 including candidates for the input information D21 that may be input to the model control unit 101 and corresponding candidates for the control instruction D22, so as to generate or update the model information D102.

A reference sign D26 denotes feedback information indicating a control result in the target equipment 2. Also in this embodiment, the state information D25 and/or feedback information D26 may be acquired from the output destination of the model output data D103 and/or information generated based on the model output data D103. The control system 2000 may, for example, output the acquired state information D25 and/or feedback information D26 as information indicating the control result to the user 1, the learning model unit 200, or another device not illustrated. The control system 2000 can generate supplementary information D28 for input/output data of the learning model unit 200 based on the acquired state information D25 and/or feedback information D26, and issue the supplementary information D28 to the user 1, the learning model unit 200, or another device not illustrated. The control system 2000 may be configured to return an inquiry D27 to the user 1 when the input information D21 includes unclear or uncertain information. The inquiry D27 is handled in substantially the same manner as the inquiry D17 in Embodiment 1.

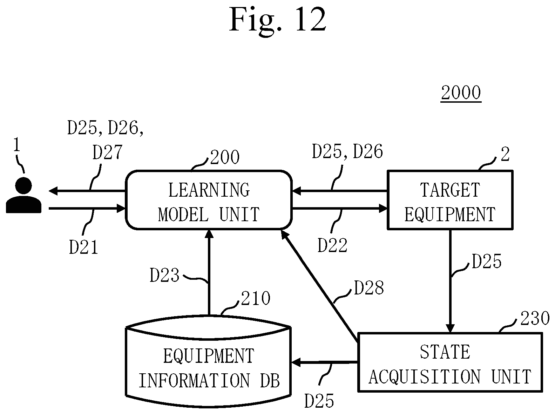

Fig. 12 is a configuration diagram illustrating another example of the control system 2000. As illustrated in Fig. 12, the control system 2000 may further include a state acquisition unit 230 that acquires the state information D25 and/or the feedback information D26 and issues the supplementary information D28. The state acquisition unit 230 is substantially the same as the state acquisition unit 130 in Embodiment 1.

Also in this embodiment, the target equipment 2 is not particularly limited. It is assumed that the target equipment 2 is equipment that can receive the control instruction D22 and can actually be controlled. However, this does not apply if a conversion device, such as a controller or a converter, that converts various signals is provided for the target equipment 2. In this case, the conversion device may receive the control instruction D22 and control the target equipment 2.

In this embodiment, the input information D21 accepted by the control system 2000 can be considered to be information related to requirements in a work environment, that is, an environment in which the target equipment 2 operates (control content required for the target equipment 2). Therefore, the input information D21 accepted by the control system 2000 can be considered to be an example of the first information indicating requirements in the work environment. The control instruction D22 can be considered to be information used for the work (work involved in controlling the target equipment 2) in response to such input information D21. In the following, the control instruction D22 output to a predetermined output destination from the operating environment of the learning model to which model input data based on the input information D21 is input may be referred to as the second information.

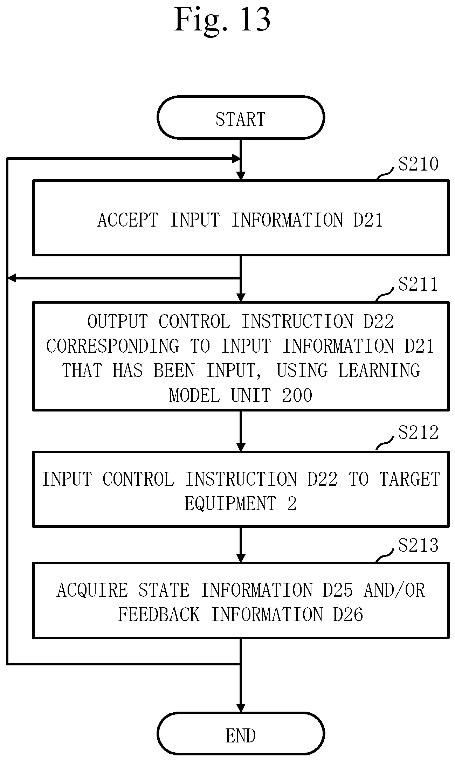

The operation of the control system 2000 of this embodiment will now be described. Fig. 13 is a flowchart illustrating an example of the operation of the control system 2000.

In the example illustrated in Fig. 13, the control system 2000 first accepts the input information D21 (step S210). For example, the input unit 102 or the input processing unit 201 described above may accept the input information D21. The accepted input information D21 is input to the learning model unit 200 as the model input data D101.

Next, the control system 2000 performs a process of generating the control instruction D22 using the learning model unit 200 (step S211). In step S211, the learning model unit 200 (more specifically, the model control unit 101) outputs the control instruction D22 corresponding to the input information D21 based on the model information D102, the input information D21 that has been input, and, if necessary, the model reference information D104 including the equipment information D23.

In step S211, the learning model unit 200 may, for example, generate the control instruction D22 of binary data from the input information D21 that has been input, using a learning model that can generate binary data. The learning model unit 200 may, for example, generate the control instruction D22 of text data from the input information D21 that has been input, using a learning model that can generate text data. The learning model unit 200 may, for example, generate the control instruction D22 of image data from the input information D21 that has been input, using a learning model that can generate image data. The learning model unit 200 may, for example, generate the control instruction D22 of voice data from the input information D21 that has been input, using a learning model that can generate voice data.

In step S211, the preprocessing unit 105 and/or the post-processing unit 106 of the learning model unit 200 may further perform the process described above.

The control instruction D22 output from the learning model unit 200 is input, for example, to the target equipment 2 (step S212). The control instruction D22 may be input to the target equipment 2 directly from the control system 2000 (more specifically, the learning model unit 200 or the information processing device 10 that is its operating environment), or may be input indirectly through a communication device or other equipment (a server, various conversion devices, etc.).

As a result, the target equipment 2 operates according to the input control instruction D22.

If the state of the target equipment 2 changes due to the target equipment 2 being controlled or there is feedback from the target equipment 2 as a result of outputting the control instruction D22, the control system 2000 may acquire the state information D25 and the feedback information D26 (step S213). The processing in step S213 is not essential and can be omitted as appropriate.

The control system 2000 may repeat the processing in step S210 to step S213 multiple times (for example, until the desired control is completed for the target equipment 2).

As described above, according to this embodiment, even if the user 1 does not know a specific control method for the target equipment 2, the control instruction D22 can be generated from the input information D21 input from the user 1, and the target equipment 2 can be controlled based on the generated control instruction D22. Therefore, the efficiency and sophistication of work involved in controlling the target equipment 2 can be improved.

According to this embodiment, equipment can be controlled to an appropriate state even with ambiguous information.

### Embodiment 3.

Embodiment 3 will now be described. In this embodiment, an example will be described in which a learning model is used to assist work involved in operating target equipment.

In the following, cases will be considered where various types of equipment such as an air conditioner, a refrigerator, a television, a light, a washing machine, a projector, various sensors, and communication equipment are operated in a home or a building, for example. In recent years, even these types of consumer-targeted equipment provide sophisticated functions, and control of these types of equipment has become more complex. Although innovations have been made in controllers such as operating screens and remote controls to simplify complex control, it is still difficult to remember all operations. Even if a desired function is provided, it may not be easy to access that function.

There are many cases where even if similar functions are provided, there are differences between models in function names that are provided, details of the functions, or control methods. When a different model is introduced due to replacement or other reasons, these differences need to be learned from the very beginning, which is cumbersome.

Some equipment automatically controls itself to an appropriate state by remembering a past operation history, understanding the operating environment, and so on. However, in situations where multiple people gather and the appropriate state varies depending on the person or where there is one person and the appropriate state varies depending on the physical condition of the person, accurate control can be difficult.

In such cases, it is desirable to be able to easily perform operations to achieve the desired state even if a specific operating method is not known or an operator does not know the state considered to be appropriate, as this will lead to improved work efficiency and performance.

Situations in which equipment is operated are not limited to within homes or buildings, and situations in which this embodiment is utilized are not limited to within homes or buildings.

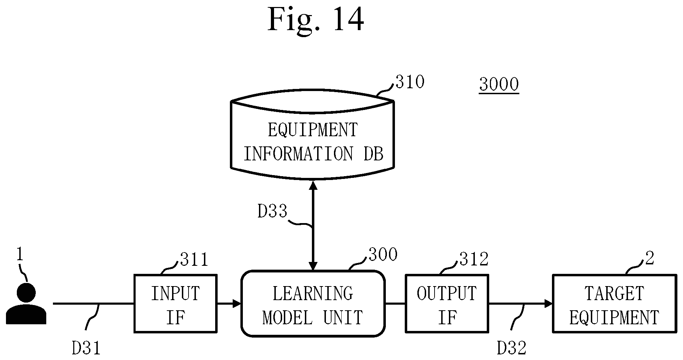

Fig. 14 is a configuration diagram illustrating an example of a control system 3000 according to Embodiment 3. The control system 3000 illustrated in Fig. 14 is a control system for operating equipment using a learning model, and includes a learning model unit 300, an equipment information storage unit 310 (indicated as an equipment information DB in the diagram), an input interface 311 (indicated as an input IF in the diagram), and an output interface 312 (indicated as an output IF in the diagram).

When input information D31 is input, the learning model unit 300 outputs an operation instruction D32. For example, when the input information D31 is input, the learning model unit 300 outputs the operation instruction D32 based on the model information D102. The configuration of the learning model unit 300 may be basically the same as that of the learning model unit 100 in Embodiment 1.

In this embodiment, the learning model unit 300 is a model and its operating environment configured to output the operation instruction D32 corresponding to the input information D31 when the input information D31 is input. The learning model unit 300 may be a model and its operating environment configured to generate and output the operation instruction D32 when the input information D31 is input, based on the input information D31, equipment information D33, and any other information that can be referred to in the learning model unit 300.

In this embodiment, the input information D31 includes information indicating operation content required for the target equipment 2. The input information D31 may be, for example, text, an image, voice, or a combination of these indicating operation content for the target equipment 2. The input information D31 may be, for example, text, an image, voice, or a combination of these indicating a plurality of pieces of operation content for the target equipment 2. The input information D31 may include information indicating operation content to be performed continuously over time, and in that case, may be time-series data in a predetermined data structure that includes text, an image, voice, or a combination of these indicating such operation content. It is assumed that operation content is indicated in a way that conforms with the input format of a model used by the learning model unit 300. However, this does not apply in cases such as those where error handling, correction processing, or conversion processing is included in the stage preceding the learning model unit 300.

An example of how to indicate operation content in the input information D31 is a method in which an operation to be performed on the target equipment 2 is identified, and then parameter values for performing that operation and a state after the operation are specified. In this case, the input information D31 may include, for example, information that identifies the operation and information that indicates the parameter values for performing the operation or the state after the operation. The parameter values for performing the operation may include, for example, values related to a type of operation (such as ON/OFF), a direction, an amount, and time. The input information D31 may include not only information that directly indicates the operation content for the target equipment 2, but also information that indirectly indicates the operation content using control content, behavior of the user 1, or an image of the target equipment 2 corresponding to the control content, a similar operation instruction in other models, or the like.

The operation instruction D32 includes information related to an operation of the target equipment 2 indicated in a predetermined format that can be recognized by the target equipment 2 or an interface (including a person) that requests the target equipment 2 to perform control. The operation instruction D32 may include information indicating an operation request or control request to the target equipment 2. The operation instruction D32 is, for example, an operation command, an operation signal, an operation code, a control command, a control signal, or control code for the target equipment 2. The operation instruction D32 may be, for example, a command written in a format that can be handled by a predetermined controller corresponding to the target equipment 2. The operation instruction D32 can be considered to be a concept such that information related to an operation is added to the control instruction D22 described above. When the interface is a person, that is, when control of the target equipment 2 is requested via a person, the operation instruction D32 may be, for example, information indicating a method for operating the target equipment 2 that is indicated in a format that can be recognized by humans.

The equipment information storage unit 310 stores the equipment information D33, which is information related to the target equipment 2. The equipment information storage unit 310 and the equipment information D33 are handled in basically the same way as the equipment information storage unit 110 and the equipment information D13 in Embodiment 1. The equipment information D33 in this embodiment may include, for example, information used in an operation of the target equipment 2. The equipment information D33 may include, for example, information indicating a procedure for an operation to be actually performed on the target equipment 2 based on the operation content. The equipment information D33 may include, for example, a command, a signal, a code, and so on issued to the target equipment 2. The equipment information D33 may be used, for example, as additional information when the learning model unit 300 outputs the operation instruction D32. In the following, in this embodiment, information particularly indicating the state of the target equipment 2 may be referred to as state information D35.

The input interface 311 is an interface that accepts the input information D31 from the user 1 and inputs the input information D31 to the learning model unit 300. The input interface 311 may be, for example, an interface that converts the input information D31 input from the user 1 into data that conforms with the input format of the learning model unit 300. The input interface 311 may be provided as an example of the input unit 102 described above.

The output interface 312 is an interface that accepts the operation instruction D32 from the learning model unit 300 and outputs the operation instruction D32 to a predetermined output destination. The output interface 312 may be provided, for example, as an example of the output unit 103 described above. The output interface 312 may be, for example, an interface that converts the operation instruction D32 output from the learning model unit 300 into data that conforms to a predetermined output destination. In this embodiment, the output destinations of the output interface 312 may include the target equipment 2, a controller 4 (not illustrated), a display 7 (not illustrated) that is predetermined, and an operation terminal (not illustrated) of the user 1.

In this embodiment, the learning model unit 300 may be, for example, a language learning model such as an LLM to which natural language is input to obtain an output result and its operating environment. The learning model unit 300 may be, for example, an image learning model such as a VLM to which an image is input to obtain an output result and its operating environment. The learning model unit 300 may be, for example, a multimodal model to which natural language and an image are input to obtain an output result and its operating environment. In that case, the input information D31 may be input as text data, image data, or a combination of text data and image data, or in a data format that can be converted into these (voice data, video that is a combination of voice data and image data, etc.). The learning model used in this embodiment is not limited to the models mentioned above.

In this embodiment, the input information D31 corresponds to the model input data D101. The operation instruction D32 corresponds to the model output data D103. The learning model unit 300 (particularly, the model control unit 101) may be configured to, for example, accept the input information D31, and then output the operation instruction D32 corresponding to the input information D31 based on the model information D102 and, if necessary, the model reference information D104.

In such a case, the model generation unit 107 provided corresponding to the learning model unit 300 may, for example, perform machine learning using the model learning data D105 including candidates for the input information D31 that may be input to the model control unit 101, so as to generate or update the model information D102. The model generation unit 107 may, for example, perform machine learning using the model learning data D105 including candidates for the input information D31 that may be input to the model control unit 101 and corresponding candidates for the operation instruction D32, so as to generate or update the model information D102.

Although not illustrated, also in this embodiment, the state information D35 and/or feedback information D36 may be acquired from the output destination of the model output data D103 of the learning model unit 300 and/or information generated based on the model output data D103. The control system 3000 may, for example, output the acquired state information D35 and/or feedback information D36 as information indicating a response result to the user 1, the learning model unit 300, or another device not illustrated. The control system 3000 may be configured to return an inquiry D37 to the user 1 when the input information D31 includes unclear or uncertain information. The control system 3000 can generate supplementary information D38 for input/output data of the learning model unit 300 based on the acquired state information D35 and/or feedback information D36, and issue the supplementary information D38 to the user 1, the learning model unit 300, or another device not illustrated. The state information D35, the feedback information D36, the inquiry D37, and the supplementary information D38 may be handled in basically the same way as in Embodiment 1.

The control system 3000 may further include a state acquisition unit 330 (not illustrated) that acquires the state information D35 and/or the feedback information D36 and issues the supplementary information D38 as necessary. The state acquisition unit 330 is substantially the same as the state acquisition unit 130 in Embodiment 1.

Also in this embodiment, the target equipment 2 is not particularly limited. It is assumed that the target equipment 2 is equipment that receives the operation instruction D32 and can actually perform control corresponding to the operation content indicated by the operation instruction D32. However, this does not apply if a conversion device, such as a controller 4 or a converter, that converts various signals is provided for the target equipment 2. In this case, the conversion device or the operator may receive the operation instruction D32 and operate the target equipment 2.

In this embodiment, the input information D31 accepted by the control system 3000 can be considered to be information related to requirements in a work environment, that is, an environment in which the target equipment 2 operates (operation content required for the target equipment). Therefore, the input information D31 accepted by the control system 3000 can be considered to be an example of the first information indicating requirements in the work environment. The operation instruction D32 can be considered to be information used for the work (work involved in operating the target equipment 2) in response to such input information D31. In the following, the operation instruction D32 output to a predetermined output destination from the operating environment of the learning model to which model input data based on the input information D31 is input may be referred to as the second information.

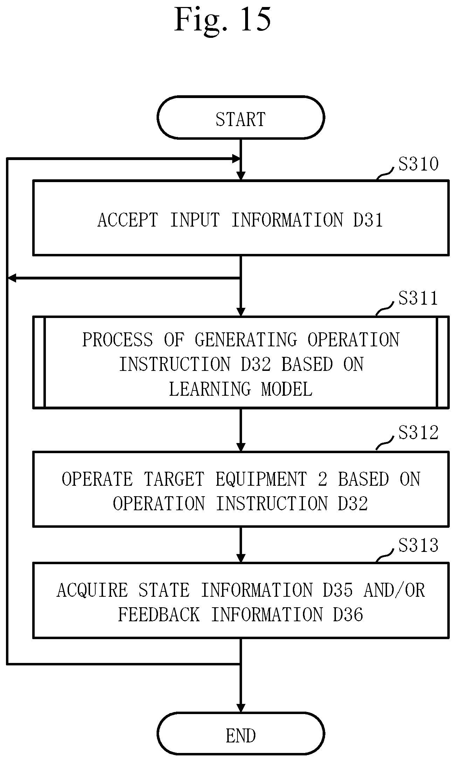

The operation of the control system 3000 in this embodiment will now be described. Fig. 15 is a flowchart illustrating an example of the operation of the control system 3000.

In the example illustrated in Fig. 15, the input interface 311 of the control system 3000 first accepts the input information D31 (step S310). The accepted input information D31 is input to the learning model unit 300 as the model input data D101.

Next, the control system 3000 performs a process of generating the operation instruction D32 using the learning model unit 300 (step S311). In step S311, the learning model unit 300 (more specifically, the model control unit 101) generates and outputs the operation instruction D32 corresponding to the input information D31 based on the model information D102, the input information D31 that has been input, and, if necessary, the model reference information D104 including the equipment information D33.

In step S311, the learning model unit 300 may, for example, generate the operation instruction D32 of binary data from the input information D31 that has been input, using a learning model that can generate binary data. The learning model unit 300 may, for example, generate the operation instruction D32 of text data from the input information D31 that has been input, using a learning model that can generate text data. The learning model unit 300 may, for example, generate the operation instruction D32 of image data from the input information D31 that has been input, using a learning model that can generate image data. The learning model unit 300 may, for example, generate the operation instruction D32 of voice data from the input information D31 that has been input, using a learning model that can generate voice data.

In step S311, the preprocessing unit 105 and/or the post-processing unit 106 of the learning model unit 300 may further perform the process described above.

The operation instruction D32 output from the learning model unit 300 is output to a predetermined output destination via the output interface 312, for example. The predetermined output destination may be the target equipment 2, the controller 4, the display 7 that is predetermined, or an operation terminal (not illustrated) of the user 1. When the operation instruction D32 is input to the predetermined output destination, the target equipment 2 is operated according to the input operation instruction D32 (step S312).

For example, the output interface 312 may output the operation instruction D32 to the target equipment 2. In this case, the target equipment 2 that has accepted the operation instruction D32 (e.g., an operation command, an operation signal, an operation code, a control command, a control signal, control code, etc.) may execute actual control according to the operation instruction D32. The output interface 312 may output the operation instruction D32 to the controller 4 corresponding to the target equipment 2. In this case, the controller 4 that has accepted the operation instruction D32 (e.g., indirect control information for the target equipment 2, such as a command, operation command, operation signal, or operation code for the controller 4) may control the target equipment 2 according to the operation instruction D32. The controller 4 may control the target equipment 2 by outputting direct control information such as control code to the target equipment 2 based on the control information indicated by the accepted operation instruction D32. The controller 4 may be, for example, an operation panel attached to the target equipment 2, or may be a remote control that corresponds to the target equipment 2 and is directly operated by the user. The controller 4 includes a controller specific to the target equipment 2 and a generalpurpose controller. The output interface 312 may output the operation instruction D32 to the operation terminal of the user 1 or a predetermined display. In this case, the operation terminal of the user 1 or the display that has accepted the operation instruction D32 (e.g., information indicating an operation method, etc.) displays the operation instruction D32. Then, the user 1 may operate the target equipment 2 or the controller 4 by referring to the displayed operation instruction D32.

The operation instruction D32 may be input to the output destination directly from the control system 3000 (more specifically, the learning model unit 300 or the information processing device 10 that is its operating environment), or may be indirectly input to the output destination via a communication network or other equipment (a server, various conversion devices, etc.).

As a result, the target equipment 2 operates according to the operation instruction D32.

If the state of the target equipment 2 changes due to the target equipment 2 being operated or there is feedback from the target equipment 2 as a result of outputting the operation instruction D32, the control system 3000 may acquire the state information D35 and the feedback information D36 (step S313). The processing in step S313 is not essential and can be omitted as appropriate.

The control system 3000 may repeat the processing in step S310 to step S313 multiple times (e.g., until the desired operation is completed on the target equipment 2).

As described above, according to this embodiment, even if the user 1 does not know a specific operating method for the target equipment 2, the operation instruction D32 can be generated from the input information D31 input by the user 1, and the target equipment 2 can be operated based on the generated operation instruction D32. Therefore, the efficiency of work involved in operating the target equipment 2 can be improved.

According to this embodiment, equipment can be operated to an appropriate state even with ambiguous information. In addition, according to this embodiment, equipment can be operated to an appropriate state without depending on the equipment and without learning how to operate the equipment.

### Variation 3-1.

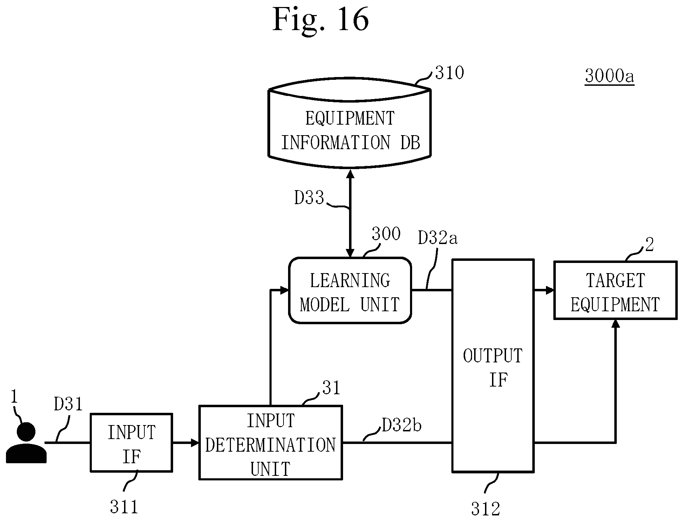

A variation of the control system 3000 will now be described. Fig. 16 is a configuration diagram illustrating an example of a control system 3000a, which is a variation of the control system 3000 according to this embodiment. The same elements as those of the control system 3000 are denoted by the same reference signs, and description will be omitted.

The control system 3000a illustrated in Fig. 16 further includes an input determination unit 31. The input determination unit 31 is means for accepting the input information D31, analyzing the input information D31, and switching a control destination for the input information D31d. In this variation, the input determination unit 31 switches the control destination for the input information D31 between the learning model unit 300 and the output interface 312.

The input determination unit 31 may switch the control destination for the input information D31 depending on whether the input information D31 conforms with an operation command rule for the target equipment 2, for example. If the input information D31 conforms with the operation command rule for the target equipment 2, the input determination unit 31 may input the input information D31 as it is to the output interface 312. If the input information D31 does not conform with the operation command rule for the target equipment 2, the input determination unit 31 may input the input information D31 to the learning model unit 300.

The conformity with the operation command rule may be determined, for example, using a rule-based model. The input determination unit 31 may be a learning model that is relatively lightweight compared to the learning model unit 300.

In the following, in order to distinguish information input at the output interface 312, the operation instruction D32 output from the learning model unit 300 may be referred to as an operation instruction D32a, and the input information D31 output to the output interface 312 may be referred to as an operation instruction D32b.

In this example, the output interface 312 may be any interface that accepts the operation instruction D32a or the operation instruction D32b and outputs it to a predetermined output destination.

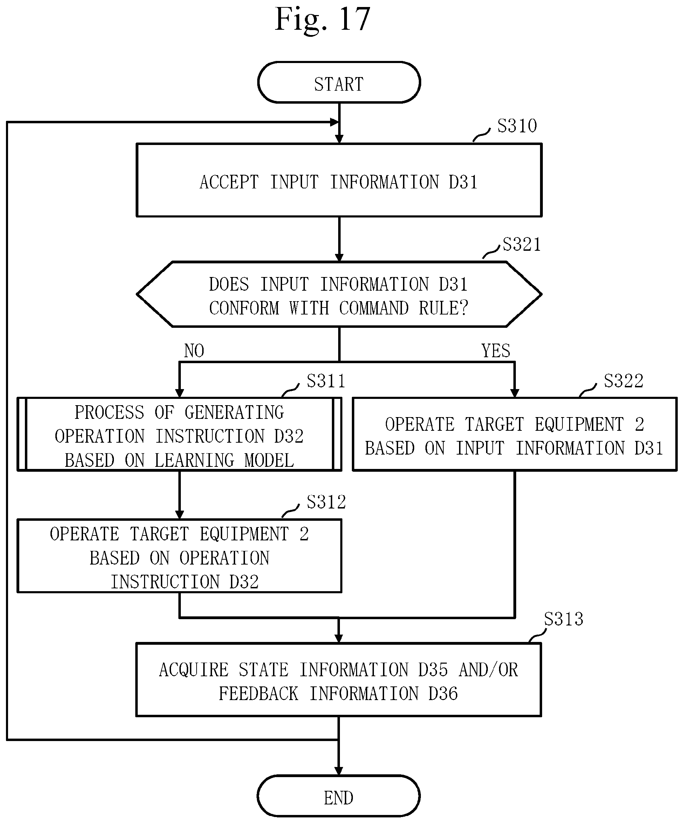

The operation of the control system 3000a of this variation will now be described. Fig. 17 is a flowchart illustrating an example of the operation of the control system 3000a.

In the example illustrated in Fig. 17, the input interface 311 of the control system 3000a first accepts the input information D31 (step S310). The accepted input information D31 is input to the input determination unit 31.

Next, the input determination unit 31 determines whether the input information D31 conforms with the operation command rule for the target equipment 2 (step S321). If it is determined that the input information D31 conforms with the operation command rule for the target equipment 2 (Yes in step S321), the input information D31 is input to the output interface 312 (proceed to step S322). If it is determined that the input information D31 does not conform with the operation command rule for the target equipment 2 (No in step S321), the input information D31 is input to the learning model unit 300 (proceed to step S311).

The processing in step S311 to step S313 is the same as in the example illustrated in Fig. 15.

In step S322, the output interface 312 outputs the input information D31 that has been input, as the operation instruction D32b, to a predetermined output destination. As a result, the target equipment 2 operates according to the operation instruction D32b.

Other aspects may be substantially the same as those in other control systems according to this embodiment.

As described above, according to this variation, if an input from the user 1 conforms with the operation command rule for the target equipment 2, the target equipment 2 can be operated according to the input. If the input does not conform with the operation command rule, the target equipment 2 can be operated using a learning model. Therefore, the efficiency of work involved in operating the target equipment 2 can be further improved.

### Variation 3-2.

Another variation of the control system 3000 will now be described. In this variation, an operation instruction that involves arbitration of a plurality of inputs is generated using a learning model.

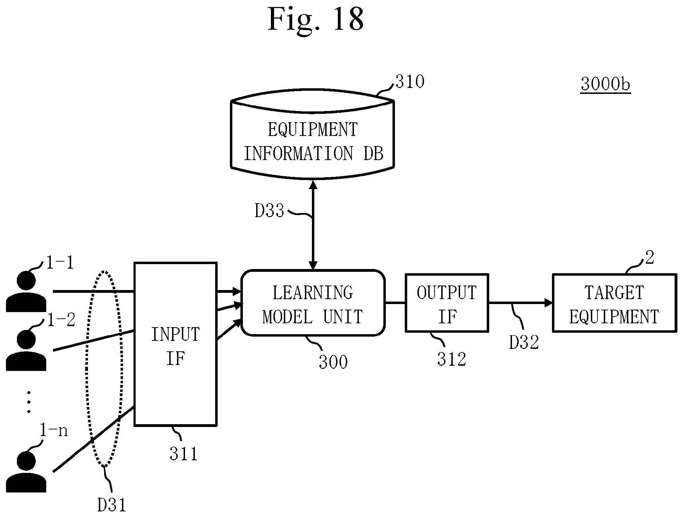

Fig. 18 is a configuration diagram illustrating an example of a control system 3000b, which is a variation of the control system 3000 according to this embodiment. The same elements as those of the control system 3000 are denoted by the same reference signs, and description will be omitted.

In the control system 3000b illustrated in Fig. 18, the input interface 311 accepts the input information D31 from a plurality of users 1.

The input interface 311 accepts the input information D31 from a plurality of users 1 and inputs the input information D31 to the learning model unit 300. At this time, the input interface 311 may accept the input information D31 to which information about the user 1 who is the input source is attached. Alternatively, the input interface 311 may identify the user 1 who is the input source, add information about the input source, and then accept the input information D31, or accept the input information D31 without doing anything in particular.

The learning model unit 300 may be a model and its operating environment configured to, when pieces of the input information D31 accepted by the input interface 311 are input, output the operation instruction D32 corresponding to the pieces of the input information D31. The learning model unit 300 may be a model and its operating environment configured to, when pieces of the input information D31 are input, generate and output the operation instruction D32 based on the pieces of the input information D31, the equipment information D33, and other information that can be referred to in the learning model unit 300.

For example, the learning model unit 300 may generate and output the operation instruction D32 that is a compromise for different pieces of operation content indicated by pieces of the input information D31 by performing a process of extracting a preferred solution in a language space (more specifically, in a feature vector space having information on the language space) using a language learning model such as an LLM to which natural language is input to obtain an output result. In this case, the learning model unit 300 may refer to a history of the input information D31 for each user 1 who is the input source and/or a history of the operation instruction D32 for each user 1 who is the input source.

Other aspects may be substantially the same as those in other control systems according to this embodiment.

As described above, according to this variation, even when pieces of information each about different operation content are input from a plurality of users, it is possible to use the learning model unit 300 to generate a more appropriate operation instruction D32 in which these pieces of content are arbitrated. Therefore, the functionality of work involved in operating the target equipment 2 can be further improved.

### Variation 3-3.

Another variation of the control system 3000 will now be described. In this variation, an operation screen user interface is generated using a learning model.

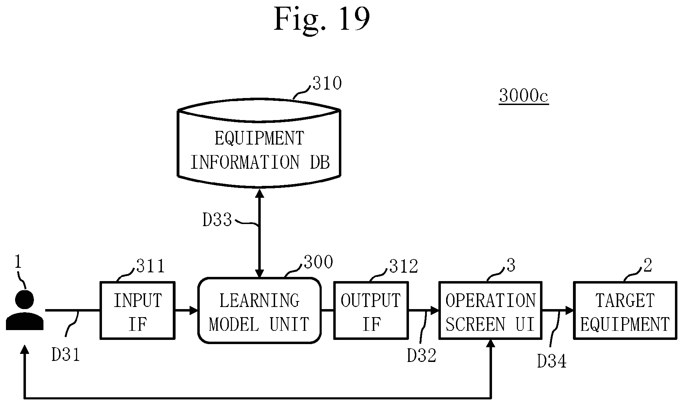

Fig. 19 is a configuration diagram illustrating an example of a control system 3000c, which is a variation of the control system 3000 according to this embodiment. The same elements as those of the control system 3000 are denoted by the same reference signs, and description will be omitted.

The control system 3000c illustrated in Fig. 19 further includes an operation screen user interface 3 (indicated as an operation screen UI in the diagram). The learning model unit 300 generates, as the operation instruction D32, an operation screen for actually performing an operation of operation content corresponding to the input information D31 on the target equipment 2.

The operation screen generated by the learning model unit 300 may be, for example, a screen application programming interface (API) that has a function of accepting a description of operation content and an operation input from a user and outputting a control instruction D34 such as control code corresponding to the accepted operation input. Outputting control code or the like in response to an operation input includes a mode in which a plurality of control instructions D34 are sequentially output in response to a single operation input. The operation screen may be a screen API that includes operation description, operation input acceptance, and control instruction output corresponding to two or more different pieces of operation content. The learning model unit 300 may, for example, extract two or more pieces of operation information each indicating different operation content as the operation instructions D32 corresponding to the input information D31, and generate a screen API that includes operation input acceptance and control instruction output corresponding to each piece of operation information.

The operation screen generated by the learning model unit 300 may be an existing operation screen whose display mode is modified such that operation points for the corresponding operation content are highlighted, operation functions that are displayed are limited, the positions and forms (shapes, sizes, colors, etc.) of UI components on the screen are displayed differently, and so on.

The operation screen user interface 3 is an interface that displays an operation screen for the target equipment 2 and accepts inputs related to user operations on the operation screen. The operation screen user interface 3 may be realized, for example, by a touch panel display or a controller including operation buttons and a display unit. The operation screen user interface 3 may be realized by a display device such as a display that functions in cooperation with an operation input device such as a mouse.

The output interface 312 in this variation outputs the operation instruction D32 (operation screen) output from the learning model unit 300 to the operation screen user interface 3.

In this variation, the learning model unit 300 may have a function of interactively confirming an operation expected by the user 1. In such a case, for example, when information requesting re-acquisition of the operation instruction D32 is received after the operation screen is presented as the operation instruction D32, the learning model unit 300 may change part of input information, part of model parameters, a reference destination of reference information, or the like, and then re-acquire the operation instruction D32.

As described above, in this variation, the learning model unit 300 can be used to generate an operation screen that has been processed (constructing a screen API, changing the display mode, etc.) to allow desired operations to be performed easily or clearly. Therefore, the efficiency of work involved in operating the target equipment 2 can be further improved. Furthermore, according to this variation, the user 1 can perform actual operations while checking the description or the like of operation instructions generated by the learning model unit 300, so that the operations can be performed without mistakes.

### Variation 3-4.

Another variation of the control system 3000 will now be described. In this variation, a learning model generates an operation instruction further using environmental information.

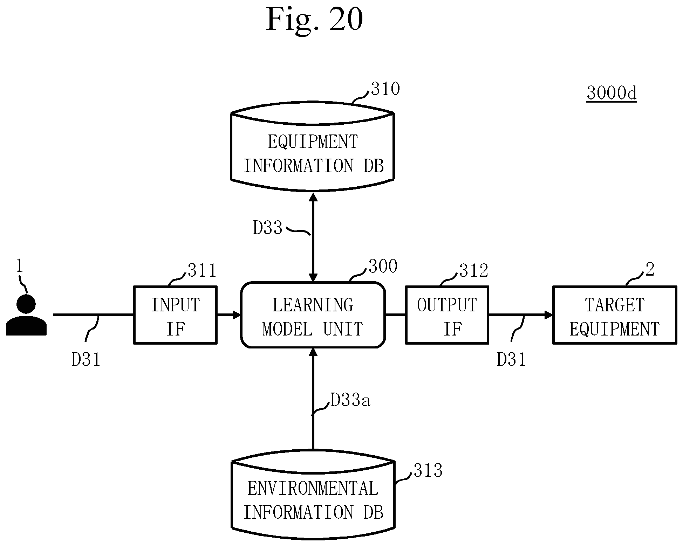

Fig. 20 is a configuration diagram illustrating an example of a control system 3000d, which is a variation of the control system 3000 according to this embodiment. The same elements as those of the control system 3000 are denoted by the same reference signs, and description will be omitted.

The control system 3000d illustrated in Fig. 20 further includes an environmental information storage unit 313 (indicated as an environmental information DB in the diagram).

The environmental information storage unit 313 stores environmental information D33a, which is information about an environment in which the target equipment 2 operates. The environmental information D33a may include information about a space where the target equipment 2 is operating. In this variation, information about an object or a person present in the space where the target equipment 2 is operating and the user 1 who is the operator of the target equipment 2 are also considered to be part of the environment. Therefore, the environmental information D33a may include information about the object, the person, or the user 1.

The environmental information D33a may include, for example, information such as the attributes, temperature, location, posture, heart rate of a person as information about the person. The environmental information D33a may include, for example, information such as the location, temperature, humidity, and brightness of the space as information about the space. When such information about a space or a person changes, the environmental information D33a may retain information indicating the transition. Information indicating a transition is referred to also as time-series data or history information. The environmental information D33a may be configured, for example, as part of the model reference information D104 of the learning model.

The environmental information D33a may be acquired, for example, by a sensor or the like that is not illustrated.

The learning model unit 300 is, for example, a model and its operating environment configured to generate and output the operation instruction D32 when the input information D31 is input, based on the input information D31, the equipment information D33, the environmental information D33a, and other information that can be referred to in the learning model unit 300.

As described above, according to this embodiment, the learning model can generate the operation instruction D32 using also the environmental information D33a about the space in which the target equipment 2 is operating. Therefore, the functionality of work involved in operating the target equipment 2 can be further improved.

### Variation 3-5.

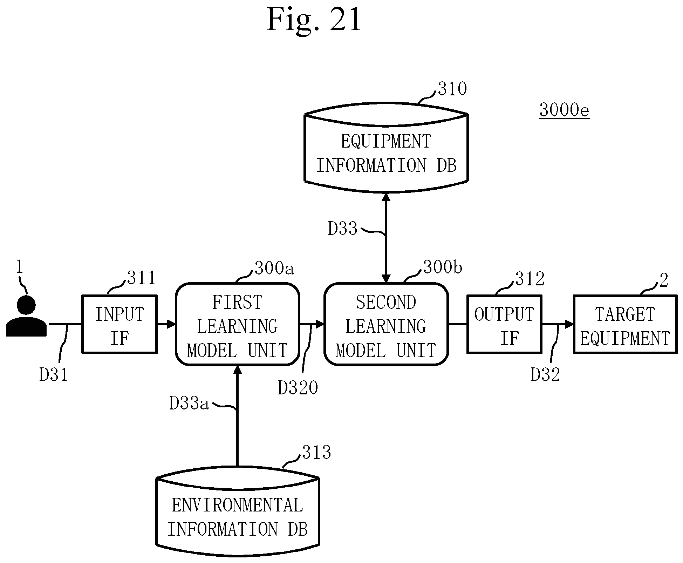

Another variation of the control system 3000 will now be described. In this variation, an operation instruction is generated by combining two learning models. Fig. 21 is a configuration diagram illustrating an example of a control system 3000e, which is a variation of the control system 4000 according to this embodiment. The same elements as those of the control system 3000 are denoted by the same reference signs, and description will be omitted.

The control system 3000e illustrated in Fig. 21 includes a learning model unit 300a as a first learning model unit 300 and a learning model unit 300b as a second learning model unit 300 in place of the learning model unit 300 illustrated in Fig. 20.

When the input information D31 is input, the learning model unit 300a outputs operation information D320. The learning model unit 300a may be a model and its operating environment configured to generate and output the operation information D320 when the input information D31 is input, based at least on the input information D31 and the environmental information D33a.

The operation information D320 includes information about an operation of the target equipment 2 expressed in a predetermined format that can be recognized by the learning model unit 330b at the subsequent stage. The operation information D320 may be information that supplements (including addition, correction, and deletion) the operation content indicated by the input information D31 according to the environmental information D33a. The operation information D320 may be information obtained by changing the operation content or its representation indicated by the input information D31 according to the situation of the space where the target equipment 2 is operated. The learning model unit 300a may be a model that mainly performs grounding on the input information D31.

For example, even if the desired operation is the same, the language expression may differ or the way in which an event is recognized may differ depending on the environment in which the target equipment 2 is operating . For example, the meaning of the operation content in the input information D31 may differ due to factors such as dialects, idiosyncratic phrasing, use of company-specific terms or household-specific terms, and differences in sensitivity to heat/coldness and so on.

The learning model unit 300a serves to absorb such differences in linguistic expressions and/or differences in perception of events and to modify them into more general or specific content, for example. The learning model unit 300a may be a local learning model that obtains output results based on local information from limited databases that can be referred to or the like.

The operation information D320 generated by the learning model unit 300a is input to the learning model unit 300b.

The learning model unit 300b may be basically the same as the learning model unit 300 described above. However, instead of the input information D31, the operation information D320 generated by the learning model unit 300a is input.

When the operation information D320 is input, the learning model unit 300b outputs the operation instruction D32. The learning model unit 300b may be a model and its operating environment configured to generate and output the operation instruction D32 when the operation information D320 is input, based on the operation information D320, the equipment information D33, and other information that can be referred to in the learning model unit 300b. The learning model unit 300b may be a global learning model that obtains output results based on global information, such as information obtained by freely accessing external networks.

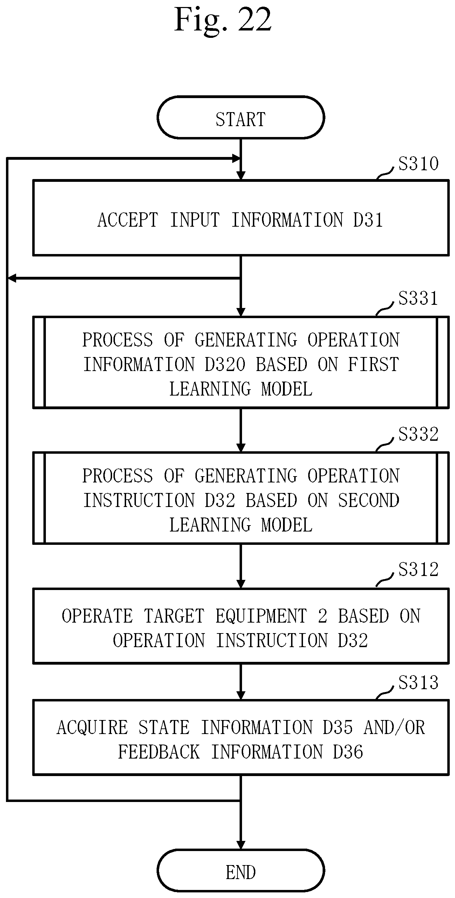

Fig. 22 is a flowchart illustrating an example of the operation of this variation. In the example illustrated in Fig. 22, when the input interface 311 of the control system 3000e accepts the input information D31 in step S310, the input information D31 is input to the learning model unit 300a.

Next, the control system 3000e performs a process of generating the operation information D320 using the learning model unit 300a (step S331). In step S331, the learning model unit 300a (more specifically, the model control unit 101) generates and outputs the operation information D320 corresponding to the input information D31 based on the model information D102, the input information D31 that has been input, and, if necessary, the model reference information D104 including the environmental information D33a. The operation information D320 output from the learning model unit 300a is input to the learning model unit 300b.

Next, the control system 3000e performs a process of generating the operation instruction D32 using the learning model unit 300b (step S332). In step S332, the learning model unit 300b (more specifically, the model control unit 101) generates and outputs the operation instruction D32 corresponding to the operation information D320 based on the model information D102, the operation information D320 that has been input, and, if necessary, the model reference information D104 including the equipment information D33.

The subsequent processing may be substantially the same as that in other control systems according to this embodiment.

As described above, according to this variation, the input information D31 input by the user 1 can be modified to more general or more specific content by absorbing differences in linguistic expressions and/or perception of events, and then the operation instruction D32 can be generated. Therefore, the functionality of work involved in operating the target equipment 2 can be further improved.

Even in the configuration presented in Variation 3-4, the learning model unit 300 can generate the operation instruction D32 by smoothing out differences in linguistic expressions and/or perception of events based on the environmental information D33a, the equipment information D33, the model reference information D104 including a past operation history, and so on. However, according to this variation, the roles of the learning models can be clearly separated, such as absorbing differences in expressions and converting to operation instructions. Therefore, each learning model can be trained in a specialized role, allowing for a compact design due to reduction in the scale of learning and so on.

### Embodiment 4.

Embodiment 4 will now be described. In this embodiment, an example will be described in which a learning model is used to assist work involved in monitoring a certain work situation.

For example, cases will be considered where anomalies in a factory automation (FA) system that includes control equipment such as a robot and a PLC are monitored in a factory. For example, if there is an obvious installation error in the target work of control equipment, the error can be handled by an existing monitoring algorithm based on rules or the like. However, a slight installation error could trigger an anomaly that is discovered in a later process. In such a case, even if analysis or the like is conducted as a result of detecting an anomaly, it is difficult to accurately assess the situation and obtain a solution.

In this embodiment, the efficiency and performance of monitoring work is improved by assisting work involved in monitoring a work environment where cases may occur in which an occurrence situation does not match existing rules and it is difficult to determine the cause, such as a case in which a relatively minor problem spreads and becomes a major anomaly.

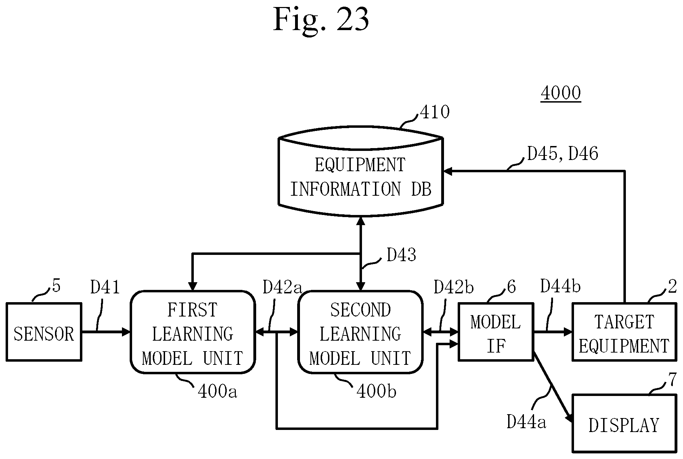

Fig. 23 is a configuration diagram illustrating an example of a control system 4000 according to Embodiment 4. The control system 4000 illustrated in Fig. 23 is a control system for monitoring specific work situations using a learning model, and includes a sensor 5, a learning model unit 400a, a learning model unit 400b, an equipment information storage unit 410 (indicated as an equipment information DB in the diagram), a model interface 6 (indicated as a model IF in the diagram), and the display 7.

The sensor 5 acquires data indicating a situation of the work to be monitored. Data acquired by the sensor 5 will be referred to as sensor data. Sensor data may be, for example, image data obtained by capturing an image of the work to be monitored. Sensor data may be, for example, audio data recorded in the work to be monitored. Sensor data may be, for example, measurement data obtained by measuring a state such as the location of a person or object that performs the work to be monitored.

It is assumed that sensor data is constantly acquired by the sensor 5. However, sensor data may be acquired based on a trigger provided by a person or another monitoring system, for example. The sensor data acquired by the sensor 5 is input to the learning model unit 400a as input information D41. The sensor data itself that is used as the input information D41 may be provided by a person or another monitoring system. In such cases, the sensor 5 may be omitted.

When the input information D41 is input, the learning model unit 400a outputs an analysis result D42a. For example, when the input information D41 is input, the learning model unit 400a outputs the analysis result D42a based on the model information D102. The configuration of the learning model unit 400a may be basically the same as that of the learning model unit 100 in Embodiment 1.

In this embodiment, the learning model unit 400a is a model and its operating environment configured to output the analysis result D42a corresponding to the input information D41 when the input information D41 is input. The learning model unit 400a may be a model and its operating environment configured to generate and output the analysis result D42a when the input information D41 is input, based on the input information D41, equipment information D43, and other information that can be referred to in the learning model unit 400a (the model reference information D104, etc.). The learning model unit 400a may refer to and use information about the work to be monitored as the model reference information D104. The information about the work to be monitored may be, for example, information indicating a location, a person, an object, a procedure, conditions, and so on for performing the work. For example, the learning model unit 400a may use, as the model reference information D104, a digitalized version of a manual that describes the conditions, installation environment, operation procedure, and so on of equipment used in the work.

In this embodiment, the input information D41 includes information indicating a situation of the work to be monitored. The work to be monitored includes one or more tasks performed by a person or equipment. The input information D41 may be, for example, a measurement value, an image, voice, or a combination of these indicating a situation of the work to be monitored. The input information D41 may be, for example, measurement values, images, voice, or combinations of these indicating situations of a plurality of pieces of work to be monitored. The input information D41 may include information indicating situations of work to be performed continuously over time, and in that case, may be time-series data in a predetermined data structure that includes measurement values, images, voice, or combinations of these indicating the above situations. It is assumed that a work situation is indicated in a way that conforms with the input format of a model used by the learning model unit 400a. However, this does not apply in cases such as those where error handling, correction processing, or conversion processing is included in the stage preceding the learning model unit 400a.

The analysis result D42a includes information indicating a situation analysis result obtained by analyzing a work situation indicated by the input information D41. The information indicating the situation analysis result may be information indicating objects (environment) present and/or events occurring in the work situation indicated by the input information D41. The information indicating the situation analysis result can be considered to be information indicating an interpretation of the work situation indicated by the input information D41. The analysis result D42a may be, for example, text indicating an interpretation of the work situation indicated by the input information D41. The analysis result D42a may be, for example, text indicating an interpretation of a part that is different from the normal situation and is noticed in the work situation indicated by the input information D41. The analysis result D42a may be in a format other than text. The format of the analysis result D42a is not particularly limited, provided that it is written in a predetermined format that can be interpreted by the learning model unit 400b at the subsequent stage, and may be text, an image, voice, or a combination of these.

Examples of an interpretation of a work situation include expressing objects present in the work situation using their attributes, expressing events that have occurred in the work situation using a predetermined syntax form such as 5W1H or 7W1H, and expressing the work situation in a specific manner and further summarizing it. Other examples include breaking down the work being performed in the work situation into a plurality of perspectives and interpreting and expressing the work from each perspective, and in a case where the work being performed in the work situation includes a plurality of subtasks or steps, breaking down the target work into subtask units or step units and describing each subtask or step. The analysis result D42a can be considered to be a result obtained by performing concretization, subdivision, and/or extraction of singular points on and/or from the work situation indicated by the input information D11, and further expressing those in a predetermined format. As described above, the analysis result D42a expresses the work situation in an easy-to-understand and organized manner.

When the analysis result D42a is input, the learning model unit 400b outputs an analysis result D42b. For example, when the analysis result D42a is input, the learning model unit 400b outputs the analysis result D42b based on the model information D102. The configuration of the learning model unit 400b may be basically the same as that of the learning model unit 100 in Embodiment 1.

In this embodiment, the learning model unit 400b is a model and its operating environment configured to output the analysis result D42b corresponding to the analysis result D42a when the analysis result D42a is input. The learning model unit 400b may be, for example, a model and its operating environment configured to generate and output the analysis result D42b when the analysis result D42a is input, based on the analysis result D42a, the equipment information D43, and/or information that can be referred to in the learning model unit (the model reference information D104, etc.).

The analysis result D42b includes information indicating a method for improving the work situation derived from the analysis result of the work situation by the learning model unit 400a. The information indicating the method for improving the work situation may be information indicating a recovery method for restoring an anormal state to normal, or may be information indicating a solution for a problem that has occurred in the environment where the work to be monitored is being performed (work environment), such as a person is in trouble or equipment has stopped.

The information indicating an improvement method may be, for example, text, an image, or voice indicating the method, or may be a control instruction (e.g., a command, a control signal, control code, etc.) for the equipment (target equipment 2) on which the method is to be performed, a procedure manual, a sequence diagram, source code, or executable code describing the method, or a controller command for causing a controller to execute the method. The information indicating an improvement method may be text, an image, voice, data written in a predetermined design language, a control description (including source code and information written in a predetermined programming platform language), information written in other platform languages, a control instruction (including a control command, a control signal, control code, and a controller command), executable code, each indicating the method, or a combination of two or more of these. The predetermined design language may be, for example, Unified Modeling Language (UML), but is not limited to this.

In the following, the learning model unit 400a may be referred to as a first learning model unit 400, and the analysis result D42a may be referred to as a first analysis result D42. The learning model unit 400b may be referred to as a second learning model unit 400, and the analysis result D42b may be referred to as a second analysis result D42.

As already described, the analysis result D42a includes information indicating the situation analysis result of the work situation indicated by the input information D41. Therefore, the learning model unit 400b may be a model and its operating environment configured to output the analysis result D42b corresponding to the situation analysis result indicated by the analysis result D42a. When the information indicating the situation analysis result is text describing the work situation indicated by the input information D41, the learning model unit 400b may be a model and its operating environment configured to output the analysis result D42b corresponding to the text describing the work situation.

The equipment information storage unit 410 and the equipment information D43 are handled in basically the same way as the equipment information storage unit 110 and the equipment information D13 in Embodiment 1. In this embodiment, the equipment information storage unit 410 stores the equipment information D43, which is information about equipment related to the work to be monitored as the target equipment 2. The equipment related to the work broadly include equipment required for analysis of the situation and derivation of an improvement method described above. More specifically, not only equipment used in the work but also equipment that affects the person or equipment performing the work is included. More specifically, the equipment that affects the person or equipment performing the work may be equipment that directly or indirectly causes changes in the person or equipment performing the work. Examples include equipment directly used in the work (including various machines such as a processing machine and a conveyer, workbenches, and tools), equipment that controls the equipment directly used in the work (a power supply, a relay, a switch, a controller, etc.), and equipment that causes changes in the work environment (lighting equipment, an air conditioner, a vacuum cleaner, a purifier, etc.).

The equipment information D43 is used, for example, as additional information when the learning model unit 400a and/or the learning model unit 400b outputs the model output data D103 (the analysis result D42a, the analysis result D42b). In the following, in this embodiment, information indicating the state of the target equipment 2 in particular may be referred to as state information D45.

In this embodiment, the learning model unit 400a may be an image learning model such as a VLM to which an image is input to obtain an output result and its operating environment. The learning model unit 400a may be, for example, a multimodal model to which natural language and an image are input to obtain an output result and its operating environment. The learning model unit 400b may be, for example, a language learning model such as an LLM to which natural language is input to obtain an output result and its operating environment. In this case, the input information D41 may be input as text data, image data, a combination of text data and image data, or in a data format that can be converted into these (voice data, video that is a combination of voice data and image data, etc.). The learning model used in this embodiment is not limited to the models described above.

The model interface 6 is an interface that accepts model output data (the analysis result D42a and the analysis result D42b) from the learning model unit 400a and the learning model unit 400b and outputs the model output data to a predetermined output destination. The model interface 6 may be, for example, an interface that converts the model output data output from the learning model unit 400a and the learning model unit 400b into data that conforms to a predetermined output destination and outputs the data. The model interface 6 may be provided as an example of the output unit 103 described above, for example. In this embodiment, the output destinations of the model interface 6 include the target equipment 2 and the display 7.

The model interface 6 may, for example, output result information D44a indicating the situation analysis result included in the analysis result D42a and the improvement method included in the analysis result D42b to the display 7, and also output result information D44b indicating the improvement method included in the analysis result D42b to the target equipment 2. At this time, the model interface 6 may extract some data from the analysis result D42a and/or the analysis result D42b, convert the data into a data format that conforms to the output destination, and then output the data as the result information D44a and the result information D44b.

In the example illustrated in Fig. 23, the target equipment 2 and the display 7 are depicted as the output destinations of the model interface 6, but the output destinations of the model output data are not limited to these. For example, if the method for improving the situation indicated by the model output data to be output includes information indicating control on the target equipment 2, the model interface 6 can output the model output data or information indicating the method directly to the target equipment 2 on which the method is to be implemented, and can also output the model output data or information indicating the method to a conversion device (not illustrated) that performs conversion into information that can be accepted by the target equipment 2, for example. The conversion device may be, for example, the control system 1000 of Embodiment 1 that converts input information into a control description or executable code that can be recognized by the target equipment 2.

The model interface 6 itself may have the function of a conversion device. For example, the model interface 6 may have functions of not only controlling output of model output data, but also of converting the improvement method output by the learning model unit 400b into code that can be executed by an interpreter, and outputting the converted code or controlling equipment based on the code. The model interface 6 may have a function of controlling a processing flow, such as if the improvement method includes a process that is highly urgent, immediately executing the process. The model interface 6 may have a function of transmitting a prompt input via the display 7, such as a response to a proposed method displayed on the display 7, to the learning model unit 400b.

The model interface 6 may have the functions of the output checking unit 202 and the correction checking unit 203 described above. For example, the model interface 6 may determine an urgency level of the analyzed situation. If it is determined that the urgency level is not high, the model interface 6 may confirm the appropriateness of the improvement method by making an inquiry to a supervisor or using a simulator or the like, and if the improvement method is not appropriate, may communicate this to the learning model unit 400b to prompt output of another improvement method. In that case, the model interface 6 may issue supplementary information D48 for the model input data of the target learning model unit.

In this embodiment, the input information D41 corresponds to the model input data D101 of the learning model unit 400a. The analysis result D42a corresponds to the model output data D103 of the learning model unit 400a. The analysis result D42a corresponds to the model input data D101 of the learning model unit 400b. The analysis result D42b corresponds to the model output data D103 of the learning model unit 400b. The learning model unit 400a (particularly, the model control unit 101) may be configured to, for example, accept the input information D41 and then output the analysis result D42a corresponding to the input information D41 based on the model information D102 and, if necessary, the model reference information D104. The learning model unit 400b (particularly, the model control unit 101) may be configured to, for example, accept the analysis result D42a and then output the analysis result D42b corresponding to the analysis result D42a based on the model information D102 and, if necessary, the model reference information D104.

In such cases, the model generation unit 107 provided corresponding to the learning model unit 400a may, for example, perform machine learning using the model learning data D105 including candidates for the input information D41 that may be input to the model control unit 101, so as to generate or update the model information D102, or may perform machine learning using the model learning data D105 including candidates for the input information D41 that may be input to the model control unit 101 and corresponding candidates for the analysis result D42a, so as to generate or update the model information D102. The model generation unit 107 provided corresponding to the learning model unit 400b may, for example, perform machine learning using the model learning data D105 including candidates for the analysis result D42a that may be input to the model control unit 101, so as to generate or update the model information D102, or may perform machine learning using the model learning data D105 including candidates for the analysis result D42a that may be input to the model control unit 101 and corresponding candidates for the analysis result D42b, so as to generate or update the model information D102.

Although not illustrated, also in this embodiment, the state information D45 and/or feedback information D46 may be acquired from the output destination of the model output data D103 of the learning model unit 400a and the learning model unit 400b and/or information generated based on the model output data D103. The control system 4000 may, for example, output the acquired state information D45 and/or feedback information D46 as information indicating a control result to the user, the learning model unit 400a, the learning model unit 400b, or another device not illustrated. The control system 4000 may be configured to return an inquiry D47 to the user when the input information D41 includes unclear or uncertain information. The control system 4000 can generate supplementary information D48 for input/output data of the learning model unit 400a and the learning model unit 400b based on the acquired state information D45 and/or feedback information D46, and issue the supplementary information D48 to the user, the learning model unit 400a, the learning model unit 400b, or another device not illustrated. The state information D45, the feedback information D46, the inquiry D47, and the supplementary information D48 may be handled in basically the same way as in Embodiment 1. Information may be output to the user via, for example, the display 7 or an input/output interface (not illustrated) included in the information processing device 10.

The control system 4000 may further include a state acquisition unit 430 (not illustrated) that acquires the state information D45 and/or the feedback information D46 and issues the supplementary information D48 as necessary. The state acquisition unit 430 is substantially the same as the state acquisition unit 130 in Embodiment 1.

Also in this embodiment, the target equipment 2 is not particularly limited. It is assumed that the target equipment 2 is equipment that receives the analysis result D42b and can actually perform control. However, this does not apply if the conversion device described above is provided for the target equipment 2.

In this embodiment, the input information D41 accepted by the control system 4000 can be considered to be information about a situation in a work environment (situation in the environment where monitoring work is performed). Therefore, the input information D41 accepted by the control system 4000 can be considered to be an example of the first information indicating a situation in a work environment. The analysis result D42a and the analysis result D42b can be considered to be information used for the work (monitoring work) in response to such input information D41. In the following, the analysis result D42a and/or the analysis result D42b output to a predetermined output destination from the operating environment of the learning model to which model input data based on the input information D41 is input may be referred to as the second information.

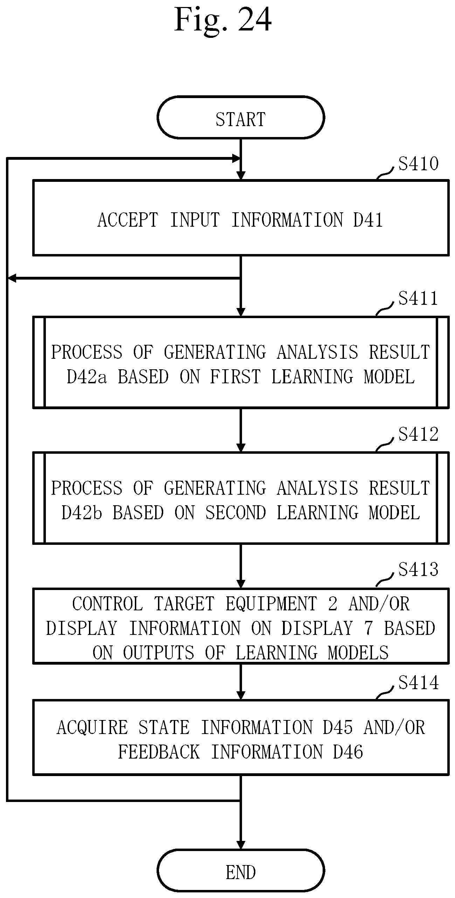

The operation of the control system 4000 of this embodiment will now be described. Fig. 24 is a flowchart illustrating an example of the operation of the control system 4000.

In the example illustrated in Fig. 24, the control system 4000 first accepts the input information D41 (step S410). For example, the input unit 102 or the input processing unit 201 described above may accept the input information D41. The accepted input information D41 is input to the learning model unit 400a as the model input data D101.

Next, the control system 4000 performs a process of generating the analysis result D42a using the learning model unit 400a (step S411). In step S411, the learning model unit 400a (more specifically, the model control unit 101) outputs the analysis result D42a corresponding to the input information D41 based on the model information D102, the input information D41 that has been input, and, if necessary, the model reference information D104 including the equipment information D43. The learning model unit 400a may generate the analysis result D42a of text data from the input information D41 that has been input, using a learning model that can generate text data.

In step S411, the preprocessing unit 105 and/or the post-processing unit 106 of the learning model unit 400a may further perform the process described above.

The analysis result D42a output from the learning model unit 400a is input to the learning model unit 400b. The analysis result D42a output from the learning model unit 400a is input to the learning model unit 400b and the model interface 6. The analysis result D42a output from the learning model unit 400a may be input to the model interface 6 via the learning model unit 400b. In this case, the learning model unit 400b may output the model output data D103 including the analysis result D42a and the analysis result D42b.

Next, the control system 4000 performs a process of generating the analysis result D42b using the learning model unit 400b (step S412). In step S412, the learning model unit 400b (more specifically, the model control unit 101) outputs the analysis result D42b corresponding to the analysis result D42a based on the model information D102, the analysis result D42a that has been input, and, if necessary, the model reference information D104 including the equipment information D43. The learning model unit 400b may, for example, generate the analysis result D42b of binary data from the analysis result D42a that has been input, using a learning model that can generate text data. The learning model unit 400b may, for example, generate the analysis result D42b of text data and binary data from the analysis result D42a that has been input, using a learning model that can generate text data and binary data.

In step S412, the preprocessing unit 105 and/or the post-processing unit 106 of the learning model unit 400b may further perform the process described above.

The analysis result D42b output from the learning model unit 400b is input, for example, to the model interface 6.

The model interface 6 controls the target equipment 2 and/or causes information to be displayed on the display 7 based on the analysis results by the learning model unit 400a and the learning model unit 400b (step S413). In step S413, for example, the model interface 6 outputs information based on the analysis result D42a and the analysis result D42b to a predetermined output destination. For example, the model interface 6 outputs the result information D44a indicating a situation analysis result and an improvement method to the display 7 based on the analysis result D42a and the analysis result D42b, and also outputs the result information D44b indicating the improvement method based on the analysis result D42b to the target equipment 2.

The result information D44a may be, for example, text and voice that indicate a situation that has occurred in the work environment and an improvement method. The result information D44b may be, for example, text or a control signal that indicates an improvement method.

As a result, the display 7 displays the situation analysis result indicated by the analysis result D42a and the improvement method indicated by the analysis result D42b based on the result information D44a, and the target equipment 2 implements the improvement method indicated by the analysis result D42b based on the result information D44b. Information may be input to the display 7 and the target equipment 2 directly from the control system 4000 (more specifically, the model interface 6), or may be input indirectly via a communication network or other equipment (a server, various conversion devices, etc.) or manually.

If the state of the target equipment 2 changes due to the target equipment 2 being controlled or there is feedback from the output destination, the control system 4000 may acquire the state information D45 and the feedback information D46 (step S414). The processing in step S414 is not essential and can be omitted as appropriate.

The control system 4000 may repeat the processing in step S410 to step S414 multiple times (e.g., until the desired state is achieved in the target work environment).

As described above, according to this embodiment, assessment of the situation and acquisition of an improvement method are performed in two stages using different learning models, so that the accuracy of the final product can be improved. As a result, the efficiency of work involved in monitoring the work situation can be improved.

For example, when assessing the situation, it is important to widely detect anormal states in the work environment, such as "something unusual has happened". On the other hand, when acquiring an improvement method, specific information is important, such as "stop this machine, move the work position to point A, restore the state of the machine to state B, and then reactivate it".

In such a case where pieces of information to be extracted, that is, pieces of targeted information have different levels of abstraction, there is a concern that the accuracy of output results will decrease if one learning model is used to learn and extract these pieces of information together. In particular, when acquiring an improvement method, it is necessary to present a specific method based on the knowledge and information of the work environment. In such a case, by separating the learning models and providing appropriate domain knowledge (environmental information), the output accuracy can be improved more reliably.

If an attempt is made to obtain solutions for different tasks of assessing the situation and acquiring an improvement method using a single learning model, the problem of hallucination may become pronounced. This is because a function of adjusting a solution to one task (assessing the situation) so that a solution to the other task (acquiring an improvement method) appears plausible may work implicitly within the algorithm of the model. This embodiment is also effective for the problem of hallucination. That is, by separating the learning models to address the two tasks of assessing the situation and acquiring an improvement method, modals inserted into each learning model can be reduced. As a result, the magnitude of hallucination can be reduced, and thus the accuracy of the final product can be improved.

Furthermore, in this embodiment, the analysis result D42a and the analysis result D42b, which are output results of the learning model unit 400a and the learning model unit 400b, can be put into text and displayed on the display 7. Therefore, a person can check the content, and thus it is possible to reduce hallucination and more reliably realize a method for improving the situation.

The control system 4000 of this embodiment can be applied not only to monitoring of a control system for equipment in a factory as described above, but also to monitoring of distribution objects in a distribution system, for example.

### Variation 4-1.

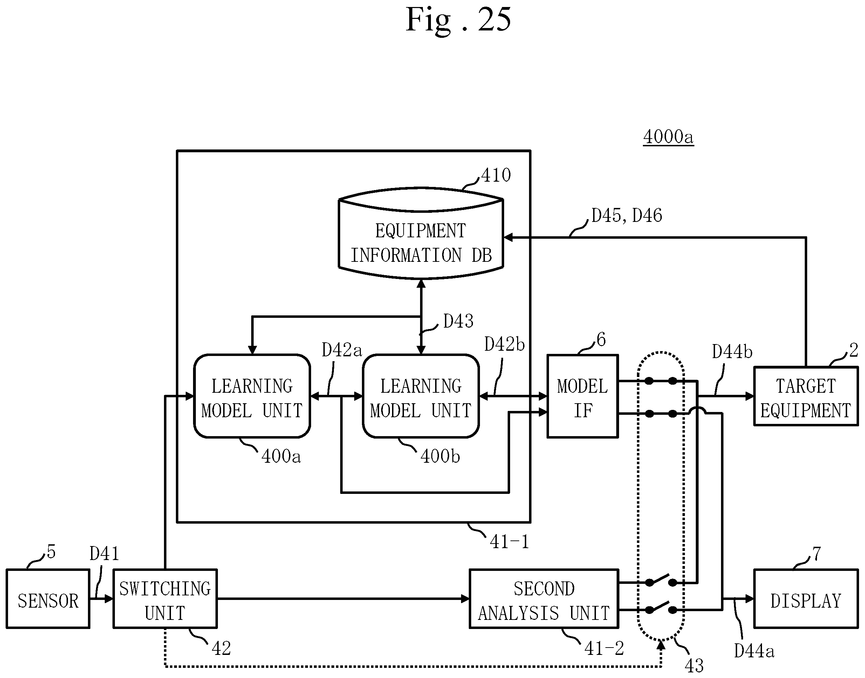

A variation of the control system 4000 will now be described. Fig. 25 is a configuration diagram illustrating an example of a control system 4000a, which is a variation of the control system 4000 according to this embodiment. The same elements as those of the control system 4000 are denoted by the same reference signs, and description will be omitted.

The control system 4000a illustrated in Fig. 25 differs from the control system 4000 in that two types of analysis means that analyze and improve the situation using different methods are included, and the analysis means to be used is switched as appropriate depending on a situation that has occurred.

The control system 4000a illustrated in Fig. 25 includes, as a first analysis unit 41-1, a part that uses the learning model unit 400a and the learning model unit 400b described above to analyze a situation and acquire an improvement method, and further includes a second analysis unit 41-2, a switching unit 42, and an output switching switch 43.

The second analysis unit 41-2 may be any means that analyzes a situation and acquires an improvement method in response to the input information D4, using a method different from the method used by the first analysis unit 41-1. As an example, the second analysis unit 41-2 may be rule-based means for analyzing a situation and acquiring an improvement method. For example, when the input information D41 is input, the second analysis unit 41-2 may determine whether the input information D41 matches any of predetermined anomaly patterns. If the input information D41 matches any of the anomaly patterns, the second analysis unit 41-2 may acquire an improvement method corresponding to the anomaly pattern. The second analysis unit 41-2 outputs an analysis result D42c that includes at least a method for improving the situation.

The analysis result D42c may include, for example, information equivalent to the result information D44a described above and information equivalent to the result information D44b. In this variation, the analysis result D42c includes at least the result information D44b indicating an improvement method obtained by the second analysis unit 41-2.

In this variation, the second the analysis unit 41-2 may be realized as an internal execution module by being implemented in, for example, a PLC, an information processing device, or the like placed in the work environment.

The switching unit 42 is means for switching the control destination for the input information D41 according to a predetermined condition. In this variation, the switching unit 42 switches the control destination for the input information D41 between the first analysis unit 41-1 and the second analysis unit 41-2. The switching unit 42 may switch the control destination for the input information D41 depending on whether the input information D41 conforms with an existing rule, for example. In this case, the switching unit 42 may switch the output destination by switching the output destination of the input information D41 to the second analysis unit 41-2 if the input information D41 conforms with the existing rule, and switching the output destination of the input information D41 to the first analysis unit 41-1 if the input information D41 does not conform with the existing rule.

The switching unit 42 may switch the control destination for the input information D41 in accordance with an instruction from a supervisor, for example. The switching unit 42 may switch the control destination for the input information D41 depending on, for example, time, work content, or the presence or absence of a supervisor. The switching unit 42 may switch the control destination for the input information D41 depending on, for example, whether or not an anomaly has occurred in the work environment. Whether or not an anomaly has occurred in the work environment may be determined depending on, for example, whether or not an anomaly signal has been generated. For example, in the event of an anomaly, the switching unit 42 may switch the control destination for the input information D41 to the first analysis unit 41-1. The switching unit 42 may switch the control destination for the input information D41 based on, for example, the severity or urgency of an anomaly occurring in the work environment.

Along with switching of the control destination for the input information D41, the switching unit 42 may control the output switching switch 43 that switches connection paths (such as circuits or communication paths) that connect the output of the first analysis unit 41-1 or the output of the second analysis unit 41-2 with the target equipment 2 and the display 7, which are the output destinations of analysis results.

For example, when the control destination for the input information D41 is switched to the first analysis unit 41-1, the switching unit 42 may control the output switching switch 43 to turn on the connection paths connecting the output of the first analysis unit 41-1 with the target equipment 2 and the display 7, and turn off the connection paths connecting the output of the second analysis unit 41-2 with the target equipment 2 and the display 7. Similarly, for example, when the control destination for the input information D41 is switched to the second analysis unit 41-2, the switching unit 42 may control the output switching switch 43 to turn on the connection paths connecting the output of the second analysis unit 41-2 with the target equipment 2 and the display 7, and turn off the connection paths connecting the output of the first analysis unit 41-1 with the target equipment 2 and the display 7.

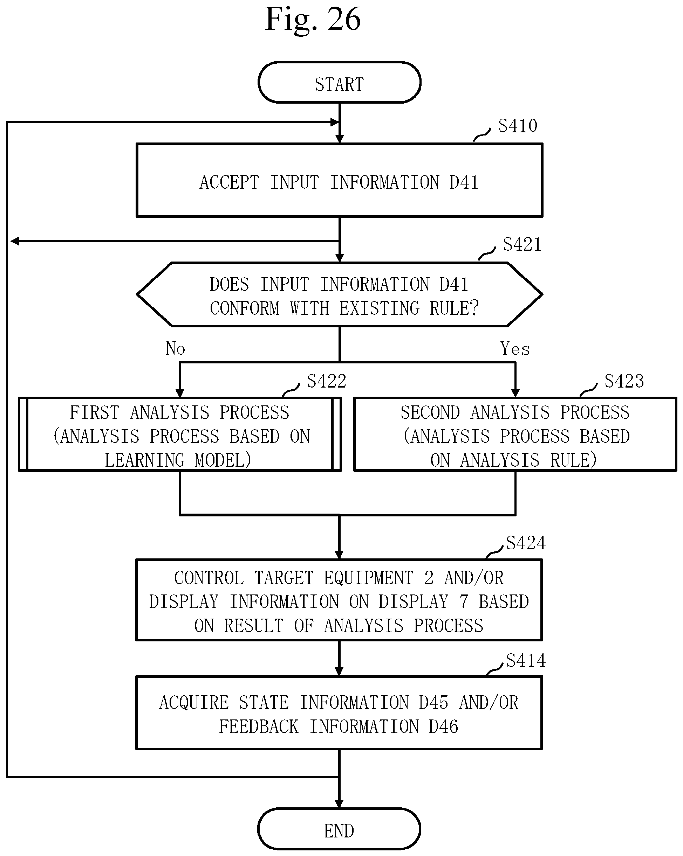

Fig. 26 is a flowchart illustrating an example of the operation of this variation. In the example illustrated in Fig. 26, when the control system 4000a accepts the input information D41 in step S410, the switching unit 42 switches the control destination for the input information D41 in accordance with a predetermined condition (step S421). In the example illustrated in Fig. 26, the switching unit 42 determines whether the input information D41 complies with an existing rule, and if it is determined that the input information D41 does not comply with the existing rule (No in step S421), proceeds to a first analysis process (step S422). If it is determined that the input information D41 complies with the existing rule (Yes in step S421), it proceeds to a second analysis process (step S423).

In the first analysis process in step S422, the learning model unit 400a and the learning model unit 400b, which serve as the first analysis unit 41-1, analyze the situation and acquire an improvement method. The learning model unit 400a and the learning model unit 400b output, as results of the first analysis process, the analysis result D42a including an analysis result of the situation and the analysis result D42b including a method for improving the situation.

In the second analysis process in step S423, the second analysis unit 41-2 analyzes the situation and acquires an improvement method in accordance with an existing rule. The second analysis unit 41-2 outputs, as a result of the first analysis process, the analysis result D42c including at least a method for improving the situation, for example.

When the result of the analysis process by the first analysis unit 41-1 or the second analysis unit 41-2 is output, the target equipment 2 is controlled and/or information is displayed on the display 7 based on the result of one of the analysis processes, depending on the state of the output switching switch 43 (step S424).

In this example, when the first analysis unit 41-1 performs the analysis process, the connection paths connecting the output of the first analysis unit 41-1 with the target equipment 2 and the display 7 are turned on. In this case, the model interface 6 may output the result information D44a indicating the situation analysis result and the improvement method to the display 7 based on the analysis result D42a and the analysis result D42b, and output the result information D44b indicating the improvement method based on the analysis result D42b to the target equipment 2, for example. When the second analysis unit 41-2 performs the analysis process, the connection paths connecting the output of the second analysis unit 41-2 with the target equipment 2 and the display 7 are turned on. In this case, based on the analysis result D42c output from the second analysis unit 41-2, the result information D44a indicating the situation analysis result and the improvement method may be output to the display 7, and/or the result information D44b indicating the improvement method may be output to the target equipment 2.

The display 7 may display the result information D44b in a manner that allows checking by an operator, for example. In this case, the operator may refer to the result information D44b displayed on the display 7, check the improvement method indicated by the result information D44b, and carry out work according to that method. The operator may check the improvement method indicated by the result information D44b and determine its appropriateness. At this time, if the improvement method indicated by the result information D44b is not appropriate, the operator may prompt the learning model unit 400b to acquire a different improvement method (re-acquire model output data). For example, upon receiving information requesting the re-acquisition of model output data, the learning model unit 400b may change part of the input information, part of the model parameters, or the reference destination of the reference information, and then re-acquire model output data.

The subsequent processing may be substantially the same as that in other control systems according to this embodiment.

As described above, this variation is configured to have a plurality of analysis units that analyze the situation and acquire improvement methods using different methods, and to switch between them depending on the situation. This allows for control that is more suited to the situation. For example, for a problem whose cause is clear, the second analysis unit with a high processing load can instantly analyze the situation and present and implement an improvement method, while for a problem whose cause is unclear, the first analysis unit using a learning model can analyze the complex situation and present and implement a better improvement method.

In the above example, the first analysis unit 41-1 uses two learning models to analyze the situation and acquire an improvement method, but the configuration of the first analysis unit 41-1 is not limited to the above example. For example, if it is not necessary to analyze the situation, the learning model unit 400a can be omitted. If it is not necessary to acquire an improvement method, the learning model unit 400b can be omitted. It is also possible to analyze the situation and acquire an improvement method using one learning model unit.

For example, when the first analysis unit 41-1 includes the learning model unit 400b that acquires a method for improving the situation based on the input information D41, the switching unit 42 may switch the control destination for the input information D41 to the first analysis unit 41-1 in the event of an anomaly. In that case, the learning model unit 400b of the first analysis unit 41-1 may be configured to, when the input information D41 is input, output information indicating an improvement method corresponding to the occurrence situation of the anomaly indicated by the input information D41. At this time, the learning model unit 400b may refer to the equipment information storage unit 410 that the control system can access, and output information indicating an improvement method corresponding to the situation.

### Embodiment 5.

Embodiment 5 will now be described. In this embodiment, an example will be described in which a learning model is used to assist response work of returning a response to information transmitted by a user in a call center, a product site, or the like. The information transmitted by the user may include inquiries and opinions about a certain service, information, event, or object.

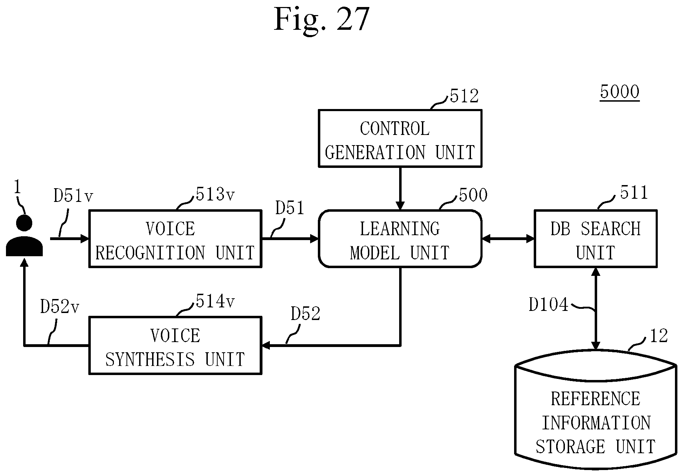

Fig. 27 is a configuration diagram illustrating an example of a control system 5000 according to Embodiment 5. The control system 5000 illustrated in Fig. 27 includes a learning model unit 500, the reference information storage unit 12, a database search unit 511 (indicated as a DB search unit in the diagram), a control generation unit 512, a voice recognition unit 513v, and a voice synthesis unit 514v. The reference information storage unit 12, the database search unit 511, and the control generation unit 512 may be provided as part of the learning model unit 500.

When input information D51 is input, the learning model unit 500 outputs response information D52 indicating response content. For example, when the input information D51 is input, the learning model unit 500 outputs the response information D52 based on the model information D102. The configuration of the learning model unit 500 may be basically the same as that of the learning model unit 100 in Embodiment 1.

In this embodiment, the learning model unit 500 is a model and its operating environment configured to output the response information D52 corresponding to the input information D51 when the input information D51 is input. The learning model unit 500 may be a model and its operating environment configured to generate and output the response information D52 when the input information D51 is input, based on the input information D51 and other information that can be referred to in the learning model unit 500.

In this embodiment, the input information D51 includes information indicating content transmitted from the user 1 or the like. The input information D51 may include information indicating content that requires a response in the work environment. The input information D51 may be, for example, text, an image, voice, or a combination of these indicating an inquiry or an opinion about a certain service, information, event, or object. The input information D51 may be, for example, a text, an image, voice, or a combination of these indicating a plurality of inquiries or opinions about a certain service, information, event, or object. The input information D51 may include information indicating transmitted content that is continuous over time, and in that case, may be time-series data in a predetermined data structure that includes text, images, voice, or a combination of these indicating the above transmitted content. It is assumed that transmitted content is indicated in a way that conforms with the input format of a model used by the learning model unit 500. However, this does not apply in cases such as those where error handling, correction processing, or conversion processing is included in the stage preceding the learning model unit 500.

The response information D52 includes information indicating a response to the transmitted content included in the input information D51. The response information D52 may be, for example, information indicating a response to an inquiry or opinion about a service, information, event, or object indicated by the transmitted content included in the input information D51.

The reference information storage unit 12 stores the model reference information D104 that the model control unit 101 of the learning model unit 500 refers to in order to output the response information D52. The model reference information D104 may include, for example, information about services, information, events, or objects that may be included in the input information D51. The reference information storage unit 12 may particularly store information about a specific service, information, event, or object as the model reference information D104. The model reference information D104 may include, for example, a digitized response manual. The model reference information D104 may include, for example, a history of the input information D51 input in the past or transmitted content included in it. In this case, the reference information storage unit 12 may store, as the model reference information D104, information about the user 1 who is the originator (e.g., a user identifier, user attribute information, etc.) and also history information indicating the input information D51 input in the past or the transmitted content contained in it. In the following, in this embodiment, information indicating in particular the state of the user 1 who is the originator may be referred to as state information D55.

The database search unit 511 is a search engine for the reference information storage unit 12 and other databases. In response to a request from the model control unit 101 of the learning model unit 500, the database search unit 511 searches databases to which the database search unit 511 is connected and allowed access, and outputs a search result. At that time, the databases that the database search unit 511 can access may be limited.

The control generation unit 512 is an interface for setting preconditions under which the learning model unit 500 (particularly, the model control unit 101) generates model output data. The control generation unit 512 may be, for example, an interface used to recognize control target information for the learning model unit 500 and/or to set an output mode. The control target information is information indicating the target of control in the model control unit 101. The model control unit 101 may be configured to generate the model output data D103 from the model input data D101 based on the control target information indicated by the control generation unit 512, for example. The control generation unit 512 may be configured, for example, to cause part of model input data that is input by the user to be recognized as the control target information, cause information generated by the model control unit 101 to be recognized as the control target information, or cause information generated by the model control unit 101 and corrected by another control unit to be recognized as the control target information. The control target information and/or output mode setting may be specified by the user, may be specified by an external processing unit, or may be specified by the control generation unit 512 according to a predetermined algorithm.

When an input from the user 1 includes input information D51v in voice format, the voice recognition unit 513v recognizes the voice indicated by the input information D51v, converts it into a format that matches the data format of the learning model unit 500, and outputs it. The voice recognition unit 513v may convert the input information D51v in voice format into the input information D51 in text format, for example. The voice recognition unit 513v has functions of accepting the input information D51v input from the user 1 who is the originator and inputting it as the input information D51 to the learning model unit 500, and thus can be considered to be an example of the input interface 311 described above.

The voice synthesis unit 514v converts the content indicated by the response information D52 into voice format and outputs it. For example, when the response information D52 output from the learning model unit 500 includes a data format other than voice, the voice synthesis unit 514v converts the content of the part indicated by the response information D52 into voice format and outputs it. For example, when the response information D52 has a data structure that includes a data format specification, the voice synthesis unit 514v may convert a data element for which the voice format is specified in the specification into voice format and output it. The voice synthesis unit 514v may convert, for example, the response information D52 in text format into response information D52v in voice format. The voice synthesis unit 514v accepts the response information D52 generated by the learning model unit 500 and outputs it as the response information D52v to the user 1 who is the originator, and thus can be considered to be an example of the output interface 312 described above.

In the above examples, data in voice format is input from and output to the user 1, but the data format used for input and output from and to the user 1 is not limited to the voice format. In this case, instead of the voice recognition unit 513v and the voice synthesis unit 514v, a processing unit may be provided that converts a data format used for input from the user 1 into a data format used for input to the learning model unit 500, and a processing unit may be provided that converts a data format used for output from the learning model unit 500 into a data format used for input to the user 1.

If the learning model unit 500 can accept the data format used for input from the user 1, the voice recognition unit 513v can be omitted. If the user 1 can accept the data format used for output from the learning model unit 500, the voice synthesis unit 514v can be omitted.

In a configuration where the voice recognition unit 513v can be omitted, input information that is input from the user 1 who is the originator is accepted and is directly input to the learning model unit 500. Therefore, it can be considered that the input interface 311 described above can be provided in place of the voice recognition unit 513v. Similarly, in a configuration where the voice synthesis unit 514v can be omitted, response information generated by the learning model unit 500 is accepted and is directly output to the user 1 who is the originator. Therefore, it can be considered that the output interface 312 described above is provided in place of the voice synthesis unit 514v.

In this embodiment, the input information D51 corresponds to the model input data D101. The response information D52 corresponds to the model output data D103. For example, the learning model unit 500 (particularly, the model control unit 101) may be configured to accept the input information D51, and then output the response information D52 corresponding to the input information D51 based on the model information D102 and, if necessary, the model reference information D104.

In such a case, the model generation unit 107 provided corresponding to the learning model unit 500 may, for example, perform machine learning using the model learning data D105 including candidates for the input information D51 that may be input to the model control unit 101, so as to generate or update the model information D102. The model generation unit 107 may, for example, perform machine learning using the model learning data D105 including candidates for the input information D21 that may be input to the model control unit 101 and corresponding candidates for the response information D52, so as to generate or update the model information D102.

Although not illustrated, also in this embodiment, the state information D55 and/or feedback information D56 may be acquired from the output destination of the model output data D103 of the learning model unit 500 and/or information generated based on the model output data D103. The control system 5000 may, for example, output the acquired state information D55 and/or feedback information D56 as information indicating a response result to a predetermined supervisor, the learning model unit 500, or another device not illustrated. The control system 5000 may be configured to return an inquiry D57 to the user 1 if the input information D51 includes unclear or uncertain information. Based on the acquired state information D55 and/or feedback information D56, the control system 5000 can generate supplementary information D58 for input/output data of the learning model unit 500 and issue the supplementary information D58 to the user 1, a predetermined supervisor, the learning model unit 500, or another device not illustrated. The state information D55, the feedback information D56, the inquiry D57, and the supplementary information D58 may be handled basically in the same way as in Embodiment 1.

The control system 5000 may further include a state acquisition unit 530 (not illustrated) that acquires the state information D55 and/or the feedback information D56, and issues the supplementary information D58 as necessary. The state acquisition unit 530 is substantially the same as the state acquisition unit 130 in Embodiment 1.

In this embodiment, the input information D51 accepted by the control system 5000 can be considered to be information about a requirement in the work environment (transmitted content that requires a response in an environment where response work for an inquiry is performed). Therefore, the input information D51 that the control system 5000 accepts can be considered to be an example of the first information indicating a requirement in the work environment. The response information D52 can be considered to be information used in the work (response work) in response to such input information D51. In the following, the response information D52 output to a predetermined output destination from the operating environment of the learning model to which model input data based on the input information D51 is input may be referred to as the second information.

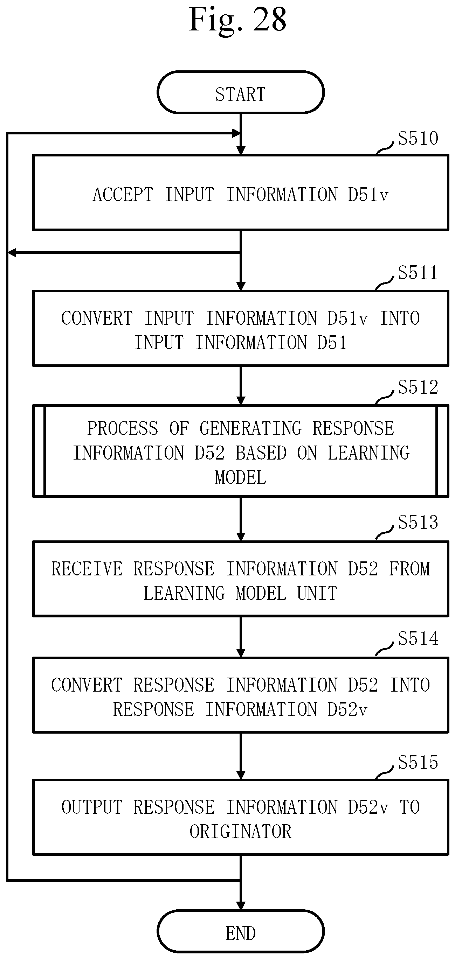

The operation of the control system 5000 of this embodiment will now be described. Fig. 28 is a flowchart illustrating an example of the operation of the control system 5000.

In the example illustrated in Fig. 28, the control system 5000 first accepts the input information D51v (step S510). For example, the input unit 102 or the input processing unit 201 described above may accept the input information D51v. The accepted input information D51v is input to the voice recognition unit 513v.

Upon accepting the input information D51v, the voice recognition unit 513v recognizes voice included in the input information D51v, and converts it into the input information D51 that conforms with the input data format of the learning model unit 500 (step S511). The converted input information D51 is input to the learning model unit 500 as the model input data D101.

If the input information D51 is long, the voice recognition unit 513v may divide the input information D51 into a plurality of pieces and input each piece of the divided input information D51 separately to the learning model unit 500. This is because if the input information D51 is long, the learning model unit 500 is more likely to be unable to recognize the correct meaning. This is particularly effective when inputs are made by voice, as it is easy for the user 1 to input long sentences.

If the voice recognition unit 513v is omitted, the accepted input information D51v may be input to the learning model unit 500 as the model input data D101.

Next, the control system 5000 performs a process of generating the response information D52 using the learning model unit 500 (step S512). In step S512, the learning model unit 500 (more specifically, the model control unit 101) outputs the response information D52 corresponding to the input information D51 based on the model information D102, the input information D51 that has been input, and, if necessary, the model reference information D104.

In step S512, the preprocessing unit 105 and/or the post-processing unit 106 of the learning model unit 500 may further perform the process described above.

The response information D52 output from the learning model unit 500 is input, for example, to the voice synthesis unit 514v (step S513). The response information D52 may be input to the voice synthesis unit 514v directly from the control system 5000 (more specifically, the learning model unit 500 or the information processing device 10 as its operating environment, etc.), or may be input indirectly via a communication network or other equipment (a server, various conversion devices, etc.) or manually.

Next, the voice synthesis unit 514v converts the input response information D52 into the response information D52v in voice format and outputs the response information D52v (step S514). The voice synthesis unit 514v may generate the response information D52v by, for example, synthesizing voice that expresses the response content indicated by the response information D52 in a data format other than voice. The response information D52v is output to the user 1 who is the originator of the input information D51v (step S515).

If the voice synthesis unit 514v is omitted, the response information D52 output from the learning model unit 500 may be output to the user 1 who is the originator of the input information D51v.

As described above, in this embodiment, in response to information transmitted from the user 1, the response information D52 can be dynamically generated using the learning model unit 500 and returned to the user who is the originator, without preparing an operator, a site with embedded response content, or the like. Therefore, the efficiency and performance of response work can be improved.

### Variation 5-1.

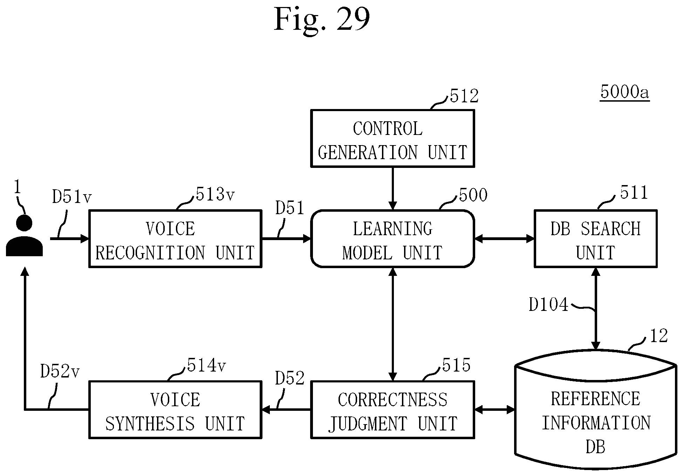

A variation of the control system 5000 will now be described. Fig. 29 is a configuration diagram illustrating an example of a control system 5000a, which is a variation of the control system 5000 according to this embodiment. The same elements as those of the control system 5000 are denoted by the same reference signs, and description will be omitted.

The control system 5000a illustrated in Fig. 29 differs from the control system 5000 in that a correctness judgment unit 515 is included.

The correctness judgment unit 515 determines whether the content indicated by the response information D52 output from the learning model unit 500 is correct. For example, the correctness judgment unit 515 may be configured to output the response information D52 to the user 1 or update the content of the reference information storage unit 12 only if it is determined that the content indicated by the response information D52 is correct.

For example, if it is determined that the content indicated by the response information D52 is not correct, the correctness judgment unit 515 may prompt the learning model unit 500 to acquire different response information D52 (re-acquire model output data). The correctness judgment unit 515 may be provided, for example, as an example of the post-processing unit 106 described above.

For example, the correctness judgment unit 515 determines whether the content indicated by the response information D52 is correct or not by the following method.

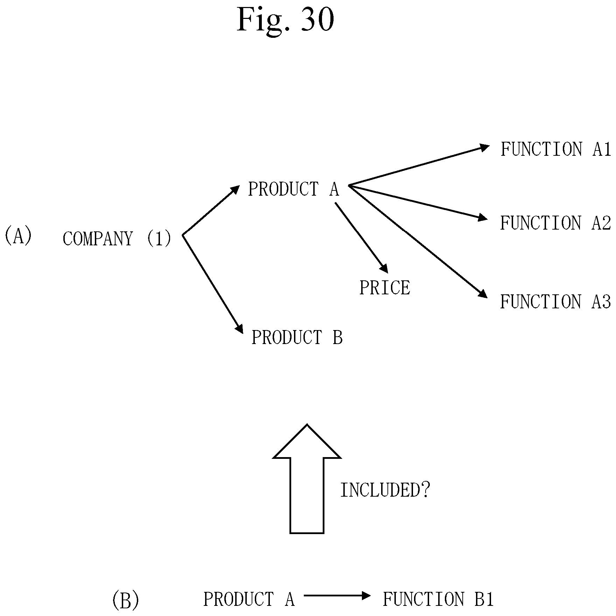

The correctness judgment unit 515 generates a knowledge graph based on information about the subject about which information is transmitted from the user 1 and turns the graph into a graph database in advance. As a specific example, when the subject is a product, the information about the subject is a product manual or the like. This work may be performed manually. For example, a graph database that indicates relationships between words in information about the subject is generated, as in (A) of Fig. 30.

The correctness judgment unit 515 generates a knowledge graph based on the response information D52 output by the learning model unit 500. As a result, a relationship between words included in the response information D52 is identified. For example, a relationship is identified, as in (B) of Fig. 30.

Then, the correctness judgment unit 515 uses a query language such as SPARQL to search the graph database generated in advance to determine whether the identified relationship between the words is included in the graph database. SPARQL is an abbreviation for SPARQL Protocol and RDF Query Language. If the identified relationship between the words is included in the graph database, the correctness judgment unit 515 determines that the content indicated by the response information D52 is correct. If the identified relationship between the words is not included in the graph database, the correctness judgment unit 515 determines that the content indicated by the response information D52 is not correct. In the example in Fig. 30, since the relationship in (B) of Fig. 30 is not included in the graph database in (A) of Fig. 30, the content indicated by the response information D52 is determined to be incorrect.

Other aspects may be substantially the same as those in other control systems according to this embodiment.

As described above, according to this variation, it is determined whether the content indicated by the response information output from the learning model unit 500 is correct, and based on this result, an output or no output is made to the user, response information is re-acquired, and reference information is updated. Therefore, the performance of response work can be further improved.

### Variation 5-2.

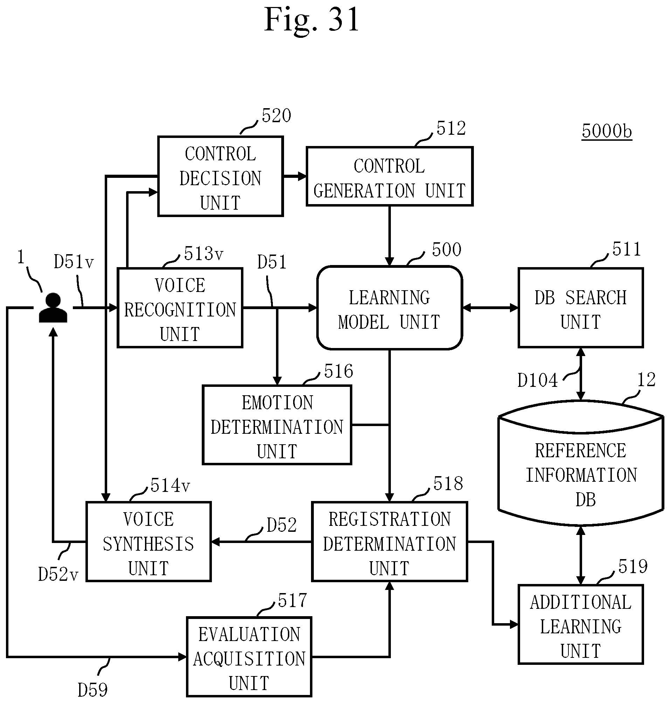

A second variation of the control system 5000 will now be described. Fig. 31 is a configuration diagram illustrating an example of a control system 5000b, which is a variation of the control system 5000 according to this embodiment. The same elements as those of the control system 5000 and the control system 5000a are denoted by the same reference signs, and description will be omitted.

As illustrated in Fig. 31, the control system 5000b may further include an emotion determination unit 516.

The emotion determination unit 516 uses the input information D51 and other information to determine the emotion of the user 1 who is the originator. The emotion determination unit 516 may determine the emotion of the user 1 after the response information D52 from the learning model unit 500 is output to the user 1.

The emotion of the user 1 determined by the emotion determination unit 516 may be input to the learning model unit 500 as the state information D55 included in the model reference information D104, or may be recorded as a history record in the reference information storage unit 12 together with the input/output data of the model.

As a method for recording in the reference information storage unit 12, the control system 5000b may, for example, further include a registration determination unit 518, and the registration determination unit 518 may determine whether or not a record is registered in the reference information storage unit 12 based on the result of determination of the emotion of the user 1 by the emotion determination unit 516. The result of determination here is the result of determination of the emotion of the user 1 after the response information D52 from the learning model unit 500 is output to the user 1. That is, the result of determination here is assumed to be the result of determination of an emotion determined based on the input information D51 or the like accepted after the response information D52 is output.

For example, if the determined emotion of the user 1 is positive, the registration determination unit 518 may record the input/output data of the model in the reference information storage unit 12 as history information of a positive case. At this time, if there is a result of determination of the emotion of the user 1 before the output of the response information D52 from the learning model unit 500, the registration determination unit 518 may record the input/output data of the model including emotion information before and after the response in the reference information storage unit 12 as history information.

For example, if the determined emotion of the user 1 is negative, the registration determination unit 518 may record the input/output data of the model in the reference information storage unit 12 as history information of a negative case. The input/output data of the model may be recorded in the reference information storage unit 12 as history information. At this time, if there is a result of determination of the emotion of the user 1 before the output of the response information D52 from the learning model unit 500, the registration determination unit 518 may record the input/output data of the model including emotion information before and after the response in the reference information storage unit 12 as history information.

The control system 5000b may further include an additional learning unit 519. When the content of the reference information storage unit 12 is updated, the model reference information D104 stored in the reference information storage unit 12 and other information that is referred to by the model control unit 101 may be re-constructed (additionally learned) based on updated information. That is, the additional learning unit 519 may cause the learning model unit 500 to perform additional learning based on input information, response information, and an evaluation on the response information by the user 1 who is the originator.

The control system 5000b may include an evaluation acquisition unit 517 in place of the emotion determination unit 516 or in addition to the emotion determination unit 516.

The evaluation acquisition unit 517 makes an inquiry to the user 1 about an evaluation of the response information D52, and acquires evaluation information D59 as a response. For example, the evaluation information D59 can be used, like the emotion of the user 1 described above, for updating the information that is referred to by the model, additional learning, and so on.

The control system 5000b may further include a control decision unit 520.

The control decision unit 520 specifies control target information and/or output mode settings to the control generation unit 512 based on the voice recognition result, emotion determination result, and/or evaluation result for the response information D52 for the input information from the user 1, instructions from an operator (not illustrated), and so on. The voice recognition result for the input information from the user 1 may include information such as attributes, an emotion, a region, a language, presence or absence of past usage, and usage frequency of the user 1. The control decision unit 520 may make a synthesized voice setting for the voice synthesis unit 514v based on the voice recognition result, emotion determination result, and/or evaluation result for the response information D52 for the input information from the user 1, an instruction from the operator (not illustrated), and so on.

For example, the control decision unit 520 can specify, as output mode settings, the difficulty level of explanation, manner of speaking (way of speaking and tone), language, level of grammar, politeness, position of the speaker, ending of speech, and so on in a response. The gender, way of speaking, tone, and so on of the synthesized voice can be specified. For example, the control decision unit 520 can specify, as settings for the synthesized voice, the gender, manner of speaking, language, level of grammar, politeness, and so on of the synthetic voice. The control decision unit 520 may make these settings based on, for example, predetermined setting rules.

The control generation unit 512 sets the preconditions specified by the control decision unit 520 for the learning model unit 500. As a result, the learning model unit 500 generates the response information D52 in response to the input information D51 input by the voice recognition unit 513v, in accordance with the preconditions specified by the control decision unit 512.

When the estimated emotion of the user 1 is anger, the control decision unit 520 may decide to set the output mode to apologizing. When the estimated attribute of the user 1 is a child, the control decision unit 520 may decide to set the output mode to simple content. The control decision unit 520 may change the gender of the text of the response information D52 and the voice of the response information D52v based on the estimated gender of the user 1. The control decision unit 520 may change the mode of the response information D52 based on the estimated nationality or used language of the user 1.

The elements of the control system 5000b illustrated in Fig. 31 can be selected as appropriate depending on the desired functions.

Other aspects may be substantially the same as those of other control systems according to this embodiment.

As described above, according to this variation, the control decision unit 520 specifies the target control information and/or the output mode settings based on information that can be obtained from the control system 5000b and so on, so that the response information D52 that is likely to match the requirements of the originator can be generated. Therefore, the performance of work of responding to the user can be further improved.

### Variation 5-3.

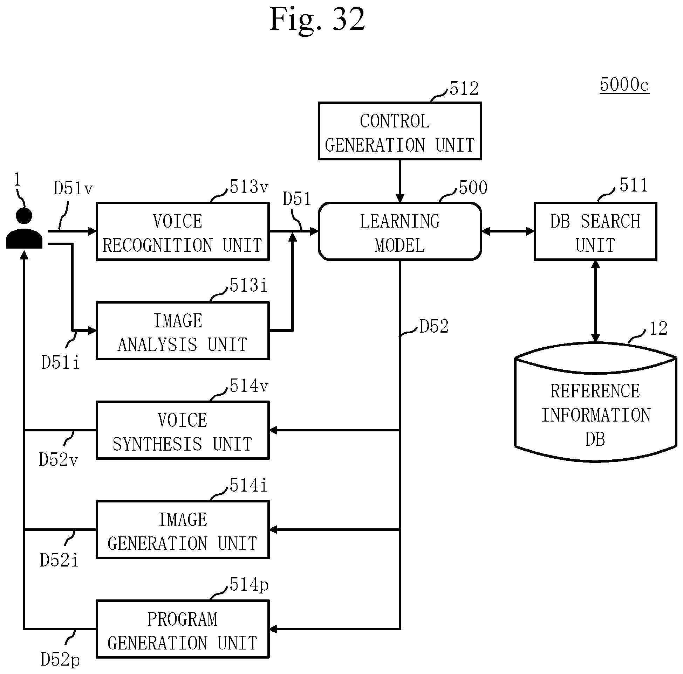

A third variation of the control system 5000 will now be described. Fig. 32 is a configuration diagram illustrating an example of a control system 5000c, which is a variation of the control system 5000 according to this embodiment. The same elements as those of the control system 5000, the control system 5000a, and the control system 5000b are denoted by the same reference signs, and description will be omitted.

As illustrated in Fig. 32, the control system 5000c may further include an image analysis unit 513i, an image generation unit 514i, and a program generation unit 514p.

When an input from the user 1 includes input information D51i in image format (input image), the image analysis unit 513i analyzes the image indicated by the input information D51i, converts it into a data format that matches the data format of the learning model unit 500, and outputs it. The image analysis unit 513i may convert, for example, the input information D51i in image format into the input information D51 in text format.

For example, when an input from the user 1 includes an input image obtained by capturing an operation screen of a product owned by the user 1, the image analysis unit 513i may analyze the image to identify which operation screen of which product it is and what operation state it is in, convert this into explanatory text, and output it. For example, when an input from the user 1 includes an input image obtained by capturing a certain purchase site that the user 1 is viewing, the image analysis unit 513i may analyze the image to identify which operation screen of which site it is and what operation state it is in, convert this into explanatory text, and output it.

The image generation unit 514i generates and outputs a response image based on the response information D52. For example, when the response information D52 output from the learning model unit 500 includes a data format other than the image format, the image generation unit 514i may generate and output a response image indicating the content of this part indicated by the response information D52. For example, when the response information D52 has a data structure that includes a data format specification, the image generation unit 514i may convert data elements for which the image format is specified in the specification into the image format and output the converted data elements. For example, the image generation unit 514i may generate the response information D52v in image format based on the response information D52 in text format. For example, the image generation unit 514i may perform a synthesis process of adding the content indicated by the response information D52 in text format as an annotation to the input image included in the input information D51. Based on the response information D52 in text format, the image generation unit 514i may perform a process of highlighting a part of the input image included in the input information D51. The image generation unit 514i may generate a response image from input information (the response information D52 and, if necessary, the input information D51) using a learning model.

The program generation unit 514p converts the content indicated by the response information D52 into a predetermined program data format and outputs the converted content. For example, when the response information D52 output from the learning model unit 500 includes a data format other than the predetermined program data format, the program generation unit 514p converts the content of this part indicated by the response information D52 into the predetermined program data format and outputs the converted content. For example, when the response information D52 has a data structure that includes a data format specification, the program generation unit 514p may convert data elements for which the predetermined program data format is specified in the specification into the predetermined program data format and output the converted data elements. The program generation unit 514p may, for example, convert the response information D52 in text format into the response information D52p in the predetermined program data format. The program generation unit 514p may generate a predetermined program from input information using a learning model.

The image analysis process by the image analysis unit 513i is performed, for example, in step S511 described above. The image generation process by the image generation unit 514i and the program generation process by the program generation unit 514p are performed, for example, in step S514 described above.

There may be a case where the voice synthesis unit 514 responds by voice and the image generation unit 514i also responds with an image. In this case, the voice recognition unit 513v may separate the input information D51 converted into text format into the input information D51 for which a response is made by voice and the input information D51 for which a response is made with an image, and input them to the learning model unit 500. Similarly, the image analysis unit 513i may separate the input information D51 converted into text format into the input information D51 for which a response is made by voice and the input information D51 for which a response is made with an image, and input them to the learning model unit 500.

Other aspects may be substantially the same as those of other control systems according to this embodiment.

As described above, according to this variation, inquiries and responses can be made not only by voice but also by voice and images, so that responses can be made more effectively to inquiries about operation screens and so on, for example. Furthermore, according to this variation, in addition to voice and images, programs can also be provided as response information to the originator, so that responses can be made more effectively to inquiries about troubleshooting and so on.

### Variation 5-4.

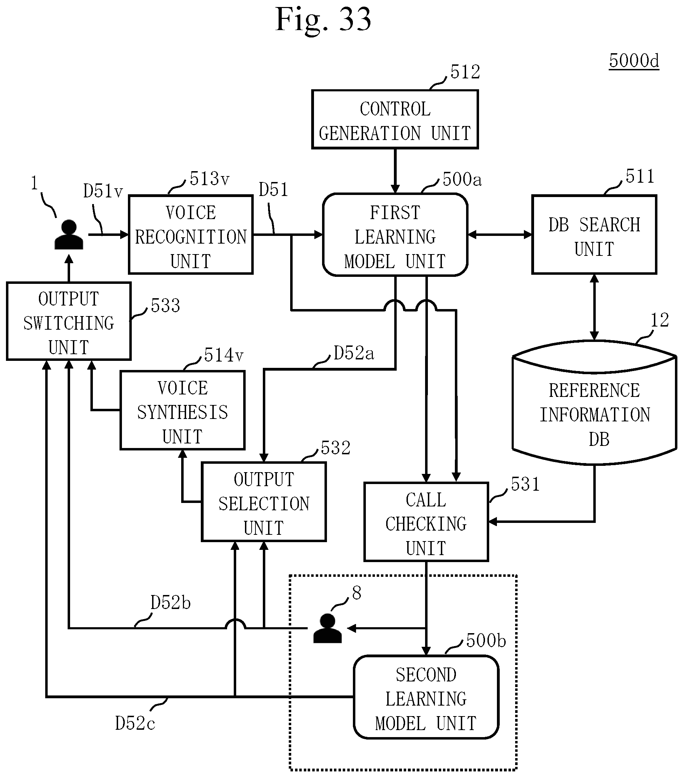

A fourth variation of the control system 5000 will now be described. Fig. 33 is a configuration diagram illustrating an example of a control system 5000d, which is a variation of the control system 5000 according to this embodiment. The same elements as those of the control system 5000 to the control system 5000c are denoted by the same reference signs, and description will be omitted.

This variation has a function of switching between a response by an operator 8 and a response by a different learning model based on the content of an inquiry from the user 1 and/or the output result from a learning model.

As illustrated in Fig. 33, the control system 5000d may further include a call checking unit 531 and an output selection unit 532.

It is assumed here that the control system 5000d includes the learning model unit 500a as a first response function, and also includes the operator 8 and a communication channel with the operator 8 as a second response function. The control system 5000d may further include, as a third response function, another learning model unit 500b that uses a different algorithm or data from those of the learning model unit 500a. The learning model unit 500b that uses a different algorithm or data from those of the learning model unit 500a may be provided as the second response function. In this case, the operator 8 and a communication channel with the operator 8 may be further provided as the third response function. The types and number of response functions are not particularly limited. For example, a response function to be switched to may be a response system that does not use a learning model.

In this example, a case will be described where the learning model unit 500a, which is the first response function, is the learning model unit 500 described above, the second response function is the operator 8 and the communication channel with the operator 8, and the third response function is the learning model unit 500b that uses a different algorithm or data from those of the learning model unit 500a.

The learning model unit 500a may be a local learning model that obtains output results based on local information, such as information from limited databases that can be referred to, and the learning model unit 500b may be a global learning model that obtains output results based on global information, such as information from freely accessible external networks.

The call checking unit 531 switches the processing destination for performing a response process based on the content of an inquiry from the user 1 and/or the output result from the learning model.

For example, if it is determined that the output from the first response function is not expected to be accurate based on the content of an inquiry from the user 1 and/or the response information D52 that is the output result from the learning model, the call checking unit 531 may call the operator 8 as the second response function. For example, the call checking unit 531 may use the communication channel with the operator 8 to call the operator 8, and input the input information D51 to operation equipment of the operator 8. The call checking unit 531 may use the communication channel with the operator 8 to call the operator 8, and input the input information D51 to an operation terminal (not illustrated) of the operator 8.

If it is determined that a call to the second response function is not possible or the output is not expected to be accurate, the call checking unit 531 may call the learning model unit 500b as the third response function. For example, the call checking unit 531 may call the learning model unit 500b by inputting the input information D51 to the learning model unit 500b using an interface with the learning model unit 500b.

The accuracy of an output may be determined using, for example, an evaluation value or likelihood output by the response function itself, or may be determined using the reliability evaluation described above. When the response function itself is configured to output a message indicating a failure to understand or a request for calling another function, it is also possible to make a judgment based on the presence or absence of such a message.

The output selection unit 532 selects the response information D52 to be output to the user 1 based on the result of switching the response process by the call checking unit 531. If the first response function is set to perform the response process as a result of switching the response process by the call checking unit 531, the output selection unit 532 outputs response information D52a output from the first response function to the user 1. If the second response function is set to perform the response process as a result of switching the response process by the call checking unit 531, the output selection unit 532 outputs response information D52b output from the second response function to the user 1. If the third response function is set to perform the response process as a result of switching the response process by the call checking unit 531, the output selection unit 532 outputs response information D52c output from the third response function to the user 1.

The output selection unit 532 may output the output from the selected response function to the user 1 by controlling an output switching switch (not illustrated) that switches the connection path (circuit or communication path) connecting the response function that is set for execution and the user 1 who is the output destination.

The connection path between the response function and the user 1 may include various conversion devices, such as the voice synthesis unit, the image generation unit, the program generation unit described above, and a predetermined interface, as necessary.

For example, when text input by the operator 8 using the operation terminal is output as the response information D52b, the connection path between the response function and the user 1 may include the voice synthesis unit that converts text into voice. The output selection unit 532 can also accept a corrected version of the response information D52a output by the first response function as the output of the second response function or the like. In this case, the operation terminal of the operator 8 includes a text display unit and a text input unit, and the control system 5000d may accept the response information D52b obtained by partially correcting the response information D52a output from the operation terminal of the operator 8.

Other aspects may be substantially the same as those of other control systems according to this embodiment.

As described above, according to this variation, in addition to generating responses using the learning model unit 500 described above, responses can also be generated, for example, by an operator or using other learning models (including, for example, a tandem structure model in which multiple models are connected, a multimodal model, and a model trained specifically for predetermined equipment or service). Therefore, the performance of work of responding to the user can be further improved.

### Variation 5-5.

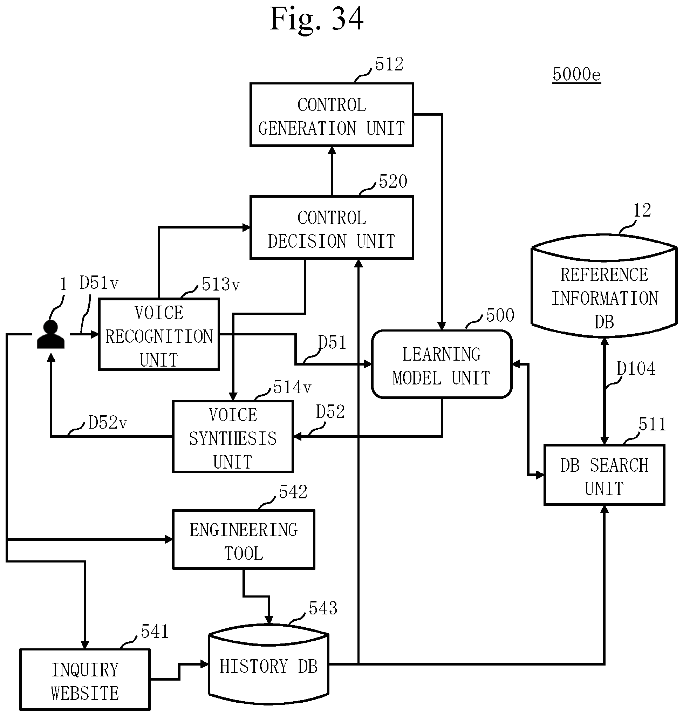

A fifth variation of the control system 5000 will now be described. Fig. 34 is a configuration diagram illustrating an example of a control system 5000e, which is a variation of the control system 5000 according to this embodiment. The same elements as those of the control system 5000 to the control system 5000d are denoted by the same reference signs, and description will be omitted.

The control system 5000e illustrated in Fig. 34 differs from the control system 5000 in that the control decision unit 520 is included, as in the control system 5000b. The control system 5000e illustrated in Fig. 34 differs from the control system 5000 in that an inquiry website 541, an engineering tool 542, and a history database 543 (indicated as a history DB in the diagram) are included.

The control decision unit 520 specifies preconditions for the control generation unit 512 based on past input information D51 from the user 1 who is the originator. That is, the control decision unit 520 specifies control target information and/or output mode settings for the control generation unit 512 based on the past input information D51 from the user 1.

The past input information D51 from the user 1 is not limited to information indicating the content of inquiries input to the learning model unit 500 via the voice recognition unit 513v, but may also include information indicating the content of inquiries and so on input via the inquiry website 541 and information such as a program input using the engineering tool 542. The past input information D51 from the user 1 is stored in the history database 543.

The control decision unit 520 refers to the history database 543 to acquire the past input information D51 of the user 1 who is the originator. In the history database 543, the input information D51 is stored in association with identification information of the user 1. The control decision unit 520 can identify the past input information D51 from the user 1 who is the originator by narrowing down the input information D51 stored in the history database 543 based on the identification information of the user 1 who is the originator. The identification information of the user 1 who is the originator is identified, for example, by having the user 1 to perform a login process when starting to use the control system 5000e.

The inquiry website 541, like the voice recognition unit 513v, accepts inquiries and so on about an inquiry target in the control system 5000e. The inquiry website 541 accepts inquiries and so on in a data format such as text or images, rather than voice. The text, images, or the like accepted by the inquiry website 541 are stored in the history database 543 as the input information D51.

The engineering tool 542 is a tool for creating a program. There are cases where the inquiry target in the control system 5000e is a system such as an FA system. The engineering tool 542 is a tool that is provided in such cases and used to create a program to be run in the system that is the target of inquiries. The program created using the engineering tool 542 is stored in the history database 543.

For example, based on the past input information D51 from the user 1 who is the originator, the control decision unit 520 determines whether the user 1 is already using the inquiry target or whether the user 1 is at the stage of considering use of the inquiry target. The control decision unit 520 specifies preconditions depending on the result of determination. For example, if the user 1 is already using the inquiry target, the control decision unit 520 specifies preconditions such that specific information is returned. On the other hand, if the user 1 is at the stage of considering use of the inquiry target, the control decision unit 520 specifies preconditions such that the advantages of the inquiry target are put forward.

If the input information D51 that has been newly input is an inquiry about a program, the control decision unit 520 may specify preconditions such that a response is made by using, as an example, a program previously created by the user 1 and providing additions and corrections.

The control generation unit 512 sets the preconditions specified by the control decision unit 520 to the learning model unit 500. As a result, the learning model unit 500 generates the response information D52 in response to the input information D51 input by the voice recognition unit 513v, in accordance with the preconditions specified by the control decision unit 512.

Other aspects may be substantially the same as those of other control systems according to this embodiment.

As described above, according to this variation, the control decision unit 520 specifies control target information and/or output mode settings based on the past input information D51 from the user 1 who is the originator. As a result, it is possible to generate the response information D52 that is more likely to match the requirements of the originator. Therefore, the performance of work of responding to the user can be further improved.

### Variation 5-6.

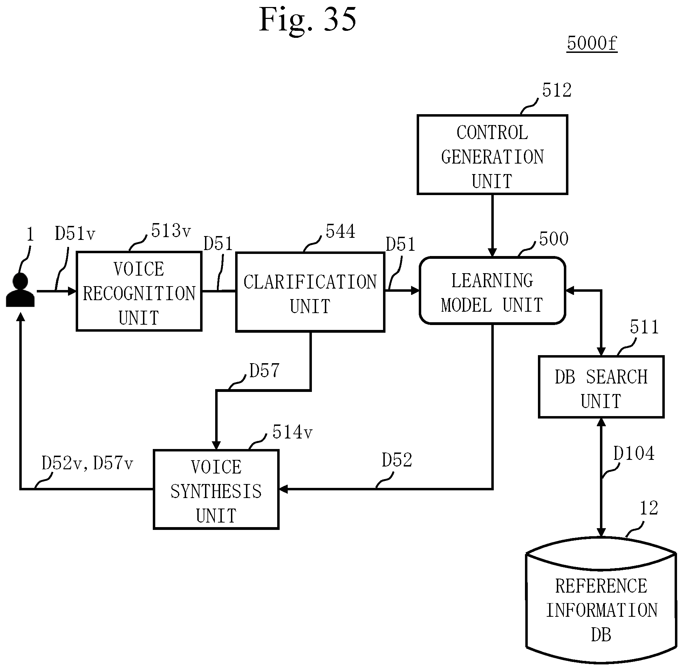

A sixth variation of the control system 5000 will now be described. Fig. 35 is a configuration diagram illustrating an example of a control system 5000f, which is a variation of the control system 5000 according to this embodiment. The same elements as those of the control system 5000 to the control system 5000e are denoted by the same reference signs, and description will be omitted.

The control system 5000f illustrated in Fig. 35 differs from the control system 5000 in that a clarification unit 544 is included.

The clarification unit 544 clarifies the words indicated by demonstrative terms included in the input information D51 converted into text format by the voice recognition unit 513v, and then inputs the input information D51 to the learning model unit 500.

At this time, when it is unclear which of a plurality of words is the word indicated by a demonstrative term included in the input information D51, the clarification unit 544 returns the inquiry D57 to the user 1 to confirm with the user 1 the word indicated by the demonstrative term. The clarification unit 544 clarifies the input information D51 so that the word indicated by the demonstrative term indicates the word specified by the user 1, and then inputs the input information D51 to the learning model unit 500.

The input information D51 may include demonstrative terms such as "this" and "that". If such a demonstrative term is directly input to the learning model unit 500, there is a possibility that appropriate response information D52 cannot be obtained. Therefore, the clarification unit 544 clarifies which word in the input information D51 is indicated by the demonstratives term, and then inputs the input information D51 to the learning model unit 500. Existing analysis techniques can be used to identify the word indicated by the demonstrative term.

At this time, there is a possibility that the clarification unit 544 cannot identify which word is indicated by the demonstrative term solely through analyzing the input information D51. For example, it is assumed that an existing analysis technique can be used to obtain a word indicated by a demonstrative term together with a probability of the word being indicated. In this case, if the probability is lower than a first threshold, the clarification unit 544 determines that which word the demonstrative term indicates cannot be identified solely through analysis and is unclear.

If which word the demonstrative term indicates cannot be identified solely through analysis, the clarification unit 544 returns the inquiry D57 to the user 1 to confirm with the user 1 the word indicated by the demonstrative term. For example, the clarification unit 544 creates text as the inquiry D57 that indicates the input information D51 and the unclear demonstrative term so as to confirm which word the unclear demonstrative term indicates, and outputs the text via the voice synthesis unit 514v as an inquiry D57v. Based on the input information D51 that is then input, the clarification unit 544 identifies the word indicated by the unclear demonstrative term. Then, the input information D51 including the unclear demonstrative term is clarified using the identified word and then input to the learning model unit 500.

If which word the demonstrative term indicates cannot be identified solely through analysis, the clarification unit 544 may set each of a plurality of words as a target word, generate a plurality of pieces of input information D51 in each of which the input information D51 is clarified so that the demonstrative term indicates the target word, and input each piece of the input information D51 to the learning model unit. If an existing analysis technique can be used to obtain words the demonstrative term indicates together with the probability of each of the words being the word that is indicated, the clarification unit 544 may set each of words whose probability is higher than a second threshold as the target word.

In this case, the learning model unit 500 generates the response information D52 corresponding to each piece of the input information D51. Thus, the voice recognition unit 513v outputs the word indicated by the demonstrative term and the response information D52 in which the demonstrative term indicates the word.

The cases have been described where the demonstrative terms in the input information D51 accepted by the voice recognition unit 513v are clarified. As described in Variation 5-3, there are cases where the input information D51 is generated from images obtained by the image analysis unit 513i. Also in these cases, the clarification unit 544 may similarly clarify the words indicated by demonstrative terms, including the input information D51 generated from the images.

Other aspects may be substantially the same as those of other control systems according to this embodiment.

As described above, according to this variation, the clarification unit 544 clarifies the demonstrative terms included in the input information D51 and then inputs the input information D51 to the learning model unit 500. As a result, the response information D52 that aligns with the intention of the originator can be generated. Therefore, the performance of work of responding to the user can be further improved.

### Variation 5-7.

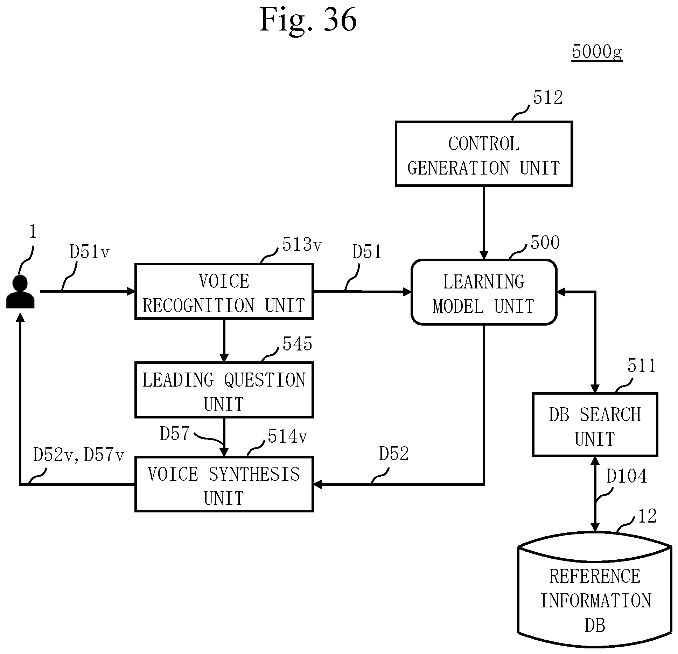

A seventh variation of the control system 5000 will now be described. Fig. 36 is a configuration diagram illustrating an example of a control system 5000g, which is a variation of the control system 5000 according to this embodiment. The same elements as those of the control system 5000 to the control system 5000f are denoted by the same reference signs, and description will be omitted.

The control system 5000g illustrated in Fig. 36 differs from the control system 5000 in that a leading question unit 545 is included.

The leading question unit 545 outputs, as the inquiry D57, a leading question to narrow the range in the reference information database 12 to be searched by the learning model unit 500. Specifically, the leading question unit 545 creates text of the leading question as the inquiry D57, and causes it to be output as an inquiry D57v via the voice synthesis unit 514v. When the input information D51 is input, the learning model unit generates the response information D52 based on information obtained by searching the reference information database 12.

For example, it is assumed that a plurality of models are included in the inquiry targets. In this case, the leading question unit 545 outputs a leading question to identify the target model from among the plurality of models. As a specific example, the leading question unit 545 outputs a leading question to confirm a model name. If there are a plurality of manuals for the identified model, the leading question unit 545 outputs a leading question to identify one of the plurality of manuals that is related to the inquiry. Furthermore, the leading question unit 545 may output a leading question to identify an item related to the inquiry in the table of contents of the identified manual. If the inquiry is about a web page instead of a manual, the leading question unit 545 may also output a leading question to identify which web page of a plurality of web pages is related to the inquiry.

When the search range is narrowed down from a reference range of the reference information database12, the leading question unit 545 inputs range information indicating the narrowed range to the learning model unit 500. Then, the learning model unit 500 generates the response information D52 based on information obtained by searching the reference information database12 using the range indicated by the range information as the search range.

The leading question unit 545 may input a reply to the leading question to the learning model unit 500 as the range information. In this case, the learning model unit 500 identifies the search range based on the range information, and then generates the response information D52 based on information obtained from searching the identified search range in the reference information database 12.

The wider the search range in the reference information database12, the more likely it is that data less relevant to the intended content will be extracted. The response information D52 is generated based on the extracted data. Therefore, if data that is less relevant to the intended content is extracted, the likelihood of not generating appropriate response information D52 increases. The more the search range in the reference information database12 is narrowed by asking leading questions, the more likely it is that appropriate response information D52 will be generated.

Other aspects may be substantially the same as those of other control systems according to this embodiment.

As described above, according to this variation, the leading question unit 545 outputs a leading question to narrow the search range in the reference information database 12. This makes it possible to generate the response information D52 that aligns with the intention of the originator. Therefore, the performance of work of responding to the user can be further improved.

The above embodiments have been described using examples of system configurations corresponding to work of interest. However, the control systems according to the present disclosure are not limited to the examples described above. For example, a control system according to the present disclosure can be implemented by appropriately combining one or more of the embodiments described above.

As an example, a control system according to the present disclosure can be implemented by combining the configuration of Embodiment 1 and the configuration of Embodiment 4 so that the functions of Embodiment 4 can be used to input information indicating a solution obtained from sensor data to the control system of Embodiment 1, so as to convert the solution into a program to directly control the target equipment 2.

The embodiments and variation are not limited to the examples described above, and can be modified as appropriate within the scope of the disclosure.

The control systems and control methods according to the present disclosure include a control system and a control method described in the following supplements.

### (Supplement 1)

A control system to assist work performed by a person or an object using equipment, the control system including:
an input interface to accept an input of first information indicating a situation or a requirement in a work environment, which is an environment where the work is performed;
a model processing unit provided so as to be able to access a learning model that is predetermined; and
an output interface to output second information for assisting the work based on an output from the learning model,
wherein the model processing unit inputs model input data based on the first information to the learning model, and accepts model output data that corresponds to the model input data from the learning model,
wherein the model output data includes information to be used for the work, and
wherein the output interface outputs the second information based on the model output data.

### (Supplement 2)

The control system according to supplement 1,
wherein the first information includes information indicating control content or operation content required for the equipment,
wherein the model input data is data in which the control content or operation content indicated by the first information is expressed in a format that matches an input format of the learning model,
wherein the model output data includes information that is used for controlling or operating the equipment and corresponds to the control content or the operation content indicated by the model input data, and
wherein the second information includes information in which the information to be used for controlling or operating the equipment included in the model output data is written in a predetermined format that can be recognized at an output destination of the output interface.

### (Supplement 3)

The control system according to supplement 2,
wherein the output destination of the output interface is the equipment or an interface that requests control of the equipment, and
wherein as a result of the second information being output to the equipment or the interface that requests control of the equipment, the equipment is controlled.

### (Supplement 4)

The control system according to supplement 2, further including
an executable code generation unit to generate and output executable code that is executable by the equipment,
wherein the output destination of the output interface is the executable code generation unit, and
wherein the equipment is controlled by executable code generated as a result of the second information being output to the executable code generation unit.

### (Supplement 5)

The control system according to supplement 2,
wherein the output destination of the output interface is a terminal that is operated by a user, and
wherein as a result of the second information being output to the terminal, the equipment is controlled.

### (Supplement 6)

The control system according to supplement 1,
wherein the first information includes information indicating a situation in the work environment,
wherein the model input data is data in which the situation in the work environment indicated by the first information is indicated in a format that matches an input format of the learning model,
wherein the model output data includes information about an analysis result of the situation in the work environment indicated by the model input data and/or an improvement method for the situation, and
wherein the second information includes information in which the information about the analysis result of the situation in the work environment and/or the improvement method for the situation is written in a predetermined format that can be recognized at an output destination of the output interface.

### (Supplement 7)

The control system according to supplement 1,
wherein the model processing unit is provided so as to be able to access a first learning model and a second learning model,
wherein the model processing unit inputs first model input data based on the first information to the first learning model, and accepts first model output data that corresponds to the first model input data from the first learning model,
wherein the model processing unit inputs second model input data based on the first model output data to the second learning model, and accepts second model output data that corresponds to the second model input data from the second learning model, and
wherein the output interface outputs the second information based on the second model output data.

### (Supplement 8)

The control system according to supplement 7,
wherein the first information includes information indicating control content or operation content required for the equipment,
wherein the first model input data is data in which the control content or the operation content indicated by the first information is indicated in a format that matches an input format of the first learning model,
wherein the first model output data includes information in which the control content or the operation content indicated by the first model input data is indicated in a more generalized or specific manner,
wherein the second model input data is data in which the control content or the operation content indicated by the first model output data is indicated in a format that matches an input format of the second learning model,
wherein the second model output data includes information that is used for controlling or operating the equipment and corresponds to the control content or the operation content indicated by the second model input data, and
wherein the second information includes information in which the information to be used for controlling or operating the equipment included in the second model output data is written in a predetermined format that can be recognized at an output destination of the output interface.

### (Supplement 9)

The control system according to supplement 7,
wherein first information includes information indicating a situation in the work environment,
wherein the first model input data is data in which the situation in the work environment indicated by the first information is indicated in a format that matches an input format of the first learning model,
wherein the first model output data includes an analysis result of the situation in the work environment indicated by the first model input data,
wherein the second model input data is data in which the analysis result of the situation in the work environment indicated by the first model output data is indicated in a format that matches an input format of the second learning model,
wherein the second model output data includes information about an improvement method for the situation in the work environment that corresponds to the analysis result of the work environment indicated by the second model input data, and
wherein the second information includes information in which at least information about the improvement method for the situation in the work environment included in the second model output data is written in a predetermined format that can be recognized at an output destination of the output interface.

### (Supplement 10)

The control system according to supplement 1,
wherein the work is a response by a person or an object using equipment,
wherein the first information includes information indicating response requirement content, which is content for which a response is required in the work environment,
wherein the model input data is data in which the response requirement content indicated by the first information is indicated in a format that matches an input format of the learning model,
wherein the model output data includes information that is used for the response and corresponds to the response requirement content indicated by the model input data, and
wherein the second information includes information in which the information used for the response included in the model output data is written in a predetermined format that can be recognized at an output destination of the output interface.

### (Supplement 11)

The control system according to supplement 3,
wherein the output destination of the output interface is a screen operation interface that requests control of the equipment via an operation screen, and
wherein the model output data includes information on an operation screen that is used to actually perform an operation corresponding to the control content or the operation content indicated by the model input data on the equipment, the information on the operation screen being written in a predetermined format that can be recognized at the output destination of the output interface.

### (Supplement 12)

The control system according to any one of supplement 1 to supplement 11,
wherein the input interface accepts inputs of the first information each indicating a requirement in the work environment from a plurality of users, and
wherein the model processing unit inputs the model input data including the first information input from the plurality of users to the learning model, and accepts the model output data that corresponds to the model input data from the learning model.

### (Supplement 13)

The control system according to any one of supplement 1 to supplement 12,
wherein the learning model is a language learning model to which natural language is input to obtain an output result, an image learning model to which an image is input to obtain an output result, and a multimodal model to which natural language and an image are input to obtain an output result.

### (Supplement 14)

The control system according to any one of supplement 1 to supplement 13,
wherein the model processing unit is provided so as to be able to access a first learning model and a second learning model,
wherein one of the first learning model and the second learning model is a local learning model whose reference database is limited to internal information, and
wherein the other one of the first learning model and the second learning model is a global learning model whose reference database is not limited to internal information.

### (Supplement 15)

The control system according to any one of supplement 1 to supplement 13,
wherein the model processing unit is provided so as to be able to access a first learning model and a second learning model,
wherein one of the first learning model and the second learning model is a learning model that can refer to information specifically defined in the work environment, and
wherein the other one of the first learning model and the second learning model is a learning model that cannot refer to information specifically defined in the work environment.

### (Supplement 16)

The control system according to any one of supplement 1 to supplement 15, further including
an output checking unit to perform a simulation that simulates control and a state of the equipment based on model output data output from the learning model.

### (Supplement 17)

The control system according to any one of supplement 1 to supplement 16,
wherein based on information collected from an output destination of the output interface, additional learning of the learning model, judgment of correctness of output information, or flow control of output information is performed.

### (Supplement 18)

The control system according to any one of supplement 1 to supplement 17, further including
an input processing unit to make an inquiry to an input source when the first information includes unclear or uncertain information.

### (Supplement 19)

The control system according to any one of supplement 1 to supplement 18,
wherein the inquiry includes information indicating a correction, an addition, or a deletion of content in input/output data of the learning model.

### (Supplement 20)

The control system according to any one of supplement 1 to supplement 19,
wherein the first information is time-series data that indicates a situation or a requirement in a work environment, which is an environment where the work is performed, together with time information.

### (Supplement 21)

The control system according to any one of supplement 1 to supplement 19, including:
as an execution environment of the learning model, a model information storage unit to store model information; and a model control unit to accept the model input data and output the model output data based on the model input data and information stored in the model information storage unit.

### (Supplement 22)

A control method for assisting work performed by a person or an object using equipment, the control method including:
accepting an input of first information indicating a situation or a requirement in a work environment, which is an environment where the work is performed, by an input interface;
inputting model input data based on the first information to a learning model, and accepting model output data that includes information to be used for the work and corresponds to the model input data from the learning model, by a model processing unit that is provided so as to be able to access the learning model; and
outputting second information that is used to assist the work and is based on the model output data, based on an output from the learning model, by an output interface.

### Industrial Applicability

The control system according to the present disclosure can be suitably applied as part of a work assistance system that assists work performed by a person or an object. Furthermore, the control system according to the present disclosure can be suitably applied as a control system that controls equipment when some control or work is performed using the equipment. The control system can be suitably applied as a control system that controls FA equipment, a control system within a home or a building, or a control system that controls an information processing device such as a server device that processes information on a network.

### Reference Signs List

1000, 1000a, 1000b, 1000c, 2000, 3000, 3000a, 3000b, 3000c, 3000d, 3000e, 4000, 4000a, 5000, 5000a, 5000b, 5000d: control system;
100, 200, 300, 300a, 300b, 400, 400a, 400b, 500, 500a, 500b: learning model unit;
10, 20: information processing device;
11: model information storage unit;
12: reference information storage unit;
101: model control unit;
102: input unit;
103: output unit;
105: preprocessing unit;
106: post-processing unit;
107: model generation unit;
104, 104a: control unit;
201: input processing unit;
202: output checking unit;
203: correction checking unit;
1: user;
1a: input source;
2: target equipment;
2a: output destination;
3: operation screen user interface;
4: controller;
41-1, 41-2: analysis unit;
42: switching unit;
43: output switching switch;
5: sensor;
6: model interface;
7: display;
8: operator;
110, 210, 310, 410: equipment information storage unit;
120: executable code generation unit;
230: state acquisition unit;
311: input interface;
312: output interface;
313: environmental information storage unit;
511: database search unit;
512: control generation unit;
513v: voice recognition unit;
513i: image analysis unit;
514v: image synthesis unit;
514p: program generation unit;
515: correctness judgment unit;
516: emotion determination unit;
517: evaluation acquisition unit;
518: registration determination unit;
519: additional learning unit;
531: call checking unit;
532: output selection unit;
533: output switching unit;
541: inquiry website;
542: engineering tool;
543: history database;
544: clarification unit;
545: leading question unit;
D101: model input data;
D102: model information;
D103: model output data;
D104: model reference information;
D11, D21, D31, D41, D51, D51v, D51i: input information;
D12: control description;
D22, D34: control instruction;
D42a, D42b: analysis result;
D52, D52v, D52i, D52p, D52a, D52b, D52c: response information;
D32, D32a, D32b: operation instruction;
D320: operation information;
D13, D23, D33, D43: equipment information;
D33a: environmental information;
D14: executable code;
D44a, D44b: result information;
D15, D25, D35, D45: state information;
D16, D26, D36, D46: feedback information;
D17, D27, D37, D47, D57, D57v: inquiry;
D18, D28, D38, D48: supplementary information;
D59: evaluation information.

## Claims

1. A control system comprising:
an input interface to accept input information input from an originator, and input the input information to a learning model unit;
a control decision unit to specify a precondition for the learning model unit for generating response information according to the input information previously input from the originator; and
an output interface to accept response information generated by the learning model unit in response to the input information input by the input interface in accordance with the precondition specified by the control decision unit, and output the response information to the originator.

2. The control system according to claim 1,
wherein the precondition indicates at least one of information to be focused on in generating the response information and information indicating a mode of the response information.

3. The control system according to claim 1 or 2,
wherein the control decision unit specifies the precondition according to an emotion inferred from the input information.

4. The control system according to any one of claims 1 to 3,
wherein the control decision unit specifies the precondition according to at least one of an attribute, a region, and a language inferred from the input information.

5. The control system according to any one of claims 1 to 4, further comprising
an image generation unit to generate and output a response image based on the response information.

6. The control system according to claim 5,
wherein the input information includes an image, and
wherein the image generation unit generates the response image by processing an input image included in the input information based on the response information.

7. The control system according to any one of claims 1 to 6, further comprising
a program generation unit to generate and output a program based on the response information.

8. The control system according to any one of claims 1 to 7,
wherein the input information is in text format, and
wherein the control system further comprises an image analysis unit to, when an input image is input from the originator, convert the input image into text format, and then include the input image in the input information.

9. The control system according to any one of claims 1 to 8, further comprising
a call checking unit to switch between outputting the response information and calling a second response function different from the learning model unit so as to cause the second response function to perform a response process, based on at least one of the input information and the response information.

10. The control system according to claim 9,
wherein when it is determined that accuracy of the response information is lower than a reference value, the call checking unit calls the second response function.

11. The control system according to any one of claims 1 to 10, further comprising
a correctness determination unit to determine whether or not content of the response information is correct, and cause the learning model unit to output a response again when it is determined that the content of the response information is incorrect.

12. The control system according to any one of claims 1 to 11, further comprising
an additional learning unit to cause the learning model unit to perform additional learning based on the input information, the response information, and an evaluation by the originator about the response information.

13. The control system according to claim 12,
wherein the evaluation by the originator is identified based on one of an emotion input by the originator after the response information is output and an emotion inferred from input information input by the originator after the response information is output.

14. The control system according to any one of claims 1 to 13, further comprising
a clarification unit to, when it is unclear which word of a plurality of words is a word indicated by a demonstrative term included in the input information, confirm with the originator the word indicated by the demonstrative term, clarify the input information so as to make the word indicated by the demonstrative term indicate the word specified by the originator, and then input the input information to the learning model unit.

15. The control system according to any one of claims 1 to 13, further comprising
a clarification unit to, when it is unclear which word of a plurality of words is a word indicated by a demonstrative term included in the input information, set each of the plurality of words as a target word, clarify the input information so as to make the demonstrative term indicate the target word, and then input the input information to the learning model unit.

16. The control system according to any one of claims 1 to 15,
wherein when the input information is input, the learning model unit generates the response information according to information obtained by searching a reference information database, and
wherein the control system further comprises a leading question unit to output a leading question to narrow a search range in the reference information database to the originator.

17. A control method comprising:
accepting input information input from an originator, and inputting the input information to a learning model unit, by a computer;
specifying a precondition for the learning model unit for generating response information according to the input information previously input from the originator, by the computer; and
accepting response information generated by the learning model unit in response to the input information that has been input in accordance with the specified precondition, and outputting the response information to the originator, by the computer.

18. A control program to cause a computer to function as a control system to perform:
an input interface process of accepting input information input from an originator, and inputting the input information to a learning model unit;
a control decision process of specifying a precondition for the learning model unit for generating response information according to the input information previously input from the originator; and
an output interface process of accepting response information generated by the learning model unit in response to the input information input by the input interface process in accordance with the precondition specified by the control decision process, and outputting the response information to the originator.
